# EUROPEAN PATENT APPLICATION

(11) **EP 4 711 980 A1**
(43) Date of publication of application: **18.03.2026**
(21) Application number: 24803422.5
(22) Date of filing: 30.04.2024
(51) Int. Cl.: G06K 19/077, B42D 25/305, G06K 19/07, H01Q 1/38, H01Q 1/50, H01Q 7/00

(54) **IC MODULE AND IC CARD**

(30) Priority: 11.05.2023 JP 2023078853; 11.05.2023 JP 2023078856; 02.06.2023 JP 2023091916
(71) Applicant: Toppan Holdings Inc., Tokyo 110-0016 (JP)
(72) Inventor: KATAOKA, Shin, Tokyo 110-0016 (JP)
(74) Representative: Hoffmann Eitle
(86) International application number: PCT/JP2024/016636
(87) International publication number: WO 2024/232309

(57) **Abstract**

An IC module according to the present invention includes a rectangular substrate having long sides extending in a first direction; a connection coil formed in a spiral shape on a first surface of the substrate; an outermost connection terminal portion formed at an outermost end of the connection coil; and an IC chip provided on a portion of the first surface on an inner peripheral side relative to the connection coil, wherein the outermost connection terminal portion includes an outermost through-hole portion penetrating the substrate in a thickness direction of the substrate, and an outermost land portion surrounding the outermost through-hole portion and connecting between the outermost through-hole portion and the connection coil; and as viewed in a second direction perpendicular to both the first direction and the thickness direction, the outermost connection terminal portion is disposed on a first side in the first direction relative to the IC chip.

## Description

### [Technical Field]

The present invention relates to IC modules and IC cards.

This application is based on and claims the benefit of priorities from earlier Japanese Patent Application Nos. 2023-078853 and 2023-078856 both filed in Japan on May 11, 2023 and Japanese Patent Application No. 2023-091916 filed in Japan on June 2, 2023, the descriptions of all of which are incorporated herein by reference.

### [Background Art]

As IC cards incorporating a semiconductor memory or the like, so-called hybrid IC cards (dual IC cards) functioning as both contact- and contactless-type cards are known. Hybrid IC cards are used, for example, for credit cards, cash cards, prepaid cards, membership cards, gift cards, transportation cards, passports, driver's licenses, etc. A hybrid IC card includes, for example, an IC module including a module substrate which is provided with a contact terminal contacting a contact-type external device, an IC chip functioning as both a contact- and contactless-type chip, and a connection coil formed into a spiral form, and an antenna sheet including a coupling coil electromagnetically coupling with the connection coil in a contactless manner, and an antenna coil communicating with an external terminal in a contactless manner, with these IC module and antenna sheet being sandwiched between card substrates (e.g., PTL 1).

On the other hand, due to demands for cost reduction and the like,
IC modules having a contact terminal constituted of six terminal portions are becoming mainstream for IC modules of hybrid IC cards, rather than the conventional contact terminal constituted of eight terminal portions. Furthermore, with the introduction of a contact terminal having six terminal portions, downsizing of module substrates is proceeding.

### [Citation List]

### [Patent Literature]

PTL 1: JP6888402B

### [Summary of the Invention]

### [Technical Problem]

In an IC module, if the IC chip is mounted on the substrate in a state of being located on the connection coil, the fixing strength between the module substrate and the IC chip may decrease. Accordingly, in order to prevent the IC chip from being mounted on the substrate in a state of being located on the connection coil, it is necessary to increase the distance between the IC chip and the connection coil even more than a predetermined distance. Thus, since it is necessary to increase the distance between the IC chip and the connection coil, in addition to downsizing of the module substrate mentioned above, the number of turns of the connection coil tends to decrease. Furthermore, if the width of the connection coil is reduced in order to increase the number of turns of the connection coil, there is a risk that the connection coil may break. Furthermore, if the interval between the turns of the connection coil is reduced in order to increase the number of turns of the connection coil, there is a risk that the turn portions may short-circuit with each other. Consequently, the inductance of the connection coil is difficult to increase, and so is the impedance of the connection coil. Furthermore, in recent years, due to demand for lower capacitance IC chips, low capacitance IC chips are being used. For this reason, in recent IC modules, it has become difficult to form a connection coil with an impedance matching that of the IC chip.

The present invention has been made considering such circumstances, and aims to provide an IC module and an IC card that can increase the impedance of the connection coil.

### [Solution to Problems]

In order to solve the above issues, the present invention proposes the following solution.

An IC module according to a first aspect of the present invention includes a rectangular substrate having long sides extending in a first direction; a connection coil formed in a spiral shape on a first surface of the substrate; and an outermost connection terminal portion formed at an outermost end of the connection coil, wherein the outermost connection terminal portion includes an outermost through-hole portion penetrating the substrate in a thickness direction of the substrate, and an outermost land portion surrounding the outermost through-hole portion and connecting between the outermost through-hole portion and the connection coil; and as viewed in a second direction perpendicular to both the first direction and the thickness direction, the outermost connection terminal portion is disposed on a first side in the first direction relative to the IC chip.

According to a second aspect of the present invention, in the IC module according to the first aspect, the substrate is provided with a plurality of through-hole portions including the outermost through-hole portion, the plurality of through-hole portions penetrating the substrate in the thickness direction; and the outermost through-hole portion has an inner diameter smaller than inner diameters of other through-hole portions.

According to a third aspect of the present invention, in the IC module according to the first or second aspect, the connection coil includes a first coil portion in which the outermost connection terminal portion is formed at an outermost end, and a second coil portion disposed on an inner peripheral side relative to the first coil portion; and a coil width in the first coil portion is greater than a coil width in the second coil portion.

According to a fourth aspect of the present invention, in the IC module according to the first or second aspect, the connection coil has a width increasing from an inner peripheral side toward an outer peripheral side.

According to a fifth aspect of the present invention, in the IC module according to any one of the first to fourth aspects, the connection coil has a width greater than an interval between adjacent portions of the connection coil in a radial direction.

According to a sixth aspect of the present invention, in the IC module according to any one of the first to fifth aspects, the outermost connection terminal portion is disposed at an edge portion of the substrate on a first side in the second direction; the connection coil includes a bypass portion bypassing the outermost connection terminal portion on a second side in the second direction, and a plurality of connection pads respectively formed on different turn portions of the connection coil; and as viewed in the first direction, at least a part of the plurality of connection pads overlaps with the bypass portion.

According to a seventh aspect of the present invention, the IC module according to any one of the first to six aspects includes a contact terminal provided on a second surface of the substrate facing away from the first surface, wherein the contact terminal includes a first contact terminal portion disposed on a first side in the first direction and on a first side in the second direction relative to the IC chip, and a second contact terminal portion disposed on a second side in the first direction of the first contact terminal portion so as to be adjacent to the first contact terminal portion in the first direction; the second contact terminal portion includes a protrusion protruding toward the first side in the first direction; and as viewed in the thickness direction, at least a part of the outermost connection terminal portion overlaps with the protrusion.

According to an eighth aspect of the present invention, the IC module according to any one of the first to six aspects includes a contact terminal provided on a second surface of the substrate facing away from the first surface, wherein the contact terminal includes a second contact terminal portion disposed on a first side in the first direction relative to the IC chip; and as viewed in the thickness direction, the outermost connection terminal portion is disposed on an edge portion of the second contact terminal portion on a first side in the first direction.

According to a ninth aspect of the present invention, in the IC module according to the seventh or eighth aspect, the IC chip has an input capacitance of less than 60 pF between RF terminals; the contact terminal is constituted of a plurality of terminal portions; and the number of terminal portions constituting the contact terminal or the number of terminal portions therein is six or less.

An IC module according to a tenth aspect of the present invention includes the IC module according to any one of the first to ninth aspects; a card substrate in which the IC module is fitted; and an antenna substrate including an antenna coil and a coupling coil that can be electromagnetically coupled to the connection coil.

An IC module according to an eleventh aspect of the present invention includes a rectangular substrate; a connection coil formed in a spiral shape on a first surface of the substrate; an outermost connection terminal portion formed at an outermost end of the connection coil; an IC chip provided on a portion of the first surface on an inner peripheral side relative to the connection coil; and a contact terminal provided on a second surface of the substrate facing away from the first surface, wherein the outermost connection terminal portion comprises an outermost through-hole portion penetrating the substrate in a thickness direction of the substrate, and an outermost land portion surrounding the outermost through-hole portion and connecting between the outermost through-hole portion and the connection coil; and a part of the outermost land portion is located on an outer peripheral side relative to the connection coil.

According to a twelfth aspect of the present invention, in the IC module according to the eleventh aspect, as viewed in the thickness direction, the connection coil is disposed on an inner peripheral side relative to an outer edge of the contact terminal; and as viewed in the thickness direction, an outer edge of the outermost land portion overlaps with an outer edge of the contact terminal, or is disposed on an inner peripheral side relative to an outer edge of the contact terminal.

According to a thirteenth aspect of the present invention, in the IC module according to the eleventh aspect, the outermost through-hole portion is an edge surface through-hole provided on an edge surface of the substrate.

According to a fourteenth aspect of the present invention, in the IC module according to the eleventh aspect, the outermost connection terminal portion includes a plurality of outermost through-hole portions connected in parallel with each other via the outermost land portion; and the plurality of outermost through-hole portions are edge surface through-holes provided to an edge surface of the substrate.

According to a fifteenth aspect of the present invention, in the IC module according to thirteenth or fourteenth aspect, a portion of the edge surface of the substrate on which the outermost connection terminal portion is formed is recessed toward the inner peripheral side.

According to a sixteenth aspect of the present invention, in the IC module according to any one of the thirteenth to fifteenth aspects, the outermost through-hole portion has an arc shape with a center angle of 120° or more as viewed in the thickness direction.

According to a seventeenth aspect of the present invention, in the IC module according to any one of the thirteenth to sixteenth aspects, the outermost through-hole portion is filled with a filler made of a resin or a conductive material.

An IC module according to an eighteenth aspect of the present invention includes a rectangular substrate having long sides extending in a first direction; a connection coil formed in a spiral shape on a first surface of the substrate; an outermost connection terminal portion formed at an outermost end of the connection coil; and an IC chip provided on a portion of the first surface on an inner peripheral side relative to the connection coil, wherein the connection coil includes a first coil portion disposed on a first side in a second direction perpendicular to the first direction relative to the IC chip, and extending in the first direction, and a second coil portion disposed on a second side in the second direction relative to the IC chip, and extending in the first direction; at least either of the first coil portion and the second coil portion has a part provided with a small-width portion; as viewed in a thickness direction of the substrate, a first virtual line that is a straight line passing through both the outermost connection terminal portion and the IC chip passes through the small-width portion; and at least either of a width of a coil wire in the small-width portion and an interval between portions of the coil wire in the small-width portion is smaller than that in a portion of the connection coil other than the small-width portion.

According to a nineteenth aspect of the present invention, in the IC module according to the eighteenth aspect, the outermost connection terminal portion is disposed on an edge portion of the substrate on a first side in the second direction; the first coil portion includes a bypass portion bypassing the outermost connection terminal portion on a second side in the second direction; and at least a part of the bypass portion corresponds to the small-width portion.

According to a twentieth aspect of the present invention, in the IC module according to the nineteenth aspect, an outer peripheral portion of the bypass portion corresponds to the small-width portion.

According to a twenty-first aspect of the present invention, in the IC module according to any one of the eighteenth to twentieth aspects, the outermost connection terminal portion is disposed on an edge portion of the substrate on a first side in the second direction; and at least a part of the second coil portion corresponds to the small-width portion.

According to a twenty-second aspect of the present invention, in the IC module according to the twenty-first aspect, the small-width portion corresponds to an inner peripheral portion of the second coil portion.

According to a twenty-third aspect of the present invention, in the IC module according to the eighteenth aspect, the connection coil includes an outer coil portion having an outermost end at which the outermost connection terminal portion is formed; and the small-width portion corresponds to a portion of the connection coil on an inner peripheral side relative to the outer coil portion.

### [Advantageous Effects of the Invention]

According to the IC module and the IC card according to the present invention, impedance can be enhanced in the connection coil.

### [Brief Description of the Drawings]

Fig. 1 is a schematic plan view illustrating an IC card according to a first embodiment of the present invention.
Fig. 2 is a schematic exploded view illustrating the IC card.
Fig. 3 is a schematic exploded view illustrating an antenna substrate of the IC card.
Fig. 4 is a schematic cross-sectional view illustrating the IC card taken along the line IV-IV of Fig. 3.
Fig. 5 is a perspective view illustrating an IC module of the IC card as seen from above.
Fig. 6 is a transparent view illustrating the IC module of the IC card as seen from above.
Fig. 7 is a transparent view illustrating an IC module of an IC card as seen from above, according to a second embodiment of the present invention.
Fig. 8 is an enlarged transparent view illustrating the IC module of the IC card as seen from above, according to the second embodiment of the present invention.
Fig. 9 is an enlarged transparent view illustrating the IC module of the IC card as seen from above, according to a modification of the second embodiment of the present invention.
Fig. 10 is a transparent view illustrating an IC module of an IC card as seen from above, according to a third embodiment of the present invention.
Fig. 11 is a transparent view illustrating an IC module of an IC card as seen from above, according to a fourth embodiment of the present invention.
Fig. 12 is a transparent view illustrating an IC module of an IC card as seen from above, according to a fifth embodiment of the present invention.
Fig. 13 is a transparent view illustrating an IC module of an IC card as seen from above, according to a sixth embodiment of the present invention.
Fig. 14 is a transparent view illustrating an IC module of an IC card as seen from above, according to a seventh embodiment of the present invention.
Fig. 15 is an enlarged transparent view illustrating an IC module of an IC card as seen from above.
Fig. 16 is a perspective view illustrating a process of dicing to obtain IC modules of IC cards.
Fig. 17 is an enlarged transparent view illustrating an IC module of an IC card as seen from above, according to an eighth embodiment of the present invention.
Fig. 18 is an enlarged transparent view illustrating an IC module of an IC card as seen from above, according to a ninth embodiment of the present invention.
Fig. 19 is an enlarged transparent view illustrating an IC module of an IC card as seen from above, according to a tenth embodiment of the present invention.
Fig. 20 is a transparent view illustrating an IC module of an IC card as seen from above, according to an eleventh embodiment of the present invention.
Fig. 21 is a transparent view illustrating an IC module of an IC card as seen from above, according to a twelfth embodiment of the present invention.
Fig. 22 is a transparent view illustrating an IC module of an IC card as seen from above, according to a thirteenth embodiment of the present invention.
Fig. 23 is an enlarged transparent view illustrating an IC module of an IC card as seen from above.
Fig. 24 is a transparent view illustrating an IC module of an IC card as seen from above, according to a fourteenth embodiment of the present invention.
Fig. 25 is an enlarged transparent view illustrating an IC module of an IC card as seen from above.
Fig. 26 is a transparent view illustrating an IC module of an IC card as seen from above, according to a fifteenth embodiment of the present invention.
Fig. 27 is a transparent view illustrating an IC module of an IC card as seen from above, according to a sixteenth embodiment of the present invention.
Fig. 28 is a transparent view illustrating an IC module of an IC card as seen from above, according to a seventeenth embodiment of the present invention.
Fig. 29 is a transparent view illustrating an IC module of an IC card as seen from above, according to an eighteenth embodiment of the present invention.
Fig. 30 is a transparent view illustrating an IC module of an IC card as seen from above, according to a nineteenth embodiment of the present invention.

### [Description of the Embodiments]

With reference to the drawings, IC modules and IC cards according to some embodiments of the present invention will be described. The scope of the present invention is not limited to the following embodiments, but can be modified as desired within the scope of the technical concept of the present invention. In the drawings below, the scale, the number, etc. of the components may be different from the actual structure, for easy understanding of the components.

In the following description, a thickness direction Dt is shown in each figure as appropriate. The thickness direction Dt is the direction in which the surface of the substrate faces in the IC modules of the embodiments described below. In the following description, the side toward which the arrow of the thickness direction Dt points (+Dt side) is referred to as upper side, above, or upward. The side opposite to the side toward which the arrow of the thickness direction Dt points (-Dt side) is referred to as lower side, below, or downward. Furthermore, of the outer surfaces of each component constituting an IC card, the surface facing upward may be referred to as front surface, and the surface facing downward may be referred to as rear surface. It should be noted that the terms upward and downward are merely names used for explaining the relative positional relationship between the components, and the configuration may be other than that indicated by these names.

In the following description, an inner peripheral direction Di and an outer peripheral direction Do are shown in each figure as appropriate. The inner peripheral direction Di is the direction toward the center axis of the IC chip as seen in the thickness direction Dt. The center axis of the IC chip is a virtual axis extending in the thickness direction. The outer peripheral direction Do is the direction opposite to the direction toward the center axis of the IC chip as seen in the thickness direction Dt. In the following description, the side toward which the arrow of the inner peripheral direction Di points (Di side) is referred to as inner peripheral side, and the side toward which the arrow of the outer peripheral direction Do points (Do side) is referred to as outer peripheral side. In the following description, the radial direction centered on the center axis of the IC chip is simply referred to as radial direction.

### <First Embodiment>

In the following description, a first direction D1 is shown in each figure as appropriate. In the present embodiment, the first direction D1 is the direction in which the long sides of the rectangular substrate extend and perpendicular to the thickness direction Dt. In the following description, the side toward which the arrow of the first direction D1 points (+D1 side) is referred to as first side in the first direction D1. The side opposite to the side toward which the arrow of the first direction D1 points (-D1 side) is referred to as second side in the first direction D1.

In the following description, a second direction D2 is shown in each figure as appropriate. In the present embodiment, the second direction D2 is the direction in which the short sides of the rectangular substrate extend and perpendicular to the first direction D1 and the thickness direction Dt. In the following description, the side toward which the arrow of the second direction D2 points (+D2 side) is referred to as first side in the second direction D2. The side opposite to the side toward which the arrow of the second direction D2 points (-D2 side) is referred to as second side in the second direction D2. In the following description, the plane parallel to both the first direction D1 and the second direction D2 may be referred to as horizontal plane.

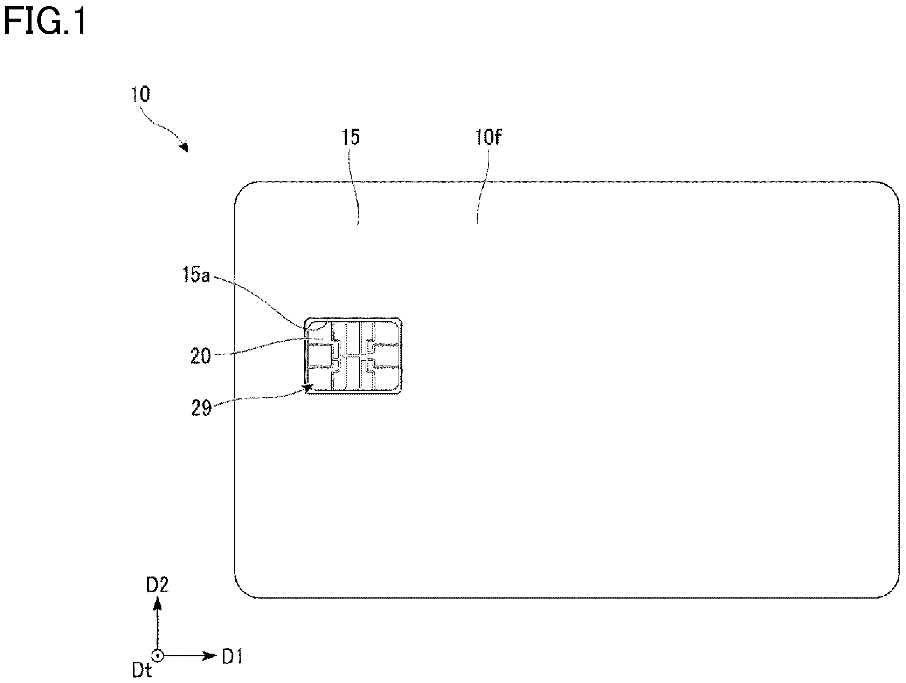

Referring to Figs. 1 to 6, a first embodiment of the present invention will be described. In the embodiments and modifications described below, components corresponding to each other are given the same reference signs, and descriptions of the corresponding components may be omitted. In the following description, expressions indicating relative or absolute positioning, such as parallel, perpendicular, center, and coaxial, not only indicate such positioning strictly, but also indicate positioning with a relative displacement with a tolerance or with an angle or distance to an extent that the same function is obtained.

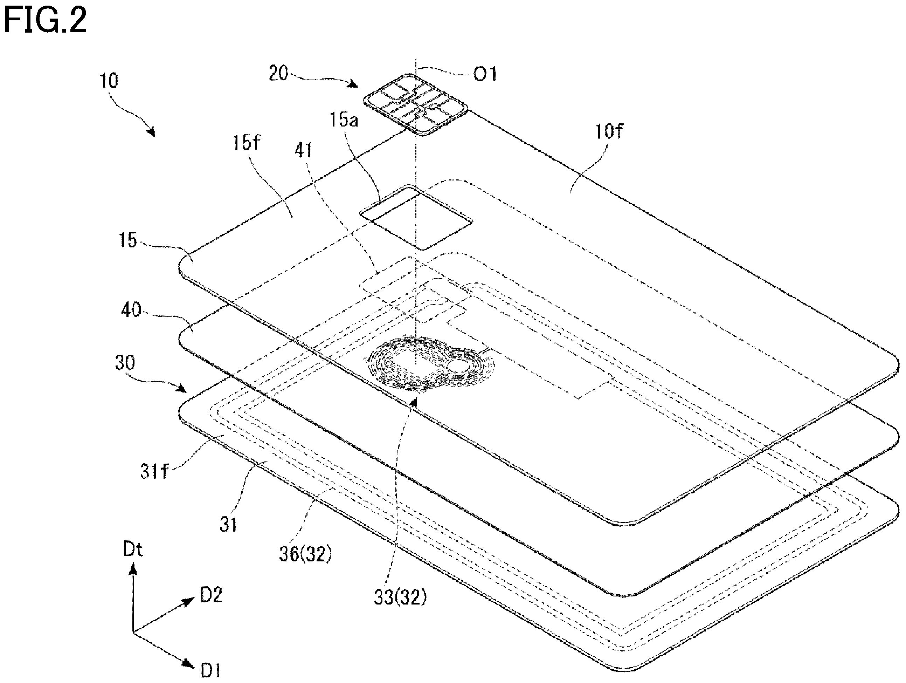

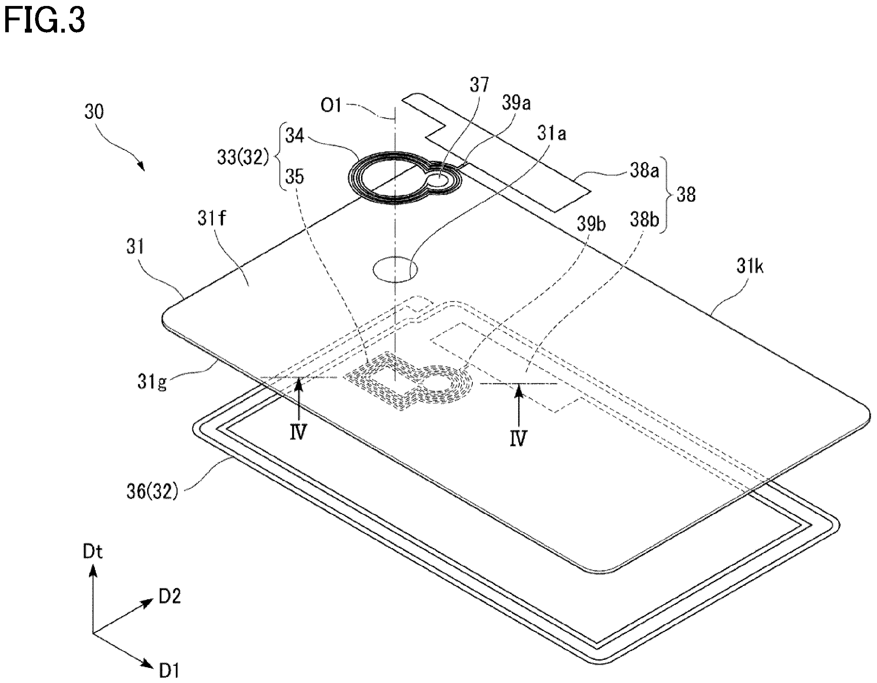

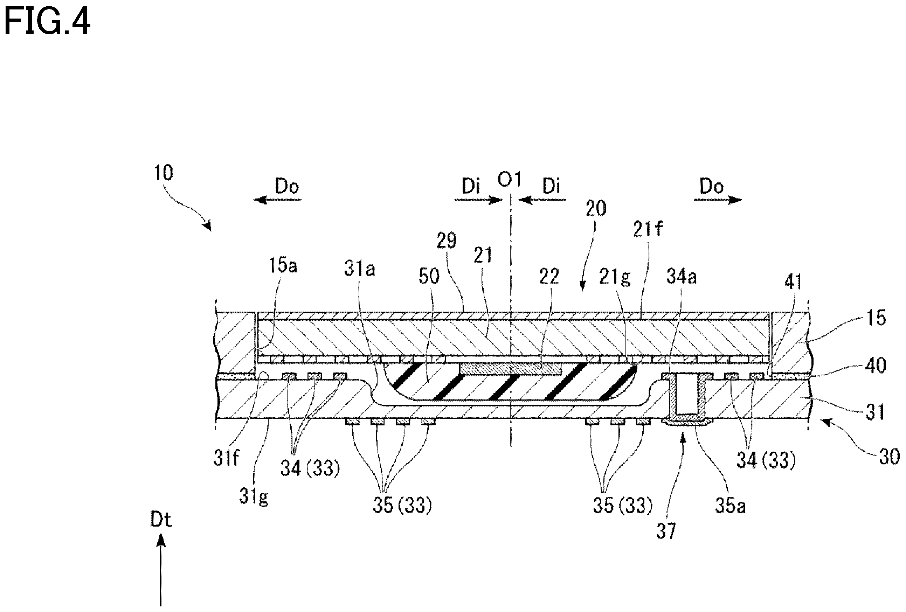

Fig. 1 is a schematic plan view illustrating an IC card 10 according to the first embodiment . Fig. 2 is a schematic exploded view illustrating the IC card 10. Fig. 3 is a schematic exploded view illustrating an antenna substrate 30 of the IC card 10. Fig. 4 is a schematic cross-sectional view illustrating the IC card 10 taken along the line IV-IV of Fig. 3.

As shown in Fig. 1, the IC card 10 is a hybrid IC card (dual IC card) capable of both contact and contactless communication with an external device. In the present embodiment, the communication range for contactless communication is the HF band (13.56 MHz) generally used on the market. The IC card 10 is in the form of a plate with its surface facing in the thickness direction Dt. As viewed in the thickness direction Dt, the IC card 10 is formed into a rectangular shape with its long sides extending in the first direction D1. The thickness of the IC card 10 in the thickness direction Dt may be, for example, about 0.5 mm or more and 1.0 mm or less. As shown in Fig. 2, the IC card 10 includes a card substrate 15, an antenna substrate 30, an IC module 20, and an adhesive layer 40. The IC module 20 of the present embodiment is a dual interface electromagnetic coupling card module capable of both contact and contactless communication with an external device.

### [Card substrate 15]

The card substrate 15 is a substrate constituting the upper side (+Dt side) of the IC card 10. The card substrate 15 has a surface 15f that is a surface 10f of the IC card 10. Examples of the material used for forming the card substrate 15 in the present embodiment include polyester-based materials such as amorphous polyester, vinyl chloride-based materials such as PVC (polyvinyl chloride), polycarbonate-based materials, and PET-G (polyethylene terephthalate copolymer). The card substrate 15 may be formed using a metal sheet, a magnetic material, or the like. The card substrate 15 may also be formed using a plastic material having high fluidity and insulating properties, such as of a UV-curable type or a mixed-liquid reaction-curable type.

The shape of the card substrate 15, such as its outer shape, may be appropriately determined in accordance with card standards. The card substrate 15 may be constituted as a laminate of two or more layers. The card substrate 15 may be provided with a magnetic layer, a protective layer, etc., and may be provided with a functional surface coating using a molding method such as a heat-sensitive, thermal transfer, or inkjet method. The surface 15f of the card substrate 15 preferably has translucency, colored transparency, or colorless transparency. Furthermore, the card substrate 15 may have fine linear convexities or concavities formed therein. The card substrate 15 is provided with an openings 15a.

The opening 15a is a hole penetrating the card substrate 15 in the thickness direction Dt. The opening 15a may be formed by, for example, milling the card substrate 15. The opening 15a surrounds a center axis O1. The shape of the opening 15a as viewed in the thickness direction Dt is not particularly limited, but in the present embodiment, it is formed into a substantially rectangular shape to match the shape of the IC module 20.

### [Antenna substrate 30]

In the present embodiment, the antenna substrate 30 is disposed on the lower side (-Dt side) relative to the card substrate 15. As shown in Fig. 3, the antenna substrate 30 includes an antenna sheet 31, a booster antenna 32, a front-rear conductor 37, and a capacitor 38.

The antenna sheet 31 is an insulating substrate having flexibility. The antenna sheet 31 is formed, for example, using materials such as polyethylene terephthalate (PET), polyethylene naphthalate (PEN), PET-G (terephthalic acid-cyclohexanedimethanol-ethylene glycol copolymer), polyvinyl chloride, vinyl chloride-vinyl acetate copolymer, polycarbonate, polyamide, polyimide, cellulose diacetate, cellulose triacetate, polystyrene-based materials, ABS, polyacrylic ester, polypropylene, polyethylene, polyurethane, polyimide, glass epoxy, and phenolic resins. The antenna sheet 31 includes a recess 31a.

As shown in Fig. 4, the recess 31a is a recess recessed downward (toward -Dt side) from a front surface 31f of the antenna sheet 31. For example, the recess 31a is formed in the front surface 31f of the antenna sheet 31 by milling. As viewed in the thickness direction Dt, the recess 31a is formed into a substantially circular shape centered on the center axis O1. The recess 31a is disposed below the opening 15a and has a smaller opening area than the opening 15a. At least a part of a resin seal portion 50 (described later) of the IC module 20 is accommodated inside the recess 31a.

As shown in Fig. 3, the booster antenna 32 includes antenna patterns provided on both the front surface 31f and a rear surface 31g of the antenna sheet 31. The booster antenna 32 includes a coupling coil 33 and an antenna coil 36. The coupling coil 33 includes a first coupling coil 34 and a second coupling coil 35. The first coupling coil 34, the second coupling coil 35, and the antenna coil 36 have electrical conductivity.

The first coupling coil 34 is formed on the front surface 31f of the antenna sheet 31. The first coupling coil 34 is formed into a spiral shape having two or more turns centered on the center axis O1. As shown in Fig. 4, the first coupling coil 34 is disposed on the outer peripheral side (Do side) relative to the recess 31a. As shown in Fig. 3, the outermost end of the first coupling coil 34 is connected to a first capacitor 38a (described later) of the capacitor 38 via connection wiring 39a. Thus, the first coupling coil 34 is electrically connected to the first capacitor 38a. As shown in Fig. 4, the first coupling coil 34 has an innermost end at which a first terminal portion 34a formed.

The first terminal portion 34a is formed into a substantially circular shape and has a width greater than the width (thickness) of the first coupling coil 34. The first terminal portion 34a is disposed on the outer peripheral side (Do side) relative to the recess 31a. The position at which the first terminal portion 34 a is disposed is not particularly limited, but it is preferable that the first terminal portion 34a be disposed at a position close to the center of the first coupling coil 34 in order to reduce the length of the first coupling coil 34.

As shown in Fig. 3, the second coupling coil 35 is formed on the rear surface 31g of the antenna sheet 31. The second coupling coil 35 is formed into a spiral shape having two or more turns centered on the center axis O1. As viewed in the thickness direction Dt, the second coupling coil 35 is wound in a rectangular shape. As shown in Fig. 4, as viewed in the thickness direction Dt, a portion of the second coupling coil 35 on the inner peripheral side (Di side) overlaps with the recess 31a and the resin seal portion 50. As shown in Fig. 3, the second coupling coil 35 is connected to a second capacitor 38b (described later) of the capacitor 38 via connection wiring 39b. Thus, the second coupling coil 35 is electrically connected to the second capacitor 38b. As shown in Fig. 4, the second coupling coil 35 is provided with a second terminal portion 35a.

The second terminal portion 35a is formed into a substantially circular shape. As viewed in the thickness direction Dt, the second terminal portion 35a is disposed on the outer peripheral side (Do side) relative to the recess 31a. In the present embodiment, as viewed in the thickness direction Dt, the second terminal portion 35a is disposed at a position overlapped with the first terminal portion 34a.

As shown in Fig. 3 , the antenna coil 36 is formed on the rear surface 31g of the antenna sheet 31. The antenna coil 36 is electrically connected to the second coupling coil 35 and the second capacitor 38b, and performs contactless communication with a contactless external device such as a reader/writer. The antenna coil 36 is formed into a rectangular shape. The antenna coil 36 is formed in one or two turns along a peripheral edge 31k of the antenna sheet 31. The number of turns, shape, width, and the like of the antenna coil 36 are not limited as long as contactless communication can be performed with a contactless external device. The antenna coil 36 may be formed on the front surface 31f of the antenna sheet 31. The antenna coil 36 only has to be formed on at least either of the front and rear surfaces 31f and 31g of the antenna sheet 31.

In the present embodiment, the width of the antenna coil 36 is greater than that of the coupling coil 33. The width of the antenna coil 36 may be substantially equal to or smaller than that of the coupling coil 33. The widths of the coupling coil 33 and the antenna coil 36 are preferably determined such that the imaginary impedances of both coils are equal at the set communication frequency.

There is no particular limitation on the method of producing the booster antenna 32 having the coupling coil 33 and the antenna coil 36, but the booster antenna 32 can be formed using various production methods. Examples of the method of producing the booster antenna 32 include laser cutting or punching of metal sheets or foils, etching of metal foils or metal layers, and placing a metal wire. Punching is particularly suitable for forming the antenna coil 36 with a large width. If the coupling coil 33 is formed using a metal wire with insulation coating, it is not necessary to separately place insulators at the intersections, and the coupling coil 33 can be easily formed. If the coupling coil 33 and the antenna coil 36 are formed using different materials, the two can be connected by soldering, welding, pressure welding, or the like.

As shown in Fig. 4, as viewed in the thickness direction Dt, the front-rear conductor 37 is disposed on the outer peripheral side (Do side) relative to the recess 31a. The front-rear conductor 37 is formed by crimping the first terminal portion 34a of the first coupling coil 34 and the second terminal portion 35a of the second coupling coil 35. In the front-rear conductor 37, the first and second terminal portions 34a and 35a are electrically connected to each other. Thus, the antenna patterns formed on both the front and rear surfaces 31f and 31g of the antenna sheet 31 are electrically connected to each other.

The method of electrically connecting the antenna patterns formed on both the front and rear surfaces 31f and 31g of the antenna sheet 31 is not particularly limited. For example, after forming antenna patterns on both the front and rear surfaces 31f and 31g of the antenna sheet 31, a hole for allowing electrical continuity between the patterns may be formed at a desired position, and the hole may be filled with a conductive ink to electrically connect the patterns, or the patterns may be electrically connected by plating.

The capacitor 38 may be, for example, a chip capacitor (including a plate capacitor). The capacitor 38 forms a resonant circuit together with the antenna coil 36 and adjusts the resonant frequency. As shown in Fig. 3, the capacitor 38 includes the first capacitor 38a and the second capacitor 38b.

The first capacitor 38a is provided on the front surface 31f of the antenna sheet 31. The first capacitor 38a is electrically connected to the first coupling coil 34. The second capacitor 38b is provided on the rear surface 31g of the antenna sheet 31. The second capacitor 38b is electrically connected to the second coupling coil 35 and the antenna coil 36. As viewed in the thickness direction Dt, at least a part of the second capacitor 38b overlaps with the first capacitor 38a.

The capacitance of the capacitor 38 can be adjusted by changing the area in which the first and second capacitors 38a and 38b overlap with each other. The capacitance of the capacitor 38 can be adjusted by changing the width, length, relative arrangement, etc. of the electrodes of the first and second capacitors 38a and 38b. The capacitor 38 is formed, for example, by etching a copper foil or an aluminum foil that has been coated with a resist by generally used gravure printing.

### [IC module 20]

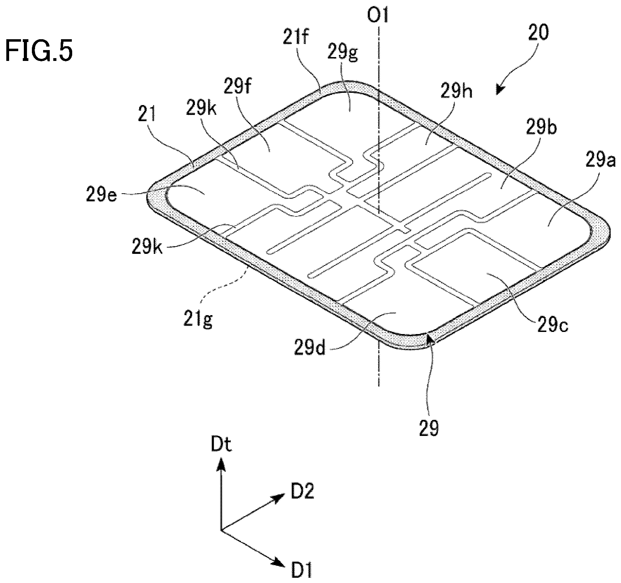

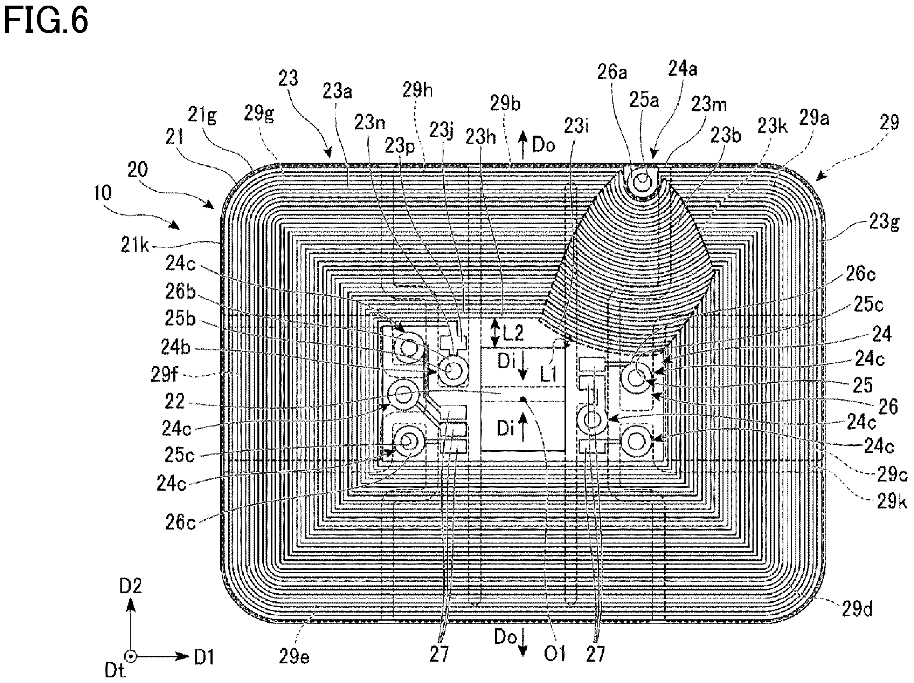

Fig. 5 is a perspective view illustrating the IC module 20 of the IC card 10 as seen from above (+Dt side). Fig. 6 is a transparent view illustrating the IC module 20 of the IC card 10 as seen from above.

As shown in Fig. 4, the IC module 20 is fitted to the opening 15a of the card substrate 15. As shown in Fig. 6, the IC module 20 includes a substrate 21 , an IC chip 22, a connection coil 23, a connection terminal 24, relay pads 27, and a contact terminal 29. As shown in Fig. 4, the IC module 20 includes the resin seal portion 50. As shown in Fig. 5, the IC module 20 has a rectangular shape with the long sides extending in the first direction D1. The long-side dimension of the IC module 20 is about 10.6 mm, and the short-side dimension of the IC module 20 is about 8.0 mm. As will be described later, the IC module 20 of the present embodiment is a so-called six-terminal IC module. The size of the substrate 21 according to the present embodiment is smaller than the size of the substrate of the so-called eight-terminal IC module of the conventional art.

As shown in Fig. 4, the IC module 20 is disposed with a small gap between it and the inner side surface of the opening 15a of the card substrate 15 to prevent electrical short-circuiting with the inner side surface of the opening 15a. This can suppress electrical short-circuiting between the IC module 20 and the card substrate 15 even when the card substrate 15 is made of a conductive material such as metal. Therefore, communication failure of the IC card 10 can be suppressed.

In the present embodiment, the substrate 21 is in the form of a sheet extending in the direction perpendicular to the thickness direction Dt. As shown in Fig. 5, as viewed in the thickness direction Dt, the substrate 21 has a rectangular shape with the long sides extending in the first direction D1. The substrate 21 may be formed, for example, using a material such as glass epoxy and polyethylene terephthalate. As shown in Fig. 4, the substrate 21 has a first surface 21g and a second surface 21f. Of the outer surfaces of the substrate 21, the first surface 21g is the surface facing downward (-Dt side). The first surface 21g corresponds to the rear surface of the substrate 21. Of the outer surfaces of the substrate 21, the second surface 21f is the surface facing upward (+Dt side). The second surface 21f corresponds to the front surface of the substrate 21. The second surface 21f is the surface facing away from the first surface 21g.

As shown in Fig. 6, the IC chip 22 is provided on the first surface 21g of the substrate 21. The IC chip 22 is provided on a portion of the first surface 21g on the inner peripheral side (Di side) relative to the connection coil 23. As viewed in the thickness direction Dt, the IC chip 22 is disposed at substantially the center of the substrate 21 in both the first direction D1 and the second direction D2. In the present embodiment, the IC chip 22 is formed into a substantially rectangular shape as viewed in the thickness direction Dt. In the present embodiment, the input capacitance between the RF terminals of the IC chip 22 is less than 60 pF, which is smaller than the input capacitance between the RF terminals of the conventional IC chips. The IC chip 22 can have a known configuration having contact and contactless communication functions. The IC chip 22 has multiple terminals not shown. These terminals of the IC chip 22 are electrically connected to the connection coil 23 and the contact terminal 29 via the connection terminal 24, the relay pads 27, a connection pad 23p of the connection coil 23 described later, wiring formed on the substrate 21, and wires not shown. Thus, the IC chip 22 is electrically connected to the connection coil 23 and the contact terminal 29.

The contact terminal 29 is configured so that it can be in contact with a contact external device. As shown in Fig. 5, the contact terminal 29 is provided on the second surface 21f of the substrate 21. The contact terminal 29 has electrical conductivity. For example, the contact terminal 29 may be made of a metal such as gold and copper. The contact terminal 29 is electrically connected to the IC chip 22 via relay connection terminal portions 24c (described later) of the connection terminal 24, relay pads 27, etc. The contact terminal 29 is constituted of multiple terminal portions. In the present embodiment, the contact terminal 29 is constituted of eight terminal portions. The contact terminal 29 includes a first contact terminal portion 29a, a second contact terminal portion 29b, a third contact terminal portion 29c, a fourth contact terminal portion 29d, a fifth contact terminal portion 29e, a sixth contact terminal portion 29f, a seventh contact terminal portion 29g, and an eighth contact terminal portion 29h. Slits 29k are formed between the terminal portions. The terminal portions are insulated from each other by the slits 29k.

The first contact terminal portion 29a is a GND (ground) terminal portion. The IC chip 22 is grounded via the first contact terminal portion 29a. The first contact terminal portion 29a is disposed at a portion of the substrate 21 on the first side (+D1 side) in the first direction D1 and on the first side (+D2 side) in the second direction D2. The edge portion of the first contact terminal portion 29a on the second side (-D1 side) in the first direction D1 is located on the first side in the first direction D1 relative to the center of the substrate 21 in the first direction D1. The edge portion of the first contact terminal portion 29a on the second side (-D2 side) in the second direction D2 is located on the first side in the second direction D2 relative to the center of the substrate 21 in the second direction D2. As shown in Fig. 6, the first contact terminal portion 29a is disposed on the first side in the first direction D1 and on the first side in the second direction D2 relative to the IC chip 22.

The second contact terminal portion 29b is a terminal portion which is not defined in card standards such as ISO/IEC 7816 and is not used for contact communication. Specifically, the second contact terminal portion 29b is a terminal that is not used when the IC chip 22 and a contact external device perform contact communication. As shown in Fig. 5, the second contact terminal portion 29b is located on the second side (-D1 side) in the first direction D1 relative to the first contact terminal portion 29a. The second contact terminal portion 29b is provided starting from an edge portion of the substrate 21 on the first side (+D2 side) in the second direction D2 to an edge portion thereof on the second side (-D2 side) in the second direction D2. A portion of the second contact terminal portion 29b on the first side in the second direction D2 is located on the second side in the first direction D1 of the first contact terminal portion 29a. The portion of the second contact terminal portion 29b on the first side in the second direction D2 is disposed adjacent to the first contact terminal portion 29a in the first direction D1. As shown in Fig. 6, the end portion of the second contact terminal portion 29b on the first side (+D1 side) in the first direction D1 is located on the first side in the first direction D1 relative to the IC chip 22.

The third contact terminal portion 29c is a VPP terminal portion. As shown in Fig. 5, the third contact terminal portion 29c is located on the second side (-D2 side) in the second direction D2 of the first contact terminal portion 29a. The third contact terminal portion 29c is disposed adjacent to the first contact terminal portion 29a in the second direction D2. As shown in Fig. 6, the second contact terminal portion 29b is disposed on the first side (+D1 side) in the first direction D1 of the IC chip 22. In the present embodiment, the third contact terminal portion 29c is a terminal portion that is not used during contact communication. The third contact terminal portion 29c may be used during contact communication.

The fourth contact terminal portion 29d is an I/O (input/output) terminal portion. Data is inputted/outputted between the IC chip 22 and a contact external device via the fourth contact terminal portion 29d. As shown in Fig. 5, the fourth contact terminal portion 29d is located on the second side (-D2 side) in the second direction D2 of the third contact terminal portion 29c. The fourth contact terminal portion 29d is disposed adjacent to the third contact terminal portion 29c in the second direction D2.

The fifth contact terminal portion 29e is a CLK (clock) terminal portion. A clock signal is transmitted to the IC chip 22 via the fifth contact terminal portion 29e. The fifth contact terminal portion 29e is disposed at a portion of the substrate 21 on the second side (-D1 side) in the first direction D1 and on the second side (-D2 side) in the second direction D2.

The sixth contact terminal portion 29f is an RST (reset) terminal portion. A reset signal is transmitted to the IC chip 22 via the sixth contact terminal portion 29f. The sixth contact terminal portion 29f is located on the first side (+D2 side) in the second direction D2 of the fifth contact terminal portion 29e. The sixth contact terminal portion 29f is disposed adjacent to the fifth contact terminal portion 29e in the second direction D2.

The seventh contact terminal portion 29g is a VCC terminal portion. Power is supplied to the IC chip 22 via the seventh contact terminal portion 29g. The seventh contact terminal portion 29g is located on the first side (+D2 side) in the second direction D2 of the sixth contact terminal portion 29f. The seventh contact terminal portion 29g is disposed adjacent to the sixth contact terminal portion 29f in the second direction D2.

The eighth contact terminal portion 29h is a terminal portion which is not defined in card standards such as ISO/IEC 7816 and is not used for contact communication. In the first direction D1, the eighth contact terminal portion 29h is located between the seventh contact terminal portion 29g and a portion of the second contact terminal portion 29b on the first side (+D2 side) in the second direction D2.

As described above, in the present embodiment, the contact terminal 29 has eight terminal portions, but the second and eighth contact terminal portions 29b and 29h are not used when the IC chip 22 and the contact external device perform contact communication with each other. Therefore, when the IC chip 22 and the contact external device perform contact communication, the number of terminal portions used is six. That is, the IC module 20 of the present embodiment is a so-called six-terminal IC module. That is, the number of terminal portions used is six or less when the IC chip 22 performs contact communication with an external contact device. The number of terminal portions constituting the contact terminal 29 is not limited to eight, but may be seven or six. In this case, at least one of the second and eighth contact terminal portions 29b and 29h does not have to be necessarily provided.

As shown in Fig. 6 , the connection coil 23 is formed on the first surface 21g of the substrate 21. The connection coil 23 is formed of a coil wire wound in a spiral shape. In the present embodiment, the connection coil 23 is formed of a coil wire wound approximately 18 times in a substantially rectangular shape. That is, the number of turns of the connection coil 23 is 18. In the following description, one turn of the connection coil 23 is referred to as a turn portion. The connection coil 23 is constituted of 18 turn portions. The turn portions are disposed side by side in the radial direction. In the connection coil 23, an outermost turn portion 23g disposed on the most outer peripheral side (Do side) is formed into a substantially rectangular shape conforming to an edge surface 21k of the substrate 21. An innermost turn portion 23h of the connection coil 23 disposed on the most inner peripheral side (Di side) faces the IC chip 22, the connection terminal 24, and the relay pads 27 in the radial direction.

The connection coil 23 is fixed to the substrate 21 using an unshown adhesive or the like. For example, the connection coil 23 may be formed by patterning a copper foil or an aluminum foil on its first surface 21g by etching. The connection coil 23 can be formed with a thickness in the range of 5 µm or more and 50 µm or less. In the present embodiment, the thickness of the connection coil 23 is about 30 µm. In the present embodiment, the width of the coil wire is about 80 µm. That is, the width of the connection coil 23 is about 80 µm. In the present embodiment, the interval between turn portions adjacent in the radial direction is about 75 µm. That is, the interval between adjacent portions of the connection coil 23 in the radial direction is about 75 µm. Thus, the width of the connection coil 23 is greater than the interval between adjacent portions of the connection coil 23 in the radial direction. The width of the connection coil 23 and the interval between adjacent portions of the connection coil 23 in the radial direction are not limited to the dimensions of the present embodiment, but can be determined appropriately depending on the impedance, etc. required for the connection coil 23. The connection coil 23 includes a rectangular portion 23a, a bypass portion 23b, and a connection pad 23p.

The rectangular portion 23a is a portion of the connection coil 23, which is formed into a rectangular shape. A bypass area 23k shown in Fig. 6, which is indicated by a virtual closed curve, is an area in which the bypass portion 23b is formed. The rectangular portion 23a is a portion of the connection coil 23 located outside the bypass area 23k. The bypass portion 23b is a portion of the connection coil 23 bypassing an outermost connection terminal portion 24a (described later) of the connection terminal 24. The bypass portion 23b is a portion of the connection coil 23 located inside the bypass area 23k. The bypass portion 23b bypasses the second side (-D2 side) in the second direction D2 of the outermost connection terminal portion 24a. As viewed in the thickness direction Dt, the turn portions constituting the bypass portion 23b are formed into a substantially arc shape centered on the outermost connection terminal portion 24a and protrude toward the inner peripheral side (Di side). A first innermost turn portion 23i shown in Fig. 6 is a portion of the innermost turn portion 23h constituting the bypass portion 23b. A second innermost turn portion 23j is a portion of the innermost turn portion 23h constituting the rectangular portion 23a, that is, a portion located on the first side (+D2 side) in the second direction D2 relative to the IC chip 22. The first innermost turn portion 23i is located on the second side in the second direction D2 relative to the second innermost turn portion 23j. Therefore, a first distance L1, which is the distance between the first innermost turn portion 23i and the IC chip 22, is smaller than a second distance L2, which is the distance between the second innermost turn portion 23j and the IC chip 22. That is, since the bypass portion 23b bypasses the outermost connection terminal portion 24a on the second side in the second direction D2, the distance between the connection coil 23 and the IC chip 22 is reduced.

The connection pad 23p is connected to the vicinity of an innermost end 23n of the connection coil 23. The connection pad 23p is formed into a substantially rectangular shape with a width greater than that of the coil wire. The connection pad 23p is electrically connected to some of the multiple electrodes of the IC chip 22 by wire bonding or the like. Consequently, the connection coil 23 is electrically connected to the IC chip 22. Therefore, the IC chip 22 can perform contactless communication with a contactless external device via the connection coil 23 and the booster antenna 32.

As shown in Fig. 4, when the IC module 20 is fitted to the opening 15a, the connection coil 23 is disposed so as to be electromagnetically coupled with the coupling coil 33 of the booster antenna 32. Thus, the IC module 20 can perform contactless communication with a contactless external device via the connection coil 23 and the booster antenna 32.

The connection terminal 24 shown in Fig. 6 electrically connects the contact terminal 29 to the connection coil 23 and the relay pads 27. The connection terminal 24 has a through-hole 25 and a land 26. The connection terminal 24 includes the outermost connection terminal portion 24a, an innermost connection terminal portion 24b, and the multiple relay connection terminal portions 24c. The through-hole 25 penetrates the substrate 21 in the thickness direction Dt and has an inner peripheral surface provided with a copper foil layer. In the present embodiment, the through-hole 25 includes an outermost through-hole portion 25a, an innermost through-hole portion 25b, and multiple relay through-hole portions 25c. The land 26 electrically connects the through-hole 25 to the contact terminal 29, the connection coil 23, and the relay pads 27. The land 26 surrounds the through-hole 25. The land 26 is connected to the through-hole 25. The land 26 includes an outermost land portion 26a, an innermost land portion 26b, and multiple relay land portions 26c. In the present embodiment, the inner diameter of the through-hole 25 may be, for example, about 300 µm, and the outer diameter of the land 26 may be, for example, about 600 µm. The inner diameter of the through-hole 25 and the outer diameter of the land 26 are not limited to these dimensions, but may be different from these dimensions.

The outermost connection terminal portion 24a is formed at an outermost end 23m of the connection coil 23. The outermost connection terminal portion 24a is disposed at an edge portion of the substrate 21 on the first side (+D2 side) in the second direction D2. In the first direction D1, the outermost connection terminal portion 24a is disposed on the first side (+D1 side) in the first direction D1 relative to the IC chip 22. As viewed in the second direction D2, the outermost connection terminal portion 24a is disposed on the first side in the first direction D1 relative to the IC chip 22. As viewed in the thickness direction Dt, the outermost connection terminal portion 24a overlaps with an edge portion of the second contact terminal portion 29b on the first side in the second direction D2 and an edge portion thereof on the first side in the first direction D1. The outermost connection terminal portion 24a electrically connects the connection coil 23 and the second contact terminal portion 29b. The outermost connection terminal portion 24a includes the outermost through-hole portion 25a and the outermost land portion 26a.

The outermost through-hole portion 25a penetrates the substrate 21 in the thickness direction Dt. As viewed in the thickness direction Dt, the outermost through-hole portion 25a has a substantially circular shape. The outermost land portion 26a has an annular shape surrounding the outermost through-hole portion 25a. As viewed in the thickness direction Dt, the outermost land portion 26a overlaps with the second contact terminal portion 29b. The outermost connection terminal portion 24a is provided with first and second halves of the outermost land portion 26a. The first half of the outermost land portion 26a is provided on the first surface 21g of the substrate 21. The first half of the outermost land portion 26a has an outer edge connected to the outermost end 23m of the connection coil 23. The first half of the outermost land portion 26a has an inner edge connected to the outermost through-hole portion 25a. Although not shown, the second half of the outermost land portion 26a is provided on the second surface 21f of the substrate 21. The second half of the outermost land portion 26a has an inner edge connected to the outermost through-hole portion 25a. The second half of the outermost land portion 26a is connected to the second contact terminal portion 29b. Consequently, the connection coil 23 is electrically connected to the second contact terminal portion 29b via the outermost connection terminal portion 24a.

The innermost connection terminal portion 24b is formed at the innermost end 23n of the connection coil 23. The innermost connection terminal portion 24b is disposed on the inner peripheral side (Di side) relative to the connection coil 23. The innermost connection terminal portion 24b is disposed on the second side (-D1 side) in the first direction D1 of the IC chip 22. As viewed in the thickness direction Dt, the innermost connection terminal portion 24b overlaps with the eighth contact terminal portion 29h. The innermost connection terminal portion 24b includes the innermost through-hole portion 25b and the innermost land portion 26b.

The innermost through-hole portion 25b penetrates the substrate 21 in the thickness direction Dt. The innermost land portion 26b has an annular shape surrounding the innermost through-hole portion 25b. The innermost connection terminal portion 24b is provided with first and second halves of the innermost land portion 26b. The first half of the innermost land portion 26b is provided on the first surface 21g of the substrate 21. The first half of the innermost land portion 26b electrically connects the innermost end 23n of the connection coil 23 to the innermost through-hole portion 25b. Although not shown, the second half of the innermost land portion 26b is provided on the second surface 21f of the substrate 21. The second half of the innermost land portion 26b electrically connects the innermost through-hole portion 25b to the eighth contact terminal portion 29h. Consequently, the connection coil 23 is electrically connected to the eighth contact terminal portion 29h via the innermost connection terminal portion 24b.

The multiple relay connection terminal portions 24c are connected to the contact terminal 29. In the present embodiment, the connection terminal 24 includes six relay connection terminal portions 24c. The relay connection terminal portions 24c are disposed on the inner peripheral side (Di side) relative to the connection coil 23. The relay connection terminal portions 24c include respective relay through-hole portions 25c and relay land portions 26c. The relay connection terminal portions 24c are electrically connected to the first contact terminal portion 29a, the third contact terminal portion 29c, the fourth contact terminal portion 29d, the fifth contact terminal portion 29e, the sixth contact terminal portion 29f, and the seventh contact terminal portion 29g, respectively.

The relay pads 27 have electrical conductivity. The relay pads 27 are formed on the first surface 21g of the substrate 21. In the present embodiment, six relay pads 27 are formed. The relay pads 27 electrically connect the multiple relay connection terminal portions 24c to the IC chip 22. The relay pads 27 are disposed on the inner peripheral side (Di side) relative to the connection coil 23. The relay pads 27 are electrically connected to respective different relay connection terminal portions 24c via connection wiring. The relay pads 27 are electrically connected to some of the multiple electrodes of the IC chip 22 by wire bonding or the like. Consequently, the contact terminal 29 is electrically connected to the IC chip 22. Accordingly, the IC chip 22 can perform contact communication with a contact external device via the contact terminal 29.

As shown in Fig. 4, the resin seal portion 50 covers the IC chip 22, the relay pads 27, and unshown wires. The resin seal portion 50 is provided on the first surface 21g of the substrate 21. The resin seal portion 50 is formed in a dome shape protruding downward (toward the -Dt side). As viewed in the thickness direction Dt, the resin seal portion 50 has a circular shape centered on the center axis O1. The outer diameter of the resin seal portion 50 is smaller than the inner diameter of the recess 31a of the antenna sheet 31. The lower portion of the resin seal portion 50 is disposed inside the recess 31a. The resin seal portion 50 may be made of, for example, a known epoxy resin, a UV curable resin, or a thermosetting resin. The resin seal portion 50 can protect the IC chip 22 from external force loads or environmental loads, and can also prevent breaking of wires and the like.

In the production processing of the IC module 20 of the present embodiment, the connection coil 23, the connection terminal 24, and the relay pads 27 are formed on the first surface 21g of the substrate 21, and then the IC chip 22 is mounted on the first surface 21g of the substrate 21. In this case, if the IC chip 22 is mounted on the substrate 21 in a state of being located on the connection coil 23, the IC chip 22 may be mounted thereon in a state of being tilted with respect to the first surface 21g of the substrate 21. Therefore, there is a risk that the fixing strength between the substrate 21 and the IC chip 22 may not be sufficiently ensured. Accordingly, the IC chip 22 is required to be mounted on the substrate 21 with a predetermined distance apart from the connection coil 23. Considering the mounting tolerance or the like of the IC chip 22 with respect to the substrate 21, the distance between the IC chip 22 and the connection coil 23 may be preferably, for example, 200 µm or more.

As described above, the first innermost turn portion 23i of the connection coil 23 is located on the second side (-D2 side) in the second direction D2 relative to the second innermost turn portion 23j. Therefore, as shown in Fig. 6, the first distance L1, which is the distance between the first innermost turn portion 23i and the IC chip 22, is smaller than the second distance L2, which is the distance between the second innermost turn portion 23j and the IC chip 22. Therefore, increase of the first distance L1 leads to increase of the distance between the IC chip 22 and the connection coil 23. As described above, as viewed in the thickness direction Dt, the turn portions of the connection coil 23 constituting the bypass portion 23b are formed into a substantially arc shape centered on the outermost connection terminal portion 24a and protrude toward the inner peripheral side (Di side). Accordingly, by increasing the distance between the IC chip 22 and the outermost connection terminal portion 24a, the first distance L1 can be increased. In other words, by increasing the distance between the IC chip 22 and the outermost connection terminal portion 24a, the distance between the IC chip 22 and the connection coil 23 can be increased.

### [Adhesive layer 40]

As shown in Fig. 4, the adhesive layer 40 is disposed between the card substrate 15 and the antenna substrate 30 in the thickness direction Dt. The adhesive layer 40 adheres the card substrate 15 to the antenna substrate 30. The adhesive layer 40 is an insulator formed by applying an adhesive to the front surface 31f of the antenna sheet 31 or by laminating an adhesive sheet thereon. Examples of the material forming the adhesive layer 40 include polyvinyl acetate resins, ethylene-vinyl acetate copolymer resins, vinyl chloride-vinyl acetate copolymer resins, acrylic resins, polyester resins, polyamide resins, polyurethane resins, and nitrocellulose. The adhesive layer 40 includes an adhesive layer opening 41 penetrating the adhesive layer 40 . As viewed in the thickness direction Dt, the adhesive layer opening 41 has the same shape and size as those of the opening 15a of the card substrate 15.

The IC card 10 is formed by integrating the antenna substrate 30, the card substrate 15 and adhesive layer 40 laminated on the antenna substrate 30, and the IC module 20 fitted to the opening 15a of the card substrate 15, using sandwich lamination, adhesion, etc. under heat and pressure, and then punching the integrated body into the shape of a card.

According to the present embodiment, the IC module 20 includes the rectangular substrate 21 whose long sides extend in the first direction D1, the connection coil 23 formed into a spiral shape on the first surface 21g of the substrate 21, the outermost connection terminal portion 24a formed at the outermost end 23m of the connection coil 23, and the IC chip 22 provided on a portion of the first surface 21g on the inner peripheral side (Di side) relative to the connection coil 23, and as viewed in the second direction D2, the outermost connection terminal portion 24a is disposed on the first side (+D1 side) in the first direction D1 relative to the IC chip 22. Therefore, compared to the IC module in which the outermost connection terminal portion 24a is disposed overlapping with the IC chip 22 as viewed in the second direction D2, the distance between the IC chip 22 and the outermost connection terminal portion 24a can be increased. Therefore, as described above, the first distance L1, which is the distance between the first innermost turn portion 23i and the IC chip 22, can be increased. Thus, the number of turns of the connection coil 23 can be increased, thereby increasing the impedance of the connection coil 23, while increasing the distance between the connection coil 23 and the IC chip 22. Accordingly, in the IC module 20, which uses the downsized substrate 21 with the introduction of the contact terminal 29 having six terminal portions and the small-capacitance IC chip 22, a connection coil 23 having an impedance matching the impedance of the IC chip 22 can be formed.

According to the present embodiment, the width of the connection coil 23 is greater than the interval between adjacent portions of the connection coil 23 in the radial direction. Therefore, electrical resistance of the connection coil 23 can be reduced compared to the case where the width of the connection coil 23 is smaller than the interval between adjacent portions of the connection coil 23 in the radial direction. Therefore, since resistance loss of the current passing through the connection coil 23 can be suppressed, a larger current can be passed through the connection coil 23. Accordingly, electromagnetic coupling can be enhanced between the connection coil 23 and the booster antenna 32 of the antenna substrate 30, thereby improving the communication performance of the IC card 10 as a contactless communication medium.

In the present embodiment, since the width of the connection coil 23 is greater than the interval between adjacent portions of the connection coil 23 in the radial direction, breaking of the connection coil 23 can be easily suppressed. Accordingly, reliability of the IC card 10 as a contactless communication medium can be enhanced.

According to the present embodiment, the input capacitance between the RF terminals of the IC chip 22 is less than 60 pF, the contact terminal 29 is constituted of multiple terminal portions, and the number of terminal portions constituting the contact terminal 29 or the number of terminal portions therein is six or less. Therefore, in IC modules 20 which have become increasingly popular in recent years, provided with both the IC chip 22 having an input capacitance of less than 60 pF between the RF terminals and the contact terminal 29 having six terminal portions, the impedance of the connection coil 23 can be increased by increasing the number of turns of the connection coil 23. Accordingly, electromagnetic coupling can be enhanced between the connection coil 23 and the booster antenna 32, and thus the communication performance of the IC card 10 as a contactless communication medium can be improved.

### <Second Embodiment>

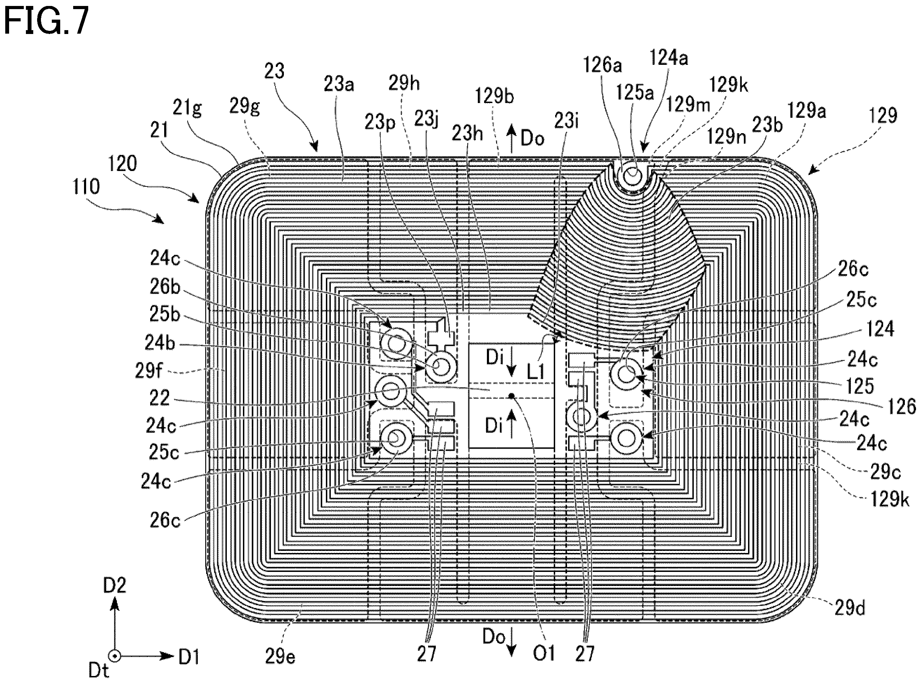

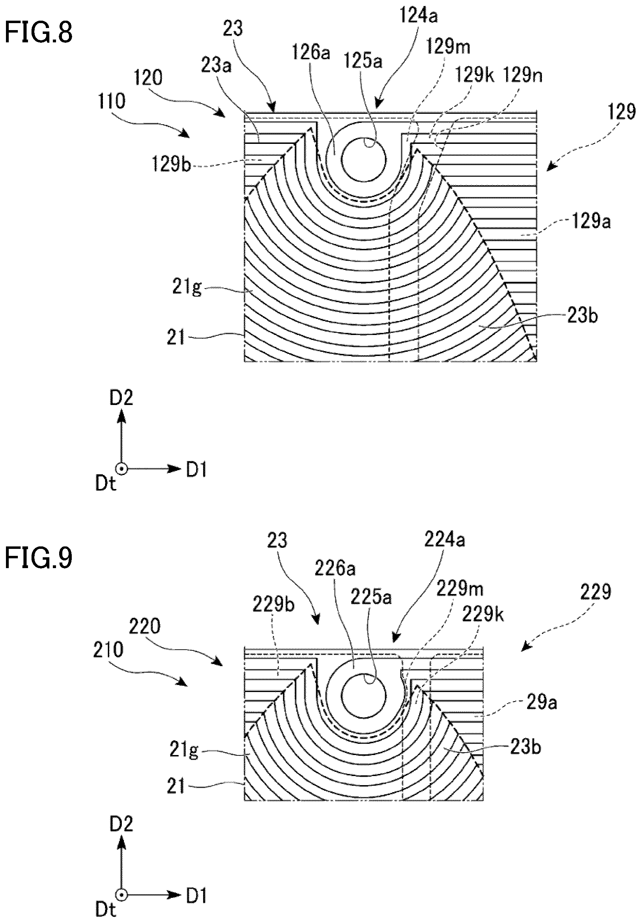

Next, referring to Figs. 7 and 8, a second embodiment of the present invention will be described. In the following description, the same components as those in the first embodiment described above are denoted by the same reference signs to omit repeated explanation. The following description will be focused on differences from the first embodiment.

Fig. 7 is a transparent view illustrating an IC module 120 of an IC card 110 according to the second embodiment as seen from above (+Dt side). Fig. 8 is an enlarged transparent view illustrating the IC module 120 of the IC card 110 as seen from above, according to the second embodiment.

As shown in Fig. 8, a first contact terminal portion 129a of a contact terminal 129 of the present embodiment has a slope 129n. The slope 129n is a part of an edge surface of the first contact terminal portion 129a on the second side (-D1 side) in the first direction D1. The slope 129n faces an outermost connection terminal portion 124a in the first direction D1. As viewed in the thickness direction Dt, the slope 129n is positioned closer to the first side (+D1 side) in the first direction D1 as it approaches the first side (+D2 side) in the second direction D2.

In the present embodiment, a second contact terminal portion 129b has a protrusion 129m protruding toward the slope 129n. That is, the second contact terminal portion 129b has the protrusion 129m protruding toward the first side (+D1 side) in the first direction D1. As viewed in the thickness direction Dt, an edge surface of the protrusion 129m on the first side in the first direction D1 is positioned on the first side in the first direction D1 as it approaches the first side (+D2 side) in the second direction D2. The protrusion 129m and the slope 129n face each other in the first direction D1 with a slit 129k interposed therebetween.

As viewed in the thickness direction Dt, a part of the outermost connection terminal portion 124a of the connection terminal 124 overlaps with the protrusion 129m. More specifically, in the present embodiment, as viewed in the thickness direction Dt, a portion of an outermost land portion 126a of a land 126 on the first side (+D1 side) in the first direction D1 overlaps with the protrusion 129m. As viewed in the thickness direction Dt, the entire outermost land portion 126a may overlap with the protrusion 129m. In the present embodiment, as viewed in the thickness direction Dt, a part of the outer edge of the outermost land portion 126a overlaps with the edge surface of the protrusion 129m on the first side in the first direction D1. Consequently, an outermost through-hole portion 125a of a through-hole 125 and the outermost land portion 126a are disposed on the first side in the first direction D1 relative to the outermost through-hole portion 25a and the outermost land portion 26a, respectively, of the first embodiment described above. Accordingly, the outermost connection terminal portion 124a of the present embodiment is disposed on the first side in the first direction D1 relative to the outermost connection terminal portion 24a of the first embodiment described above. As viewed in the thickness direction Dt, the outermost land portion 126a may be disposed on the second side (-D1 side) in the first direction D1 relative to the edge surface of the protrusion 129m on the first side in the first direction D1.

According to the present embodiment, the second contact terminal portion 129b has the protrusion 129m protruding toward the first side (+D1 side) in the first direction D1, and as viewed in the thickness direction Dt, at least a part of the outermost connection terminal portion 124a overlaps with the protrusion 129m. Therefore, as described above, the outermost connection terminal portion 124a can be disposed closer to the first side in the first direction D1, and thus the first distance L1, which is the distance between the first innermost turn portion 23i and the IC chip 22, can be increased even more. Therefore, the number of turns of the connection coil 23 can be increased to increase the impedance of the connection coil 23, while also increasing even more the distance between the connection coil 23 and the IC chip 22. Accordingly, in the IC module 120, which uses the downsized substrate 21 with the introduction of the contact terminal 29 having six terminal portions and the small-capacitance IC chip 22, a connection coil 23 having an impedance matching the impedance of the IC chip 22 can be formed more easily.

### <Modifications of second embodiment>

Next, referring to Fig. 9, modifications of the second embodiment of the present invention will be described. In the following description, the same components as those in the first embodiment described above are denoted by the same reference signs to omit repeated explanation. The following description will be focused on differences from the first embodiment.

Fig. 9 is an enlarged transparent view illustrating an IC module 220 of an IC card 210 according to a modification of the second embodiment as seen from above (+Dt side).

A second contact terminal portion 229b of a contact terminal 229 of the present modification has a protrusion 229m protruding toward the first contact terminal portion 29a. That is, the second contact terminal portion 229b has the protrusion 229m protruding to the first side (+D1 side) in the first direction D1. As viewed in the thickness direction Dt, an edge surface of the protrusion 229m on the first side in the first direction D1 is formed into a substantially arc shape conforming to the outer edge of an outermost land portion 226a. The protrusion 229m and the first contact terminal portion 29a face each other in the first direction D1 via a slit 229k. The distance between the protrusion 229m and the first contact terminal portion 29a is greater than the distance allowing insulation between the protrusion 229m and the first contact terminal portion 29a.

As viewed in the thickness direction Dt, a part of an outermost connection terminal portion 224a overlaps with the protrusion 229m. More specifically, in the present modification, as viewed in the thickness direction Dt, a portion of the outermost land portion 226a on the first side (+D1 side) in the first direction D1 overlaps with the protrusion 229m. In the present embodiment, as viewed in the thickness direction Dt, a part of the outer edge of the outermost land portion 226a overlaps with the edge surface of the protrusion 229m. Consequently, an outermost through-hole portion 225a and the outermost land portion 226a are disposed on the first side in the first direction D1 relative to the outermost through-hole portion 25a and the outermost land portion 26a, respectively, of the first embodiment described above. Accordingly, the outermost connection terminal portion 224a of the present embodiment is disposed on the first side in the first direction D1 relative to the outermost connection terminal portion 24a of the first embodiment described above. As viewed in the thickness direction Dt, the outermost land portion 226a may be disposed on the second side (-D1 side) in the first direction D1 relative to the edge surface of the protrusion 229m on the first side in the first direction D1, as long as at least a part of the outermost land portion 226a overlaps with the protrusion 229m.

According to the present modification, the second contact terminal portion 229b has the protrusion 229m protruding toward the first side (+D1 side) in the first direction D1, and as viewed in the thickness direction Dt, at least a part of the outermost connection terminal portion 224a overlaps with the protrusion 229m. Therefore, similarly to the second embodiment described above, the outermost connection terminal portion 224a can be disposed closer to the first side in the first direction D1, and thus the first distance L1, which is the distance between the first innermost turn portion 23i and the IC chip 22, can be increased even more. Therefore, the number of turns of the connection coil 23 can be increased to increase the impedance of the connection coil 23, while also increasing even more the distance between the connection coil 23 and the IC chip 22.

### <Third Embodiment>

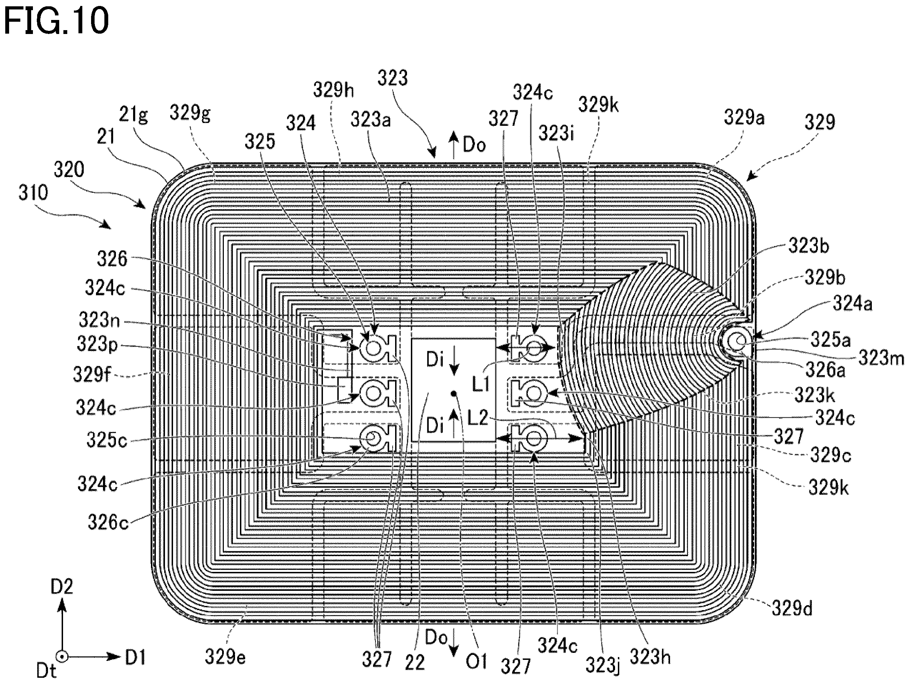

Next, referring to Fig. 10, a third embodiment of the present invention will be described. In the following description, the same components as those in the first embodiment described above are denoted by the same reference signs to omit repeated explanation. The following description will be focused on differences from the first embodiment.

Fig. 10 is a transparent view illustrating an IC module 320 of an IC card 310 according to the third embodiment as seen from above (+Dt side). The IC module 320 includes the substrate 21 , the IC chip 22, a connection coil 323, a connection terminal 324, relay pads 327, and a contact terminal 329.

A first contact terminal portion 329a of the contact terminal 329 is a GND terminal portion. The first contact terminal portion 329a is disposed at a portion of the substrate 21 on the first side (+D1 side) in the first direction D1 and on the first side (+D2 side) in the second direction D2. The first contact terminal portion 329a is disposed on the first side in the first direction D1 and on the first side in the second direction D2 relative to the IC chip 22.

A second contact terminal portion 329b is a terminal portion which is not defined in card standards such as ISO/IEC 7816 and is not used for contact communication. That is, the second contact terminal portion 329b is a terminal portion that is not used when the IC chip 22 and a contact external device perform contact communication. The second contact terminal portion 329b is located on the second side (-D2 side) in the second direction D2 relative to the first contact terminal portion 329a. The second contact terminal portion 329b is disposed adjacent to the first contact terminal portion 329a in the second direction D2. The second contact terminal portion 329b is disposed on the first side (+D1 side) in the first direction D1 of the IC chip 22.

A third contact terminal portion 329c is a VPP terminal portion. The third contact terminal portion 329c is located on the second side (-D2 side) in the second direction D2 relative to the second contact terminal portion 329b. The third contact terminal portion 329c is disposed adjacent to the second contact terminal portion 329b in the second direction D2. In the present embodiment, the third contact terminal portion 329c is a terminal portion that is not used during contact communication. The third contact terminal portion 329c may be used during contact communication.

A fourth contact terminal portion 329d is an I/O terminal portion. The fourth contact terminal portion 329d is located on the second side (-D2 side) in the second direction D2 relative to the third contact terminal portion 329c. The fourth contact terminal portion 329d is disposed adjacent to the third contact terminal portion 329c in the second direction D2.

A fifth contact terminal portion 329e is a CLK terminal portion. The fifth contact terminal portion 329e is disposed at a portion of the substrate 21 on the second side (-D1 side) in the first direction D1 and on the second side (-D2 side) in the second direction D2.

A sixth contact terminal portion 329f is an RST (reset) terminal portion. The sixth contact terminal portion 329f is located on the first side (+D2 side) in the second direction D2 relative to the fifth contact terminal portion 329e. The sixth contact terminal portion 329f is disposed adjacent to the fifth contact terminal portion 329e in the second direction D2.

A seventh contact terminal portion 329g is a VCC terminal portion. The seventh contact terminal portion 329g is located on the first side (+D2 side) in the second direction D2 relative to the sixth contact terminal portion 329f. The seventh contact terminal portion 329g is disposed adjacent to the sixth contact terminal portion 329f in the second direction D2.

An eighth contact terminal portion 329h is a terminal portion which is not defined in card standards such as ISO/IEC 7816 and is not used for contact communication. The eighth contact terminal portion 329h is disposed at the center of the substrate 21 in the first direction D1. The eighth contact terminal portion 329h is formed starting from an edge portion of the substrate 21 on the first side (+D2 side) in the second direction D2 to an edge portion thereof on the second side (-D2 side) in the second direction D2. Slits 329k are formed between the terminal portions. The terminal portions are insulated from each other by the slits 329k.

A rectangular portion 323a is a portion of the connection coil 323 located outside a bypass area 323k shown in Fig. 10. A bypass portion 323b is a portion of the connection coil 323 bypassing an outermost connection terminal portion 324a (described later) of the connection terminal 324. The bypass portion 323b is a portion of the connection coil 323 located inside the bypass area 323k. The bypass portion 323b bypasses the outermost connection terminal portion 324a on the second side (-D1 side) in the first direction D1. As viewed in the thickness direction Dt, the turn portions of the connection coil 323 constituting the bypass portion 323b are formed into a substantially arc shape centered on the outermost connection terminal portion 324a and protrude toward the inner peripheral side (Di side).

A first innermost turn portion 323i is a portion of an innermost turn portion 323h constituting the bypass portion 323b. A second innermost turn portion 323j is a portion of the innermost turn portion 323h constituting the rectangular portion 323a, that is, a portion located on the first side (+D1 side) in the first direction D1 relative to the IC chip 22. The first distance L1, which is the distance between the first innermost turn portion 323i and the IC chip 22, is smaller than the second distance L2, which is the distance between the second innermost turn portion 323j and the IC chip 22. That is, due to the bypass portion 323b bypassing the outermost connection terminal portion 324a on the second side (-D1 side) in the first direction D1, the distance between the connection coil 323 and the IC chip 22 is reduced. The first distance L1 of the present embodiment is greater than the first distance L1 according to the first embodiment shown in Fig. 6. That is, the distance between the first innermost turn portion 323i and the IC chip 22 in the IC module 320 of the present embodiment is greater than the distance between the first innermost turn portion 23i and the IC chip 22 in the IC module 20 of the first embodiment.

A connection pad 323p is connected to an innermost end 323n of the connection coil 323. The connection pad 323p is electrically connected to some of the multiple electrodes of the IC chip 22 by wire bonding or the like. Consequently, the connection coil 323 is electrically connected to the IC chip 22.

The connection terminal 324 includes the outermost connection terminal portion 324a, and multiple relay connection terminal portions 324c. A through-hole 325 includes an outermost through-hole portion 325a, and multiple relay through-hole portions 325c. A land 326 includes an outermost land portion 326a, and multiple relay land portions 326c.

The outermost connection terminal portion 324a is formed at an outermost end 323m of the connection coil 323. In the present embodiment, the outermost connection terminal portion 324a is disposed at an edge portion of the substrate 21 on the first side (+D1 side) in the first direction D1. As viewed in the second direction D2, the outermost connection terminal portion 324a is disposed on the first side in the first direction D1 relative to the IC chip 22. As viewed in the thickness direction Dt, the outermost connection terminal portion 324a overlaps with an edge portion of the second contact terminal portion 329b on the first side in the first direction D1. The outermost connection terminal portion 324a includes the outermost through-hole portion 325a and the outermost land portion 326a. The outermost through-hole portion 325a penetrates the substrate 21 in the thickness direction Dt. The outermost land portion 326a has an annular shape surrounding the outermost through-hole portion 325a. The outermost connection terminal portion 324a electrically connects the connection coil 323 to the second contact terminal portion 329b.

The multiple relay connection terminal portions 324c are connected to the contact terminal 329. In the present embodiment, the connection terminal 324 includes six relay connection terminal portions 324c. The relay connection terminal portions 324c are disposed on the inner peripheral side (Di side) relative to the connection coil 323. The relay connection terminal portions 324c include respective relay through-hole portions 325c and relay land portions 326c. Three relay connection terminal portions 324c are disposed between the IC chip 22 and the bypass portion 323b.

The multiple relay pads 327 electrically connect the multiple relay connection terminal portions 324c to the IC chip 22. In the present embodiment, six relay pads 327 are formed. The relay pads 327 are disposed on the inner peripheral side (Di side) of the respective relay connection terminal portions 324c. The relay pads 327 are electrically connected to respective different relay connection terminal portions 324c. The relay pads 327 are electrically connected to some of the multiple electrodes of the IC chip 22 by wire bonding or the like. Consequently, the contact terminal 329 is electrically connected to the IC chip 22. Three relay pads 327 are disposed between the IC chip 22 and the bypass portion 323b.

According to the present embodiment, the contact terminal 329 includes the second contact terminal portion 329b disposed on the first side (+D1 side) in the first direction D1 of the IC chip 22, and as viewed in the thickness direction Dt, the outermost connection terminal portion 324a is disposed at an edge portion of the second contact terminal portion 329b on the first side in the first direction D1. Therefore, compared to the configuration in which the outermost connection terminal portion 324a is disposed on an edge portion of the substrate 21 in the second direction D2 in which the short sides of the substrate 21 extend, the distance between the IC chip 22 and the outermost connection terminal portion 324a can be increased. Thus, the first distance L1, which is the distance between the first innermost turn portion 323i and the IC chip 22, can be increased even more. Therefore, the number of turns of the connection coil 323 can be increased to increase the impedance of the connection coil 323, while also increasing even more the distance between the connection coil 323 and the IC chip 22.

Furthermore, in the present embodiment, since the first distance L1, which is the distance between the first innermost turn portion 323i and the IC chip 22, can be increased as described above, three relay connection terminal portions 324c and three relay pads 327, for example, can be disposed between the bypass portion 323b and the IC chip 22. Accordingly, the connection coil 323, the connection terminal 324, the relay pads 327, unshown wires, etc. can be efficiently disposed on the first surface 21g of the substrate 21.

### <Fourth Embodiment>

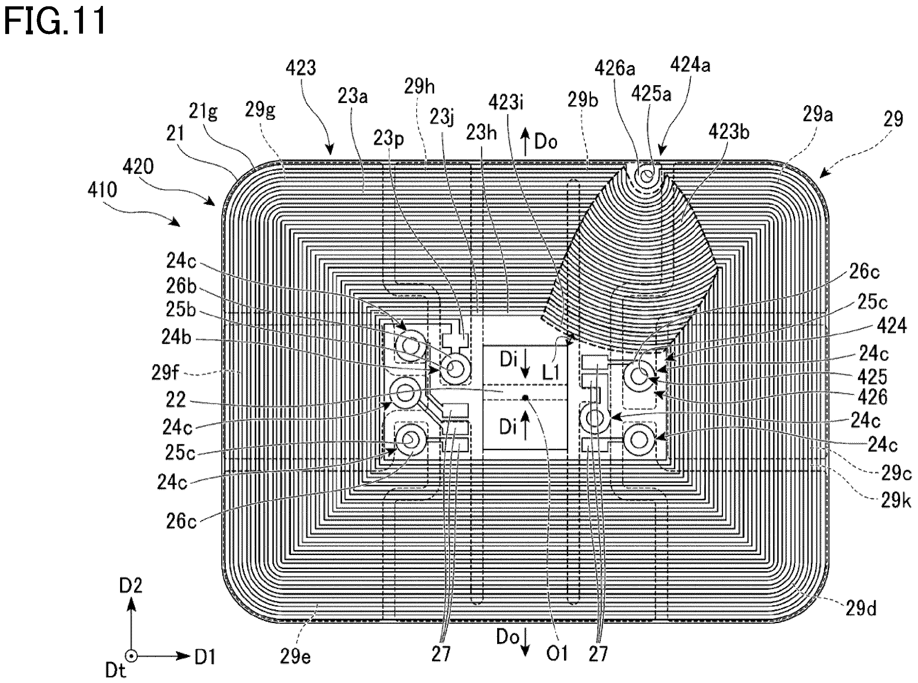

Next, referring to Fig. 11, a fourth embodiment of the present invention will be described. In the following description, the same components as those in the first embodiment described above are denoted by the same reference signs to omit repeated explanation. The following description will be focused on differences from the first embodiment.

Fig. 11 is a transparent view illustrating an IC module 420 of an IC card 410 according to the fourth embodiment as seen from above (+Dt side).

Of portions of a through-hole 425 of the present embodiment, an outermost through-hole portion 425a has an inner diameter smaller than the inner diameters of the innermost through-hole portion 25b and the multiple relay through-hole portions 25c. In other words, the inner diameter of the outermost through-hole portion 425a is smaller than the inner diameters of other through-hole portions 25b and 25c. In the present embodiment, the inner diameter of the outermost through-hole portion 425a may be, for example, about 100 µm, and the inner diameters of other through-hole portions 25b and 25c may be, for example, about 150 µm.

Of portions of a land 426 of the present embodiment, an outermost land portion 426a has an outer diameter smaller than the outer diameters of the innermost land portion 26b and the multiple relay land portions 26c. In other words, the outer diameter of the outermost land portion 426a is smaller than the outer diameters of other land portions 26b and 26c. In the present embodiment, the outer diameter of the outermost land portion 426a may be, for example, about 250 µm, and the outer diameters of other land portions 26b and 26c may be, for example, about 300 µm. Accordingly, the outer diameter of an outermost connection terminal portion 424a of a connection terminal 424 of the present embodiment is smaller than the outer diameters of other connection terminal portions 24b and 24c.

As described above, turn portions of a connection coil 423 constituting a bypass portion 423b are formed into a substantially arc shape centered on the outermost connection terminal portion 424a and protrude toward the inner peripheral side (Di side). Also, as described above, the outer diameter of the outermost connection terminal portion 424a of the present embodiment is smaller than the outer diameters of other connection terminal portions 24b and 24c. Accordingly, in the present embodiment, the curvature radius of the turn portions of the connection coil 423 constituting the bypass portion 423b can be reduced.

According to the present embodiment, the substrate 21 is provided with multiple portions of the through-hole 425 including the outermost through-hole portion 425a, which penetrate the substrate 21 in the thickness direction Dt, and the inner diameter of the outermost through-hole portion 425a is smaller than the inner diameters of other through-hole portions 25b and 25c. Accordingly, as described above, the outer diameter of the outermost land portion 426a can be reduced. Thus, the turn portions of the connection coil 423 constituting the bypass portion 423b can have a smaller curvature radius, compared to the case where the inner diameter of the outermost through-hole portion 425a is equal to the inner diameters of other through-hole portions 25b and 25c. Therefore, since a first innermost turn portion 423i of the connection coil 423 can be disposed on the first side (+D2 side) in the second direction D2, the first distance L1 can be increased. Accordingly, the number of turns of the connection coil 423 can be increased to increase the impedance of the connection coil 423, while also increasing even more the distance between the connection coil 423 and the IC chip 22.

In general, as the inner diameter of the through-hole 425 becomes smaller, the physical strength of the through-hole 425 tends to decrease. In contrast, in the present embodiment, of the multiple portions of the through-hole 425, only the outermost through-hole portion 425a has a small inner diameter. Therefore, among the multiple portions of the through-hole 425, only the outermost through-hole portion 425a is likely to have a reduced physical strength. Therefore, in the IC module 420 of the present embodiment, the number of turns of the connection coil 423 can be increased to increase the impedance of the connection coil 423, while preventing a significant decrease in reliability of the current path of the IC module 20.

### <Fifth Embodiment>

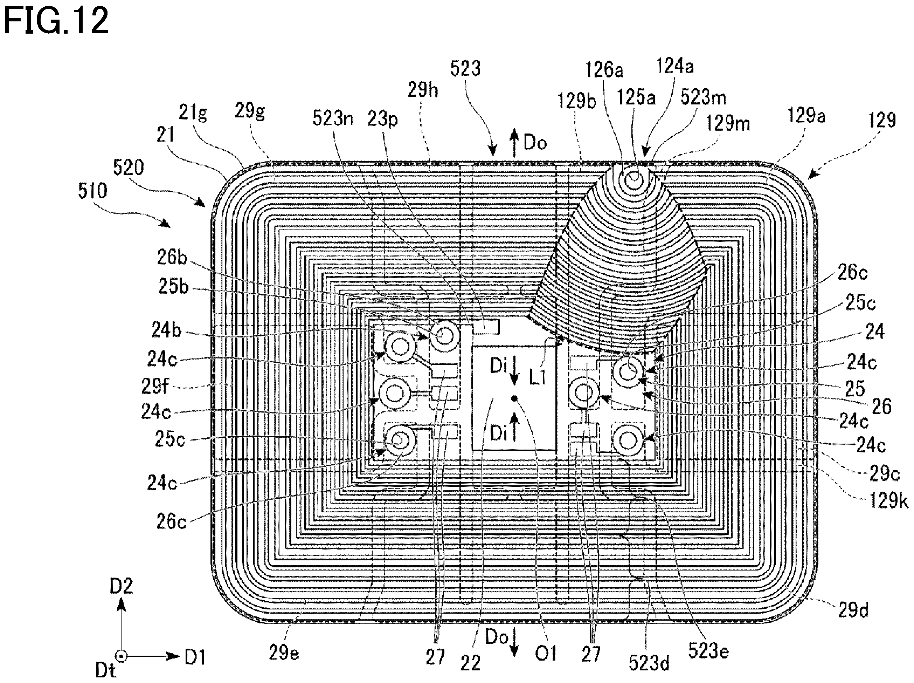

Next, referring to Fig. 12, a fifth embodiment of the present invention will be described. In the following description, the components common to those in the second embodiment described above are denoted by the same reference signs to omit repeated explanation. The following description will be focused on differences from the second embodiment.

Fig. 12 is a transparent view illustrating an IC module 520 of an IC card 510 according to the fifth embodiment as seen from above (+Dt side).

A connection coil 523 of the present embodiment includes a first coil portion 523d and a second coil portion 523e. The first coil portion 523d is a portion of the connection coil 523 on the outer peripheral side (Do side). The first coil portion 523d has an outermost end 523m corresponding to the outermost end of the connection coil 523. The outermost end 523m of the first coil portion 523d is provided with the outermost connection terminal portion 124a. The second coil portion 523e is a portion of the connection coil 523 on the inner peripheral side (Di side). The second coil portion 523e is disposed on the inner peripheral side relative to the first coil portion 523d. The second coil portion 523e is connected to the first coil portion 523d. The second coil portion 523e has an innermost end 523n corresponding to the innermost end of the connection coil 523. The innermost end 523n of the second coil portion 523e is provided with the connection pad 23p. In a portion near the innermost end 523n of the second coil portion 523e, the innermost connection terminal portion 24b is formed. In the present embodiment, the number of turns of each of the first and second coil portions 523d and 523e is 9. The number of turns of each of the first and second coil portions 523d and 523e may be 8 or less or may be 10 or more.

In the present embodiment, the width of the coil wire forming the first coil portion 523d is greater than the width of the coil wire constituting the second coil portion 523e. In other words, the coil width in the first coil portion 523d is greater than the coil width in the second coil portion 523e.

According to the present embodiment, the connection coil 523 includes the first coil portion 523d provided with the outermost connection terminal portion 124a formed at the outermost end 523m, and the second coil portion 523e disposed on the inner peripheral side (Di side) relative to the first coil portion 523d, and the coil width in the first coil portion 523d is greater than the coil width in the second coil portion 523e. Therefore, the cross-sectional area of the coil wire constituting the first coil portion 523d can be increased even more than the cross-sectional area of the coil wire constituting the second coil portion 523e, and therefore the electrical resistance per unit length of the coil wire constituting the first coil portion 523d is smaller than the electrical resistance per unit length of the coil wire constituting the second coil portion 523e. Furthermore, since the first coil portion 523d of the connection coil 523 is on the outer peripheral side (Do side) relative to the second coil portion 523e thereof, the length of the coil wire constituting the turn portions of the first coil portion 523d is larger than the length of the coil wire constituting the turn portions of the second coil portion 523e. Therefore, compared to the configuration in which the coil width in the first coil portion 523d is smaller than the coil width in the second coil portion 523e, increase in electrical resistance of the entire connection coil 523 can be suppressed in the present embodiment. Therefore, since resistance loss of the current passing through the connection coil 523 can be suppressed, an even larger current can be passed through the connection coil 523. Accordingly, electromagnetic coupling can be enhanced between the connection coil 523 and the booster antenna 32 of the antenna substrate 30, thereby improving the communication performance of the IC card 510 as a contactless communication medium.

The width of the connection coil 523 is not limited to the width according to the present embodiment described above. For example, the width of the connection coil 523 may be increased from the inner peripheral side (Di side) toward the outer peripheral side (Do side). With this configuration also, increase in electrical resistance of the entire connection coil 523 can be suppressed. Accordingly, since resistance loss of the current passing through the connection coil 523 can be suppressed, an even larger current can be passed through the connection coil 523.

### <Sixth Embodiment>

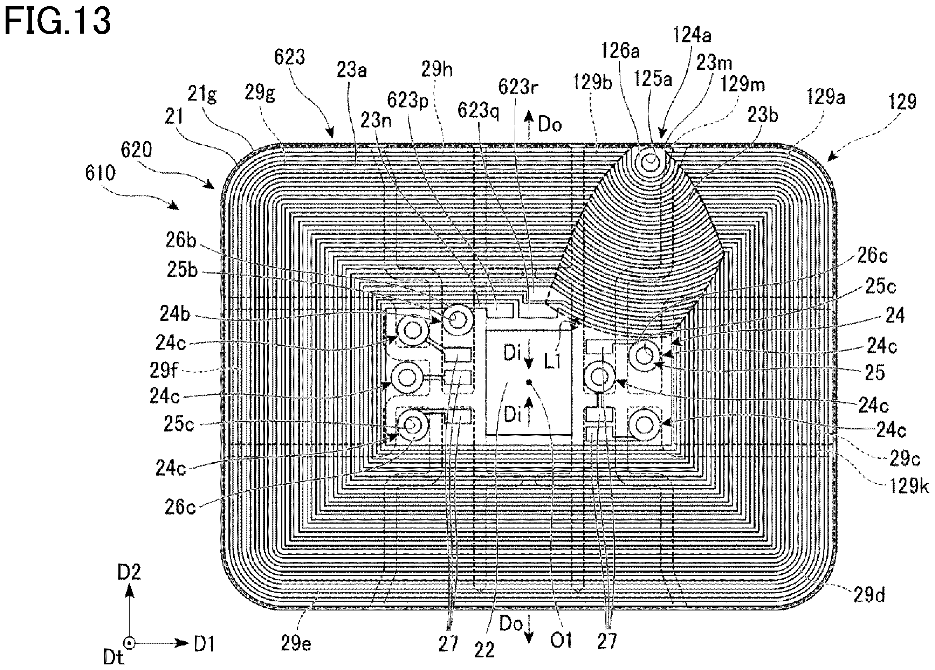

Next, referring to Fig. 13, a sixth embodiment of the present invention will be described. In the following description, the components common to those in the second embodiment described above are denoted by the same reference signs to omit repeated explanation. The following description will be focused on differences from the second embodiment.

Fig. 13 is a transparent view illustrating an IC module 620 of an IC card 610 according to the sixth embodiment as seen from above (+Dt side).

A connection coil 623 of the present embodiment includes the rectangular portion 23a, the bypass portion 23b, and multiple connection pads 623p, 623q and 623r. Similarly to the bypass portion 23b of the second embodiment described above, the bypass portion 23b of the present embodiment bypasses the outermost connection terminal portion 124a on the second side (-D2 side) in the second direction D2 which is disposed on an edge portion of the substrate 21 on the first side (+D2 side) in the second direction D2.

The multiple connection pads 623p, 623q and 623r are respectively formed on different turn portions of the connection coil 623. More specifically, the connection pad 623p is formed at the innermost end 23n of the connection coil 623. In other words, the connection pad 623p is formed on a turn portion on the most inner peripheral side (Di side) of the connection coil 623. The connection pad 623p is disposed on the second side (-D1 side) in the first direction D1 relative to the bypass portion 23b. The connection pad 623q is formed on a second turn portion from the inner peripheral side of the connection coil 623. In the first direction D1, the connection pad 623q is disposed between the connection pad 623p and the bypass portion 23b. The connection pad 623r is formed on the third turn portion from the inner peripheral side of the connection coil 623. The connection pad 623r is disposed on the first side (+D2 side) in the second direction D2 relative to the connection pad 623q. The connection pads 623p, 623q and 623r are formed into a substantially rectangular shape with a width greater than that of the coil wire. The connection pads 623p, 623q and 623r are formed on the first side (+D2 side) in the second direction D2 of the IC chip 22. As viewed in the first direction D1, at least a part of the multiple connection pads 623p, 623q and 623r overlaps with the bypass portion 23b. Any one of the multiple connection pads 623p, 623q and 623r is electrically connected to some of the multiple electrodes of the IC chip 22 by wire bonding. Consequently, the connection coil 623 is electrically connected to the IC chip 22.

According to the present embodiment, the connection coil 623 includes the bypass portion 23b that bypasses the outermost connection terminal portion 124a on the second side (-D2 side) in the second direction D2, and the multiple connection pads 623p, 623q and 623r formed on different turn portions of the connection coil 623, and as viewed in the first direction D1, at least a part of the multiple connection pads 623p, 623q and 623r overlaps with the bypass portion 23b. Therefore, by appropriately selecting a connection pad to be connected to the IC chip 22 from the connection pads 623p, 623q and 623r, effective impedance between the outermost end 23m of the connection coil 623 and the IC chip 22 can be adjusted. As viewed in the first direction D1, the connection pads 623p, 623q and 623r can be disposed so as to overlap with the bypass portion 23b, thereby preventing the connection coil 623 including the connection pads 623p, 623q and 623r from becoming larger in the second direction D2. Therefore, the distance between the connection coil 623 and the IC chip 22 can be easily increased.

### <Seventh Embodiment>

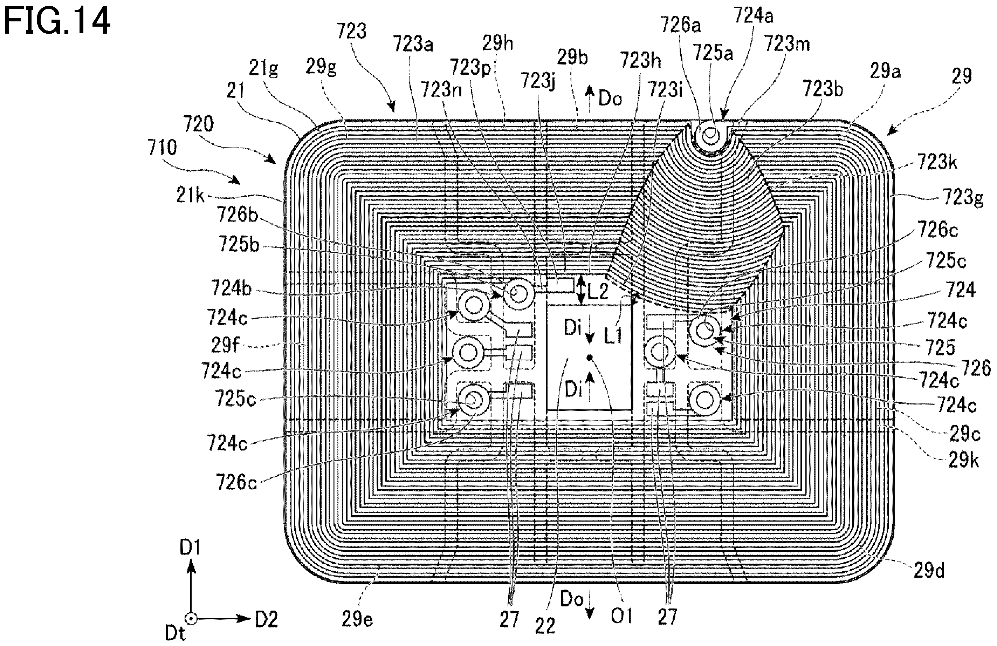

Next, referring to Figs. 14 to 16, a seventh embodiment of the present invention will be described. In the following description, the same components as those in the first embodiment described above are denoted by the same reference signs to omit repeated explanation. The following description will be focused on differences from the first embodiment.

In the present embodiment, the first direction D1 is the direction in which the short sides of the rectangular substrate extend and perpendicular to the thickness direction Dt. In the following description, the side toward which the arrow of the first direction D1 points (+D1 side) is referred to as first side in the first direction D1. The side opposite to the side toward which the arrow of the first direction D1 points (-D1 side) is referred to as second side in the first direction D1.

In the present embodiment, the second direction D2 is the direction in which the long sides of the rectangular substrate extend and perpendicular to the first direction D1 and the thickness direction Dt. In the following description, the side toward which the arrow of the second direction D2 points (+D2 side) is referred to as first side in the second direction D2. The side opposite to the side toward which the arrow of the second direction D2 points (-D2 side) is referred to as second side in the second direction D2.

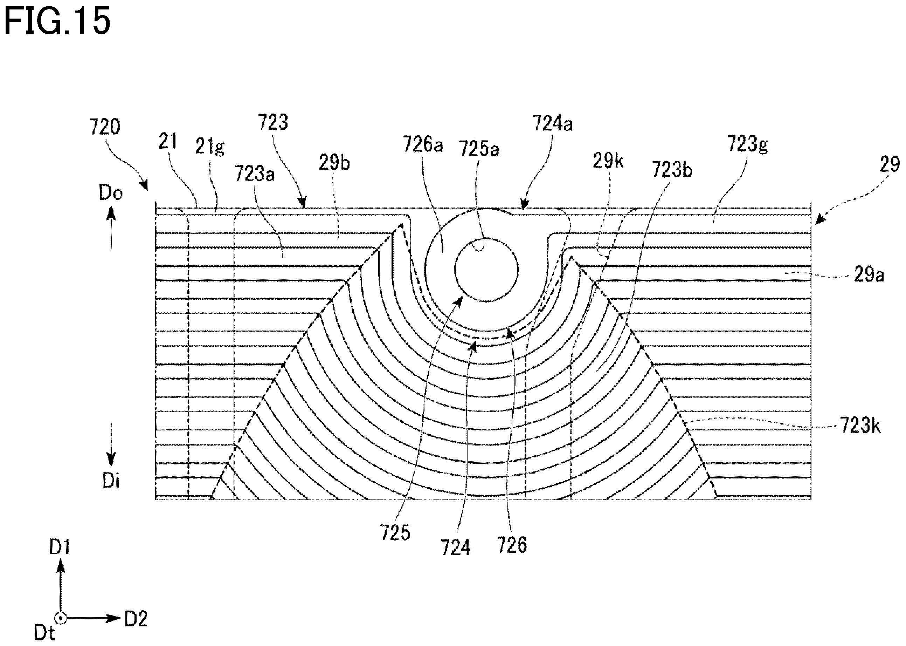

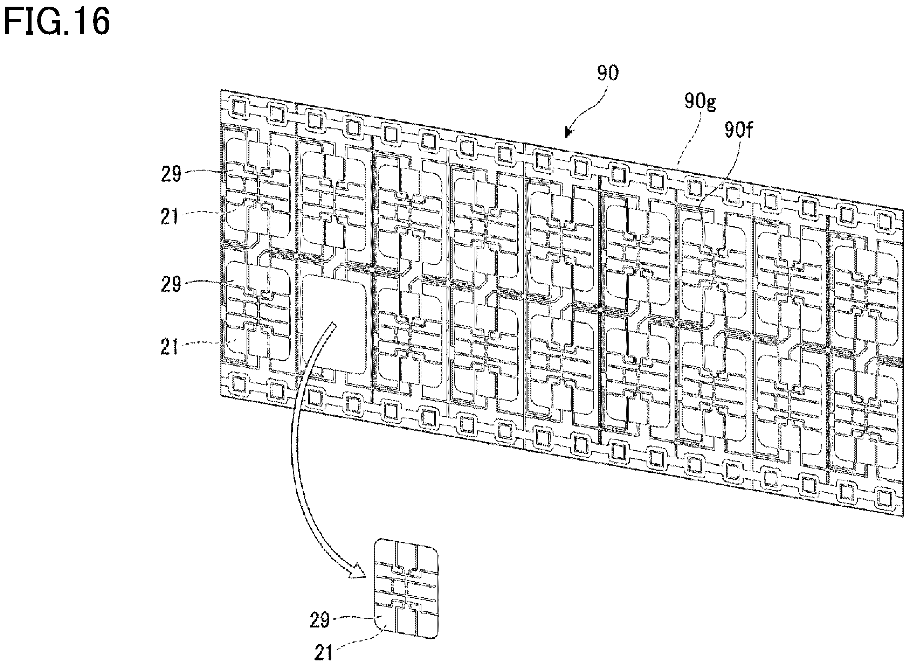

Fig. 14 is a transparent view illustrating an IC module 720 of an IC card 710 as seen from above, according to the present embodiment. Fig. 15 is an enlarged transparent view illustrating the IC module 720 of the IC card 710 as seen from above. Fig. 16 is a perspective view illustrating a process of dicing to obtain IC modules 720 for IC cards 710.

As shown in Fig. 14, the IC module 720 includes the substrate 21 , the IC chip 22, a connection coil 723, a connection terminal 724, the relay pads 27, the contact terminal 29, and the resin seal portion 50 (see Fig. 4). The IC module 720 has a rectangular shape with the short sides extending in the first direction D1. The long-side dimension of the IC module 720 is about 10.6 mm, and the short-side dimension of the IC module 720 is about 8.0 mm.

In the present embodiment, as viewed in the thickness direction Dt, the edge surfaces of the terminal portions of the contact terminal 29 facing radially outward overlap with the edge surface 21k of the substrate 21. That is, as viewed in the thickness direction Dt, the outer edge of the contact terminal 29 overlaps with the edge surface 21k of the substrate 21. As viewed in the thickness direction Dt, the outer edge of the contact terminal 29 may be located on the inner peripheral side (Di side) relative to the edge surface 21k of the substrate 21. The edge surface 21k of the substrate 21 is a surface facing radially outward in the outer surface of the substrate 21. As viewed in the thickness direction Dt, the edge surface 21k of the substrate 21 has a substantially rectangular shape.

In the present embodiment, a first contact terminal portion 29a is disposed on the first side in the first direction D1 and on the first side in the second direction D2 relative to the IC chip 22. In the present embodiment, the second contact terminal portion 29b is located on the second side (-D2 side) in the second direction D2 relative to the first contact terminal portion 29a. A portion of the second contact terminal portion 29b on the first side (+D1 side) in the first direction D1 is disposed adjacent to the first contact terminal portion 29a in the second direction D2. In the present embodiment, the third contact terminal portion 29c is located on the second side (-D1 side) in the first direction D1 of the first contact terminal portion 29a. The third contact terminal portion 29c is disposed adjacent to the first contact terminal portion 29a in the first direction D1. In the present embodiment, the fourth contact terminal portion 29d is located on the second side in the first direction D1 of the third contact terminal portion 29c. The fourth contact terminal portion 29d is disposed adjacent to the third contact terminal portion 29c in the first direction D1. In the present embodiment, the fifth contact terminal portion 29e is disposed at a portion of the substrate 21 on the second side in the first direction D1 and on the second side in the second direction D2. In the present embodiment, the sixth contact terminal portion 29f is located on the first side in the first direction D1 of the fifth contact terminal portion 29e. The sixth contact terminal portion 29f is disposed adjacent to the fifth contact terminal portion 29e in the first direction D1. In the present embodiment, the seventh contact terminal portion 29g is located on the first side in the first direction D1 of the sixth contact terminal portion 29f. The seventh contact terminal portion 29g is disposed adjacent to the sixth contact terminal portion 29f in the first direction D1. In the present embodiment, in the second direction D2, the eighth contact terminal portion 29h is located between the seventh contact terminal portion 29g and a portion of the second contact terminal portion 29b on the first side in the first direction D1.

The connection coil 723 is formed on the first surface 21g of the substrate 21. The connection coil 723 is formed of a coil wire wound in a spiral shape. In the present embodiment, the connection coil 723 is formed of a coil wire wound approximately 18 times in a substantially rectangular shape. That is, the number of turns of the connection coil 723 is 18. The connection coil 723 is constituted of 18 turn portions. The turn portions are disposed side by side in the radial direction. Of the turn portions of the connection coil 723, an outermost turn portion 723g disposed on the most outer peripheral side (Do side) is formed into a substantially rectangular shape conforming to the edge surface 21k of the substrate 21. As viewed in the thickness direction Dt, the outermost turn portion 723g is disposed on the inner peripheral side (Di side) relative to the edge surface 21k of the substrate 21 and the outer edge of the contact terminal 29. In other words, as viewed in the thickness direction Dt, the connection coil 723 is disposed on the inner peripheral side relative to the edge surface 21k of the substrate 21 and the outer edge of the contact terminal 29. Of the turn portions of the connection coil 723, an innermost turn portion 723h, which is disposed on the most inner peripheral side (Di side), faces the IC chip 22, the connection terminal 724, and the relay pads 27 in the radial direction.

In the present embodiment, the width of the coil wire is about 80 µm. That is, the width of the connection coil 723 is about 80 µm. In the present embodiment, the interval between adjacent turn portions in the radial direction is about 75 µm. That is, the interval between adjacent portions of the connection coil 723 in the radial direction is about 75 µm. Therefore, the width of the connection coil 723 is greater than the interval between adjacent portions of the connection coil 723 in the radial direction. The width of the connection coil 723 and the interval between adjacent portions of the connection coil 723 in the radial direction are not limited to the dimensions of the present embodiment, but can be determined appropriately depending on the impedance, etc. required for the connection coil 723. The connection coil 723 includes a rectangular portion 723a, a bypass portion 723b, and a connection pad 723p.

The rectangular portion 723a is a portion of the connection coil 723 which is formed into a rectangular shape. A bypass area 723k shown in Fig. 14, which is indicated by a virtual closed curve, is an area where the bypass portion 723b is formed. The rectangular portion 723a is a portion of the connection coil 723 located outside the bypass area 723k. The bypass portion 723b is a portion of the connection coil 723 bypassing an outermost connection terminal portion 724a (described later) of the connection terminal 724. The bypass portion 723b is a portion of the connection coil 723 located inside the bypass area 723k. The bypass portion 723b bypasses the outermost connection terminal portion 724a on the second side (-D1 side) in the first direction D1. As viewed in the thickness direction Dt, the turn portions constituting the bypass portion 723b are formed into a substantially arc shape centered on the outermost connection terminal portion 724a and protrude toward the inner peripheral side (Di side). A first innermost turn portion 723i shown in Fig. 14 is a portion of the innermost turn portion 723h constituting the bypass portion 723b. A second innermost turn portion 723j is a portion of the innermost turn portion 723h constituting the rectangular portion 723a, that is, a portion located on the first side (+D 1 side) in the first direction D1 relative to the IC chip 22. The first innermost turn portion 723i is located on the second side in the first direction D1 relative to the second innermost turn portion 723j. Therefore, the first distance L1, which is the distance between the first innermost turn portion 723i and the IC chip 22, is smaller than the second distance L2, which is the distance between the second innermost turn portion 723j and the IC chip 22. That is, since the bypass portion 723b bypasses the outermost connection terminal portion 724a on the second side in the first direction D1, the distance between the connection coil 723 and the IC chip 22 is reduced.

The connection pad 723p is connected to an innermost end 723n of the connection coil 723. The connection pad 723p is formed into a substantially rectangular shape with a width greater than that of the coil wire. The connection pad 723p is electrically connected to some of the multiple terminals of the IC chip 22 by wire bonding or the like. Consequently, the connection coil 723 is electrically connected to the IC chip 22. Therefore, the IC chip 22 can perform contactless communication with a contactless external device via the connection coil 723 and the booster antenna 32. Other configurations and the like of the connection coil 723 of the present embodiment are similar to those of the connection coil 23 of the first embodiment described above.

The connection terminal 724 electrically connects the contact terminal 29 to the connection coil 723 and the relay pads 27. The connection terminal 724 has a through-hole 725 and a land 726. The connection terminal 724 includes the outermost connection terminal portion 724a, an innermost connection terminal portion 724b, and multiple relay connection terminal portions 724c. The through-hole 725 penetrates the substrate 21 in the thickness direction Dt and has an inner peripheral surface provided with an unshown conductor formed of a copper foil layer. In the present embodiment, the through-hole 725 includes an outermost through-hole portion 725a, an innermost through-hole portion 725b, and multiple relay through-hole portions 725c. The land 726 electrically connects the through-hole 725 to the contact terminal 29, the connection coil 723, and the relay pads 27. The land 726 includes an outermost land portion 726a, an innermost land portion 726b, and multiple relay land portions 726c. In the present embodiment, the inner diameter of the through-hole 725 may be, for example, about 300 µm, and the outer diameter of the land 726 may be, for example, about 600 µm. The inner diameter of the through-hole 725 and the outer diameter of the land 726 are not limited to these dimensions, but may be different from these dimensions.

The outermost connection terminal portion 724a is formed at an outermost end 723m of the connection coil 723. The outermost connection terminal 724a is disposed at an edge portion of the substrate 21 on the first side (+D1 side) in the first direction D1. The outermost connection terminal portion 724a is disposed on the first side (+D2 side) in the second direction D2 relative to the IC chip 22. As viewed in the thickness direction Dt, the outermost connection terminal portion 724a overlaps with an edge portion of the second contact terminal portion 29b on the first side in the first direction D1 and an edge portion thereof on the first side in the second direction D2. The outermost connection terminal portion 724a electrically connects the connection coil 723 to the second contact terminal portion 29b. The outermost connection terminal portion 724a includes the outermost through-hole portion 725a and the outermost land portion 726a.

As shown in Fig. 15, the outermost through-hole portion 725a penetrates the substrate 21 in the thickness direction Dt. As viewed in the thickness direction Dt, the outermost through-hole portion 725a has a substantially circular shape. The outermost land portion 726a has an annular shape surrounding the outermost through-hole portion 725a. As viewed in the thickness direction Dt, the outermost land portion 726a overlaps with the second contact terminal portion 29b. An end portion of the outermost land portion 726a on the first side (+D1 side) in the first direction D1 is located on the outer peripheral side (Do side) relative to the outermost turn portion 723g of the connection coil 723. That is, a part of the outermost land portion 726a is located on the outer peripheral side relative to the connection coil 723. In the present embodiment, as viewed in the thickness direction Dt, the outer edge of the outermost land portion 726a overlaps with the outer edge of the second contact terminal portion 29b. That is, the outer edge of the outermost land portion 726a overlaps with the outer edge of the contact terminal 29. The outer edge of the outermost land portion 726a may be located on the inner peripheral side (Di side) relative to the outer edge of the contact terminal 29.

Although not shown, the outermost connection terminal portion 724a is provided with first and second halves of the outermost land portion 726a. The first half of the outermost land portion 726a is provided on the first surface 21g of the substrate 21. The first half of the outermost land portion 726a has an outer edge connected to the outermost end 723m of the connection coil 723. The first half of the outermost land portion 726a has an inner edge connected to the outermost through-hole portion 725a. Thus, the outermost land portion 726a connects between the outermost through-hole portion 725a and the connection coil 723. Although not shown, the second half of the outermost land portion 726a is provided on the second surface 21f of the substrate 21. The second half of the outermost land portion 726a has an inner edge connected to the outermost through-hole portion 725a. The second half of the outermost land portion 726a is connected to the second contact terminal portion 29b. Consequently, the connection coil 723 is electrically connected to the second contact terminal portion 29b via the outermost connection terminal portion 724a.

As shown in Fig. 14, the innermost connection terminal portion 724b is formed at the innermost end 723n of the connection coil 723. The innermost connection terminal portion 724b is disposed on the inner peripheral side (Di side) relative to the connection coil 723. The innermost connection terminal portion 724b is disposed on the second side (-D2 side) in the second direction D2 relative to the IC chip 22. As viewed in the thickness direction Dt, the innermost connection terminal portion 724b overlaps with the eighth contact terminal portion 29h. The innermost connection terminal portion 724b includes the innermost through-hole portion 725b and the innermost land portion 726b.

The innermost through-hole portion 725b penetrates the substrate 21 in the thickness direction Dt. The innermost connection terminal portion 724b includes first and second halves of the innermost land portion 726b. The first half of the innermost land portion 726b is provided on the first surface 21g of the substrate 21. The first half of the innermost land portion 726b electrically connects the innermost end 723n of the connection coil 723 to the innermost through-hole portion 725b. Although not shown, the second half of the innermost land portion 726b is provided on the second surface 21f of the substrate 21. The second half of the innermost land portion 726b electrically connects the innermost through-hole portion 725b to the eighth contact terminal portion 29h. Consequently, the connection coil 723 is electrically connected to the eighth contact terminal portion 29h via the innermost connection terminal portion 724b.

The multiple relay connection terminal portions 724c are connected to the contact terminal 29. In the present embodiment, the connection terminal 724 includes six relay connection terminal portions 724c. The relay connection terminal portions 724c are disposed on the inner peripheral side (Di side) relative to the connection coil 723. The relay connection terminal portions 724c include respective relay through-hole portions 725c and relay land portions 726c. The relay connection terminal portions 724c are electrically connected to the first contact terminal portion 29a, the third contact terminal portion 29c, the fourth contact terminal portion 29d, the fifth contact terminal portion 29e, the sixth contact terminal portion 29f, and the seventh contact terminal portion 29g, respectively. Other configurations and the like of the connection terminal 724 of the present embodiment are similar to those of the connection terminal 24 of the first embodiment described above. Other configurations and the like of the IC module 720 of the present embodiment are similar to those of the IC module 20 of the first embodiment described above. Other configurations and the like of the IC card 710 of the present embodiment are similar to those of the IC card 10 of the first embodiment described above.

A production process for the IC module 720 of the present embodiment includes an IC chip mounting process Mi and a dicing process Mf. The IC chip mounting process Mi is a process of mounting IC chips 22 on respective multiple substrates 21 constituting a main substrate 90. The dicing process Mf is a process of performing dicing to obtain multiple separate substrates 21.

In the IC chip mounting process Mi, IC chips 22 are mounted on the respective multiple substrates 21 constituting the main substrate 90 having a sheet-like shape as shown in Fig. 16. In the present embodiment, 18 substrates 21 are arrayed side by side on the main substrate 90. In the IC chip mounting process Mi, first, multiple contact terminals 29 are formed on a front surface 90f of the main substrate 90, and then, although not shown, multiple connection coils 723, multiple connection terminals 724, and multiple relay pads 27 are formed on a rear surface 90g of the main substrate 90. The arrangement of the connection coils 723, connection terminals 724, and relay pads 27 with respect to the respective contact terminals 29 is the same as the arrangement of the connection coil 723, connection terminal 724, and relay pads 27 with respect to the contact terminal 29 shown in Fig. 14.

Thereafter, although not shown, an IC chip 22 is mounted on the first surface 21 g of each of the substrates 21. In this case, if the IC chip 22 is mounted on the substrate 21 in a state of being located on the connection coil 723, there is a risk that the fixing strength between the substrate 21 and the IC chip 22 may not be sufficiently ensured. Therefore, the IC chip 22 is required to be mounted on the substrate 21 with a predetermined distance between it and the connection coil 723. Considering the mounting tolerance or the like of the IC chip 22 with respect to the substrate 21, the distance between the IC chip 22 and the connection coil 723 may be preferably, for example, 200 µm or more. After mounting the IC chip 22 on the first surface 21g of each of the substrates 21, the terminals of the IC chip 22 are electrically connected to the relay pads 27 with unshown gold wires or the like, and the IC chip 22 and the gold wires or the like are molded with a protective resin seal portion 50 (see Fig. 4), thereby completing the IC chip mounting process Mi.

In the dicing step Mf, the sheet-like main substrate 90 is diced into separate substrates 21. In the dicing process Mf, the main substrate 90 is diced to obtain separate multiple substrates 21. As a processing method of obtaining separate substrates 21, well-known processing methods can be used, such as punching in which a cutting die is pressed against the main substrate 90 to punch out the substrates 21, and cutting in which the main substrate 90 is cut with a blade into separate substrates 21. When all of the substrates 21 in the main substrate 90 have been separated from each other, the dicing process Mf is completed.

As described above, the first innermost turn portion 723i of the connection coil 723 is located on the second side (-D1 side) in the first direction D1 relative to the second innermost turn portion 723j. Therefore, as shown in Fig. 14, the first distance L1, which is the distance between the first innermost turn portion 723i and the IC chip 22, is smaller than the second distance L2, which is the distance between the second innermost turn portion 723j and the IC chip 22. Therefore, increase of the first distance L1 can increase the distance between the IC chip 22 and the connection coil 723. As described above, as viewed in the thickness direction Dt, the turn portions of the connection coil 723 constituting the bypass portion 723b are formed into a substantially arc shape centered on the outermost connection terminal portion 724a and protrude toward the inner peripheral side (Di side). Accordingly, by disposing the outermost connection terminal portion 724a on the outer peripheral side (Do side), the bypass portion 723b can be disposed on the outer peripheral side. Thus, since the first distance L1 can be increased, the distance between the IC chip 22 and the connection coil 723 can be increased. The first distance L1 can also be increased by increasing the distance between the IC chip 22 and the outermost connection terminal portion 724a, thereby increasing the distance between the IC chip 22 and the connection coil 723.

After completing the IC chip mounting process Mi, the connection pad 723p and the relay pads 27 are electrically connected to the multiple terminals of the IC chip 22 by wire bonding or the like, and the resin seal portion 50 shown in Fig. 4 is formed on the first surface 21g of the substrate 21, thereby forming an IC module 720.

According to the present embodiment, the IC module 720 includes the rectangular substrate 21, the connection coil 723 formed in a spiral shape on the first surface 21g of the substrate 21, the outermost connection terminal portion 724a formed at the outermost end 723m of the connection coil 723, the IC chip 22 provided on a portion of the first surface 21g on the inner peripheral side (Di side) relative to the connection coil 723, and the contact terminal 29 provided to the second surface 21f of the substrate facing away from the first surface 21g. The outermost connection terminal portion 724a includes the outermost through-hole portion 725a penetrating the substrate 21 in the thickness direction Dt, and the outermost land portion 726a surrounding the outermost through-hole portion 725a and connecting the outermost through-hole portion 725a to the connection coil 723, and a part of the outermost land portion 726a is located on the outer peripheral side (Do side) relative to the connection coil 723. Therefore, the outermost connection terminal portion 724a can be easily disposed close to the edge surface 21k of the substrate 21, and therefore the bypass portion 723b of the connection coil 723 can be easily disposed on the outer peripheral side. Therefore, as described above, the first distance L1, which is the distance between the first innermost turn portion 723i and the IC chip 22, can be increased. Thus, the number of turns of the connection coil 723 can be increased, thereby increasing the impedance of the connection coil 723, while increasing the distance between the connection coil 723 and the IC chip 22. Accordingly, in the IC module 720, which uses the downsized substrate 21 with the introduction of the contact terminal 29 having six terminal portions and the small-capacitance IC chip 22, a connection coil 723 having an impedance matching the impedance of the IC chip 22 can be formed.

In the present embodiment, the substrate 21 has a rectangular shape with its long sides extending in the second direction D2, and as viewed in the first direction D1, the outermost connection terminal portion 724a is disposed on the first side (+D2 side) in the second direction D2 relative to the IC chip 22. Therefore, compared to the IC module in which the outermost connection terminal portion 724a is disposed overlapping with the IC chip 22 as viewed in the first direction D1, the distance between the IC chip 22 and the outermost connection terminal portion 724a can be increased. Therefore, as described above, the first distance L1, which is the distance between the first innermost turn portion 723i and the IC chip 22, can be increased even more. Accordingly, the number of turns of the connection coil 723 can be increased to increase the impedance of the connection coil 723, while also increasing even more the distance between the connection coil 723 and the IC chip 22.

According to the present embodiment, as viewed in the thickness direction Dt, the connection coil 723 is disposed on the inner peripheral (Di side) relative to the outer edge of the contact terminal 29, and as viewed in the thickness direction Dt, the outer edge of the outermost land portion 726a overlaps with the outer edge of the contact terminal 29. Therefore, when the substrates 21 are separated from each other by dicing the main substrate 90 in the dicing step Mf, the outermost through-hole portion 725a and the connection coil 723 can be prevented from being cut. Therefore, the contact terminal 29 and the IC chip 22 can be electrically connected to each other in a stable manner via the outermost through-hole portion 725a and the connection coil 723. Accordingly, a stable current can be passed through the connection coil 723. Therefore, stable electromagnetic coupling can be achieved between the connection coil 723 and the booster antenna 32 of the antenna substrate 30, thereby improving reliability of the IC card 710 having the IC module 720 as a contactless communication medium. Furthermore, since the outermost connection terminal portion 724a can be disposed closer to the edge surface 21k of the substrate 21, the first distance L1 can be increased even more. Accordingly, the number of turns of the connection coil 723 can be increased to increase the impedance of the connection coil 723, while also increasing even more the distance between the connection coil 723 and the IC chip 22.

According to the present embodiment, the width of the connection coil 723 is greater than the interval between adjacent portions of the connection coil 723 in the radial direction. Therefore, electrical resistance of the connection coil 723 can be reduced compared to the case where the width of the connection coil 723 is smaller than the interval between adjacent portions of the connection coil 723 in the radial direction. Therefore, since resistance loss of the current passing through the connection coil 723 can be suppressed, a larger current can be passed through the connection coil 723. Accordingly, electromagnetic coupling can be enhanced between the connection coil 723 and the booster antenna 32 of the antenna substrate 30, thereby improving the communication performance of the IC card 710 as a contactless communication medium.

In the present embodiment, since the width of the connection coil 723 is greater than the interval between adjacent portions of the connection coil 723 in the radial direction, breaking of the connection coil 723 can be easily suppressed. Accordingly, reliability of the IC card 710 having the IC module 720 as a contactless communication medium can be enhanced even more.

According to the present embodiment, the input capacitance between the RF terminals of the IC chip 22 is less than 60 pF, the contact terminal 29 is constituted of multiple terminal portions, and the number of terminal portions constituting the contact terminal 29 or the number of terminal portions therein is six or less. Therefore, in IC modules 720 which have become increasingly popular in recent years, provided with both the IC chip 22 with an input capacitance of less than 60 pF between the RF terminals and the contact terminal 29 having six terminal portions, the impedance of the connection coil 723 can be increased by increasing the number of turns of the connection coil 723. Accordingly, electromagnetic coupling can be enhanced between the connection coil 723 and the booster antenna 32, and thus communication performance of the IC card 710 as a contactless communication medium can be improved.

### <Eighth Embodiment>

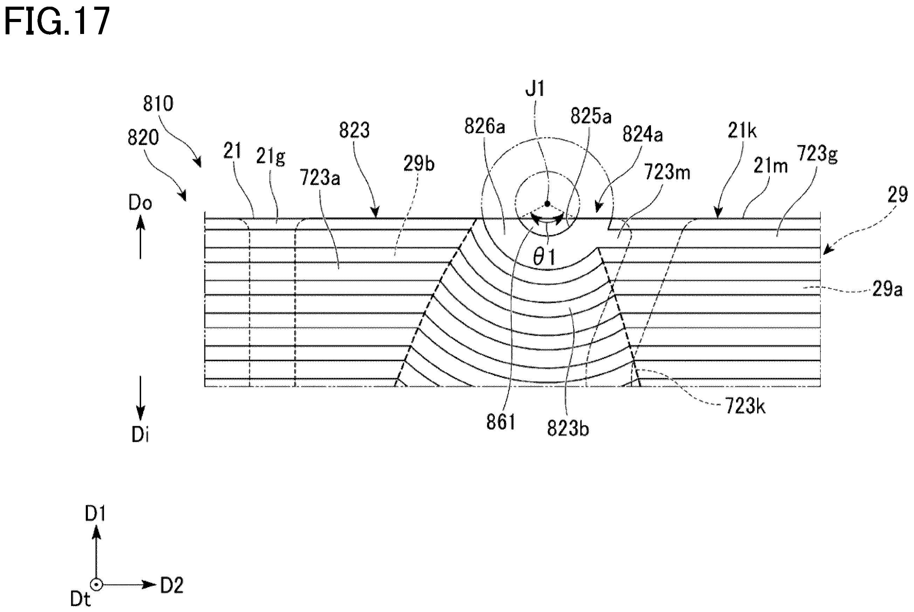

Next, referring to Fig. 17, an eighth embodiment of the present invention will be described. In the following description, the components common to those in the seventh embodiment described above are denoted by the same reference signs to omit repeated explanation. The following description will be focused on differences from the seventh embodiment.

Fig. 17 is an enlarged transparent view illustrating an IC module 820 of an IC card 810 according to the eighth embodiment as seen from above (+Dt side).

As shown in Fig. 17, an outermost connection terminal portion 824a of the present embodiment is formed at the outermost end 723m of a connection coil 823. The outermost connection terminal portion 824a includes an outermost through-hole portion 825a and an outermost land portion 826a.

In the present embodiment, the outermost through-hole portion 825a is an edge surface through-hole which is provided to the edge surface 21k of the substrate 21. More specifically, the outermost through-hole portion 825a is provided to a first edge surface 21m facing the first side (+D1 side) in the first direction D1, in the edge surface 21k of the substrate 21. The outermost through-hole portion 825a penetrates the substrate 21 in the thickness direction Dt. Also, the outermost through-hole portion 825a includes a recess formed in the first edge surface 21m toward the second side (-D1 side) in the first direction D1. As viewed in the thickness direction Dt, the outermost through-hole portion 825a has a substantially arc shape centered on a first axis J1. The first axis J1 is a virtual axis extending in the thickness direction Dt. As viewed in the thickness direction Dt, the outermost through-hole portion 825a has an arc shape with a center angle θ1 of 120° or more. In the present embodiment, the center angle θ1 of the outermost through-hole portion 825a is about 140°. As viewed in the thickness direction Dt, the outermost through-hole portion 825a overlaps with the second contact terminal portion 29b of the contact terminal 29.

The outermost land portion 826a is disposed surrounding the outermost through-hole portion 825a. As viewed in the thickness direction Dt, the inner edge and the outer edge of the outermost land portion 826a have a substantially arc shape centered on the first axis J1. The inner edge of the outermost land portion 826a is connected to the outermost through-hole portion 825a. As viewed in the thickness direction Dt, the outer edge of the outermost land portion 826a has an end portion on the first side (+D 1 side) in the first direction D1 overlapping with the first edge surface 21m. The end portion of the outermost land portion 826a on the first side in the first direction D1 is located on the outer peripheral side (Do side) relative to the outermost turn portion 723g of the connection coil 723. That is, a part of the outermost land portion 826a is located on the outer peripheral side relative to the connection coil 823. The outer edge of the outermost land portion 826a is connected to the outermost end 723m of the connection coil 823. The outermost land portion 826a is connected to the second contact terminal portion 29b. Consequently, the connection coil 823 is electrically connected to the second contact terminal portion 29b via the outermost connection terminal portion 824a.

As described above, the outermost through-hole portion 825a of the present embodiment is an edge surface through-hole provided to the first edge surface 21m. Therefore, the outermost connection terminal portion 824a of the present embodiment is disposed on the outer peripheral side (Do side) relative to the outermost connection terminal portion 724a of the seventh embodiment. As described above, as viewed in the thickness direction Dt, the turn portions of the connection coil 823 constituting a bypass portion 823b are formed into a substantially arc shape centered on the outermost connection terminal portion 824a and protrude toward the inner peripheral side (Di side). Therefore, in the IC module 820 of the present embodiment, the bypass portion 823b can be disposed closer to the outer peripheral side than in the IC module 720 of the seventh embodiment, and therefore the first distance L1 can be increased even more.

In the present embodiment, a filler 861 is filled in the outermost through-hole portion 825a. The filler 861 is formed of a resin such as an epoxy resin, or an electrically conductive material such as solder and copper. The outermost through-hole portion 825a does not necessarily have to be filled with the filler 861.

In the dicing process Mf for the IC module 820 of the present embodiment, when forming the outermost connection terminal portions 824a on the main substrate 90, the outermost through-hole portions 825a are each formed across the portion of the main substrate 90 that will become the first edge surfaces 21m of the substrates 21 after separation. The outermost land portion 826a is formed into an annular shape surrounding the outermost through-hole portion 825a. Thus, after separating the substrates 21 from each other, the outermost connection terminal portion 824a as shown in Fig. 17 is formed.

According to the present embodiment, the outermost through-hole portion 825a is an edge surface through-hole provided to the edge surface 21k of the substrate 21. Therefore, compared to the IC module 720 of the seventh embodiment described above, the outermost connection terminal portion 824a can be disposed closer to the outer peripheral side (Do side). Thus, as described above, since the bypass portion 823b of the connection coil 823 can be disposed closer to the outer peripheral side, the first distance L1, which is the distance between the unshown first innermost turn portion and the IC chip 22, can be increased even more. Accordingly, the number of turns of the connection coil 823 can be increased to increase the impedance of the connection coil 823, while also increasing even more the distance between the connection coil 823 and the IC chip 22.

According to the present embodiment, as viewed in the thickness direction Dt, the outermost through-hole portion 825a has an arc shape with the center angle θ1 of 120° or more. Thus, the circumferential dimension of the inner surface of the outermost through-hole portion 825a formed in the edge surface 21k of the substrate 21 as a result of dicing can be prevented from becoming excessively small. Thus, the circumferential dimension of the conductor formed on the inner surface of the outermost through-hole portion 825a can be prevented from becoming excessively small, thereby preventing breaking of the outermost through-hole portion 825a. Therefore, a stable current can be passed through the connection coil 823, and therefore stable electromagnetic coupling can be achieved between the connection coil 823 and the booster antenna 32 of the antenna substrate 30. This can suitably suppress deterioration in reliability of the IC card 810 having the IC module 820 as a contactless communication medium.

According to the present embodiment, the outermost through-hole portion 825a is filled with the filler 861 made of a resin or a conductive material. Thus, since the physical strength of the outermost through-hole portion 825a can be increased by the filler 861, breaking of the outermost through-hole portion 825a can be more suitably suppressed. This can even more suitably suppress deterioration in reliability of the IC card 810 having the IC module 820 as a contactless communication medium.

### <Ninth Embodiment>

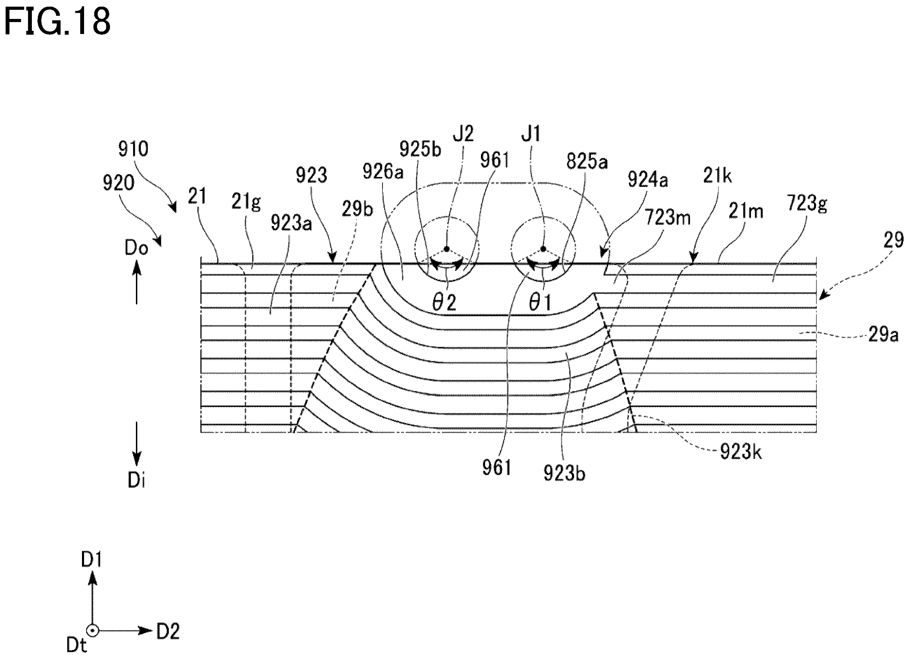

Next, referring to Fig. 18, a ninth embodiment of the present invention will be described. In the following description, the components common to those in the eighth embodiment described above are denoted by the same reference signs to omit repeated explanation. The following description will be focused on differences from the eighth embodiment.

Fig. 18 is an enlarged transparent view illustrating an IC module 920 of an IC card 910 according to the ninth embodiment as seen from above (+Dt side).

As shown in Fig. 18, an outermost connection terminal portion 924a of the present embodiment is formed at the outermost end 723m of a connection coil 923. The outermost connection terminal portion 924a includes multiple outermost through-hole portions 825a and 925b, and an outermost land 926a.

In the present embodiment, the multiple outermost through-hole portions 825a and 925b are edge surface through-holes provided to the first edge surface 21m that is the edge surface 21k of the substrate 21. The outermost through-hole portions 825a and 925b include recesses formed in the first edge surface 21m toward the second side (-D1 side) in the first direction D1. In the present embodiment, the IC module 920 includes two outermost through-hole portions 825a and 925b. The IC module 920 may include three or more outermost through-hole portions. The configuration and the like of the outermost through-hole portion 825a are similar to those of the outermost through-hole portion 825a of the eighth embodiment described above.

As viewed in the thickness direction Dt, the outermost through-hole portion 925b has an arc shape centered on a second axis J2. The second axis J2 is a virtual axis extending in the thickness direction Dt. The outermost through-hole portion 925b is disposed on the second side (-D2 side) in the second direction D2 relative to the outermost through-hole portion 825a, being spaced apart from the outermost through-hole portion 825a. As viewed in the thickness direction Dt, the outermost through-hole portion 925b has an arc shape with a center angle θ2 of 120° or more. In the present embodiment, the outermost through-hole portion 925b has a center angle θ2 of about 140°. Thus, similarly to the eighth embodiment described above, the circumferential dimension of the conductor formed on the inner surface of the outermost through-hole portion 925b can be prevented from becoming excessively small, thereby preventing breaking of the outermost through-hole portion 925b. As viewed in the thickness direction Dt, the outermost through-hole portion 925b overlaps with the second contact terminal portion 29b of the contact terminal 29.

The outermost land portion 926a is disposed surrounding the outermost through-hole portions 825a and 925b. The outermost land portion 926a extends in the second direction D2. The outermost land portion 926a is connected to both the outermost through-hole portions 825a and 925b. Thus, the multiple outermost through-hole portions 825a and 925b are connected in parallel with each other via the outermost land portion 926a. A part of the outermost land portion 926a is located on the outer peripheral side (Do side) relative to the connection coil 923. The outermost land portion 926a has an outer edge connected to the outermost end 723m of the connection coil 923. The outermost land portion 926a is connected to the second contact terminal portion 29b. Consequently, the connection coil 923 is electrically connected to the second contact terminal portion 29b via the outermost connection terminal portion 924a.

The connection coil 923 includes a rectangular portion 923a, a bypass portion 923b, and the connection pad 723p. The rectangular portion 923a is a portion of the connection coil 923 located outside a bypass area 923k. The bypass portion 923b is a portion of the connection coil 923 located inside the bypass area 923k. As viewed in the thickness direction Dt, the turn portions of the connection coil 923 constituting the bypass portion 923b are formed into a substantially arc shape centered on the outermost connection terminal portion 924a and protrude toward the inner peripheral side (Di side). As described above, the outermost through-hole portions 825a and 925b of the present embodiment are edge surface through-holes provided to the first edge surface 21m. Therefore, similarly to the eighth embodiment described above, in the IC module 920 of the present embodiment, the bypass portion 923b can be disposed closer to the outer peripheral side (Do side) than in the IC module 720 of the seventh embodiment, and therefore the first distance L1 can be increased even more.

In the present embodiment, a filler 961 is filled in the outermost through-hole portions 825a and 925b. The filler 961 is formed of a resin such as an epoxy resin, or an electrically conductive material such as solder and copper. Thus, similarly to the eighth embodiment described above, since the physical strength of the outermost through-hole portions 825a and 925b can be increased by the filler 961, breaking of the outermost through-hole portions 825a and 925b can be more suitably suppressed. The outermost through-hole portions 825a and 925b do not necessarily have to be filled with the filler 961.

According to the present embodiment, the outermost connection terminal portion 924a includes the multiple outermost through-hole portions 825a and 925b connected in parallel with each other via the outermost land portion 926a, and the multiple outermost through-hole portions 825a and 925b serve as edge surface through-holes provided to the edge surface 21k of the substrate 21. Thus, if one of the outermost through-hole portions 825a and 925b is broken, the contact terminal 29 can be electrically connected to the connection coil 923 via the other outermost through-hole portion. Therefore, a stable current can be passed through the connection coil 923, and therefore stable electromagnetic coupling can be achieved between the connection coil 923 and the booster antenna 32 of the antenna substrate 30. Accordingly, reliability of the IC card 910 having the IC module 920 as a contactless communication medium can be enhanced even more.

Furthermore, according to the present embodiment, the multiple outermost through-hole portions 825a and 925b serve as edge surface through-holes provided to the edge surface 21k of the substrate 21, and therefore, similarly to the eighth embodiment described above, the bypass portion 923b of the connection coil 923 can be disposed even closer to the outer peripheral side (Do side). Accordingly, the number of turns of the connection coil 923 can be increased to increase the impedance of the connection coil 923, while also increasing even more the distance between the connection coil 923 and the IC chip 22.

### <Tenth Embodiment>

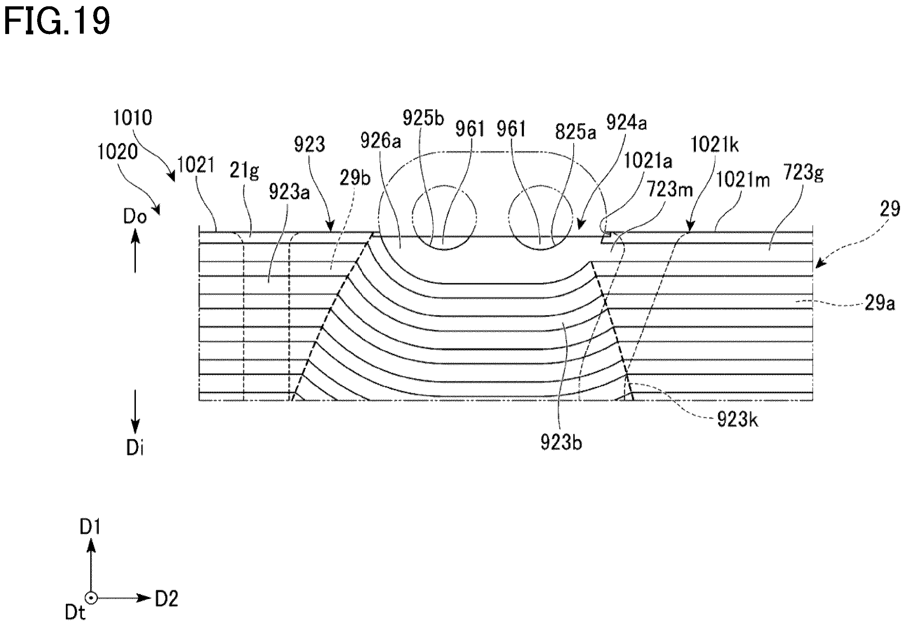

Next, referring to Fig. 19, a tenth embodiment of the present invention will be described. In the following description, the components common to those in the ninth embodiment described above are denoted by the same reference signs to omit repeated explanation. The following description will be focused on differences from the ninth embodiment.

Fig. 19 is an enlarged transparent view illustrating an IC module 1020 of an IC card 1010 according to the tenth embodiment as seen from above (+Dt side).

As shown in Fig. 19, an edge surface 1021k of a substrate 1021 of the present embodiment is provided with a substrate recess 1021a which is recessed toward the inner peripheral side (Di side). More specifically, the substrate recess 1021a is recessed in the edge surface 1021k of the substrate 1021 starting from a first edge surface 1021m facing the first side (+D1 side) in the first direction D1 toward the second side (-D1 side) in the first direction D1. The end portion of the substrate recess 1021a on the first side (+D2 side) in the second direction D2 is located on the first side in the second direction D2 relative to the outermost connection terminal portion 924a. The end portion of the substrate recess 1021a on the second side (-D2 side) in the second direction D2 is located on the second side in the second direction D2 relative to the outermost connection terminal portion 924a. The outermost connection terminal portion 924a of the present embodiment is formed on the inner surface of the substrate recess 1021a. In other words, the portion in which the outermost connection terminal portion 924a is formed in the edge surface 1021k of the substrate 1021 is recessed toward the inner peripheral side.

According to the present embodiment, the portion in which the outermost connection terminal portion 924a is formed in the edge surface 1021k of the substrate 1021 is recessed toward the inner peripheral side (Di side). Thus, the outermost through-hole portions 825a and 925b, i.e., edge surface through-holes, formed in the inner surface of the substrate recess 1021a can be disposed on the inner peripheral side relative to the edge surface 1021k. Thus, even when the card substrate 15 is made of an electrically conductive material such as a metal, the distance between the inner surface of the opening 15a of the card substrate 15 shown in Fig. 4 and the outermost through-hole portions 825a and 925b can be increased, and therefore stable insulation can be achieved between the inner surface of the opening 15a of the card substrate 15 and the outermost through-hole portions 825a and 925b. Accordingly, the communication performance of the IC card 1010 having the IC module 1020 as a contactless communication medium can be suitably stabilized.

### <Eleventh Embodiment>

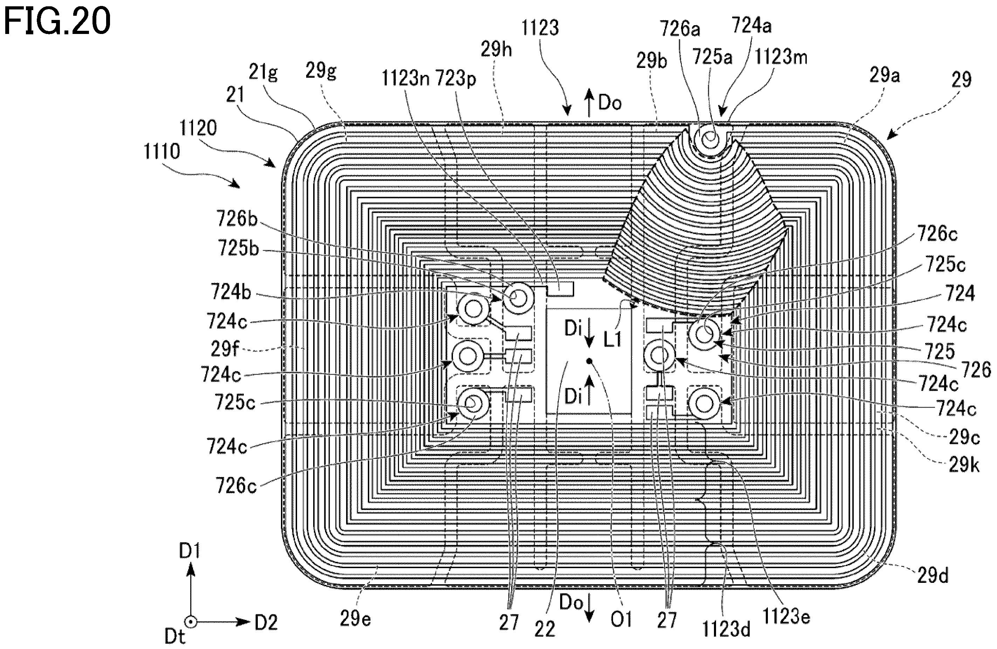

Next, referring to Fig. 20, an eleventh embodiment of the present invention will be described. In the following description, the components common to those in the seventh embodiment described above are denoted by the same reference signs to omit repeated explanation. The following description will be focused on differences from the seventh embodiment.

Fig. 20 is a transparent view illustrating an IC module 1120 of an IC card 1110 according to the eleventh embodiment as seen from above (+Dt side).

A connection coil 1123 of the present embodiment includes a first coil portion 1123d and a second coil portion 1123e. The first coil portion 1123d corresponds to a portion of the connection coil 1123 on the outer peripheral side (Do side). The first coil portion 1123d has an outermost end 1123m corresponding to the outermost end of the connection coil 1123. The outermost end 1123m of the first coil portion 1123d is provided with the outermost connection terminal portion 724a. The second coil portion 1123e corresponds to a portion of the connection coil 1123 on the inner peripheral side (Di side). The second coil portion 1123e is disposed on the inner peripheral side relative to the first coil portion 1123d. The second coil portion 1123e is connected to the first coil portion 1123d. The second coil portion 1123e has an innermost end 1123n corresponding to the innermost end of the connection coil 1123. The innermost end 1123n of the second coil portion 1123e is provided with the connection pad 723p. In a portion near the innermost end 1123n of the second coil portion 1123e, the innermost connection terminal portion 724b is formed. In the present embodiment, the number of turns of each of the first and second coil portions 1123d and 1123e is 9. The number of turns of each of the first and second coil portions 1123d and 1123e may be 8 or less or may be 10 or more.

In the present embodiment, the width of the coil wire forming the first coil portion 1123d is greater than the width of the coil wire constituting the second coil portion 1123e. In other words, the coil width in the first coil portion 1123d is greater than the coil width in the second coil portion 1123e.

According to the present embodiment, the connection coil 1123 includes the first coil portion 1123d provided with the outermost connection terminal portion 724a formed at the outermost end 1123m, and the second coil portion 1123e disposed on the inner peripheral side (Di side) relative to the first coil portion 1123d, and the coil width in the first coil portion 1123d is greater than the coil width in the second coil portion 1123e. Therefore, the cross-sectional area of the coil wire constituting the first coil portion 1123d can be increased even more than the cross-sectional area of the coil wire constituting the second coil portion 1123e, and therefore the electrical resistance per unit length of the coil wire constituting the first coil portion 1123d is smaller than the electrical resistance per unit length of the coil wire constituting the second coil portion 1123e. Furthermore, since the first coil portion 1123d of the connection coil 1123 is on the outer peripheral side (Do side) relative to the second coil portion 1123e, the length of the coil wire constituting the turn portions of the first coil portion 1123d is larger than the length of the coil wire constituting the turn portions of the second coil portion 1123e. Therefore, compared to the configuration in which the coil width in the first coil portion 1123d is smaller than the coil width in the second coil portion 1123e, increase in electrical resistance of the entire connection coil 1123 can be suppressed in the present embodiment. Therefore, since resistance loss of the current passing through the connection coil 1123 can be suppressed, a larger current can be passed through the connection coil 1123. Accordingly, electromagnetic coupling can be enhanced between the connection coil 1123 and the booster antenna 32 of the antenna substrate 30, thereby improving the communication performance of the IC card 1110 as a contactless communication medium.

The width of the connection coil 1123 is not limited to the width according to the present embodiment described above. For example, the width of the connection coil 1123 may be increased from the inner peripheral side (Di side) toward the outer peripheral side (Do side). With this configuration also, increase in electrical resistance of the entire connection coil 1123 can be suppressed. Accordingly, since resistance loss of the current passing through the connection coil 1123 can be suppressed, a larger current can be passed through the connection coil 1123.

### <Twelfth Embodiment>

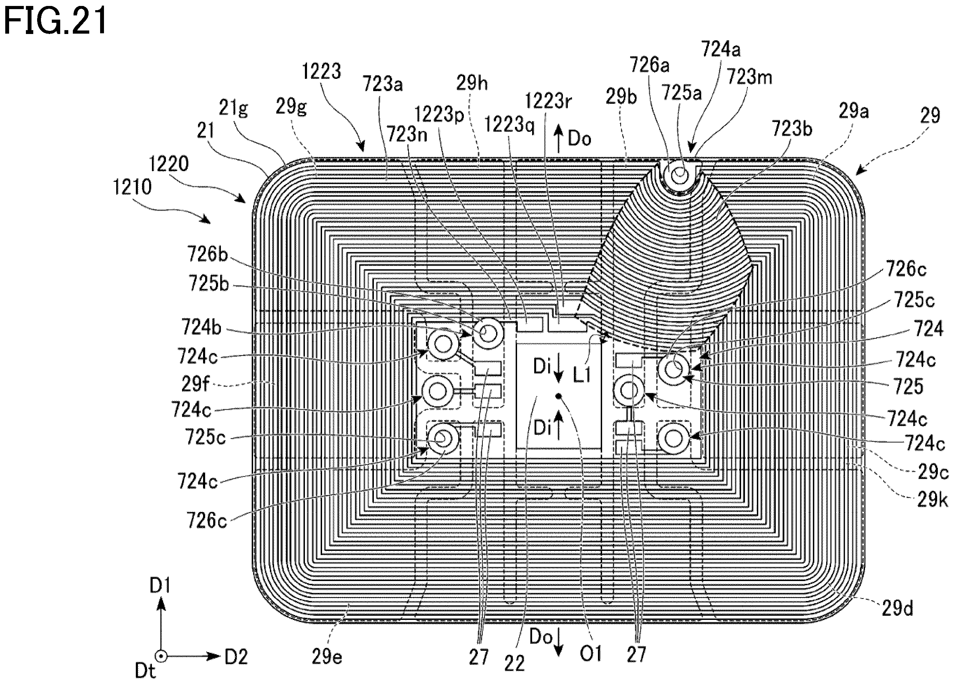

Next, referring to Fig. 21, a twelfth embodiment of the present invention will be described. In the following description, the components common to those in the seventh embodiment described above are denoted by the same reference signs to omit repeated explanation. The following description will be focused on differences from the seventh embodiment.

Fig. 21 is a transparent view illustrating an IC module 1220 of an IC card 1210 according to the twelfth embodiment as seen from above (+Dt side).

A connection coil 1223 of the present embodiment includes the rectangular portion 723a, the bypass portion 723b, and multiple connection pads 1223p, 1223q and 1223r. Similarly to the bypass portion 723b of the seventh embodiment described above, the bypass portion 723b of the present embodiment bypasses the outermost connection terminal portion 724a on the second side (-D1 side) in the first direction D1, which is disposed on an edge portion of the substrate 21 on the first side (+D1 side) in the first direction D1.

The multiple connection pads 1223p, 1223q and 1223r are respectively formed on different turn portions of the connection coil 1223. More specifically, the connection pad 1223p is formed at the innermost end 723n of the connection coil 1223. In other words, the connection pad 1223p is formed on a turn portion on the most inner peripheral side (Di side) of the connection coil 1223. The connection pad 1223p is disposed on the second side (-D2 side) in the second direction D2 relative to the bypass portion 723b. The connection pad 1223q is formed on a second turn portion from the inner peripheral side of the connection coil 1223. In the second direction D2, the connection pad 1223q is disposed between the connection pad 1223p and the bypass portion 723b. The connection pad 1223r is formed on the third turn portion from the inner peripheral side of the connection coil 1223. The connection pad 1223r is disposed on the first side (+D1 side) in the first direction D1 relative to the connection pad 1223q. The connection pads 1223p, 1223q and 1223r are formed into a substantially rectangular shape with a width greater than that of the coil wire. The connection pads 1223p, 1223q and 1223r are formed on the first side (+D1 side) in the first direction D1 of the IC chip 22. As viewed in the second direction D2, at least a part of the multiple connection pads 1223p, 1223q and 1223r overlaps with the bypass portion 723b. Any one of the multiple connection pads 1223p, 1223q and 1223r is electrically connected to some of the multiple terminals of the IC chip 22 by wire bonding. Consequently, the connection coil 1223 is electrically connected to the IC chip 22.

According to the present embodiment, the connection coil 1223 includes the bypass portion 723b that bypasses the outermost connection terminal portion 724a on the second side (-D1 side) in the first direction D1, and the multiple connection pads 1223p, 1223q and 1223r formed on different turn portions of the connection coil 1223, and as viewed in the second direction D2, at least a part of the multiple connection pads 1223p, 1223q and 1223r overlaps with the bypass portion 723b. Therefore, by appropriately selecting a connection pad to be connected to the IC chip 22 from the connection pads 1223p, 1223q and 1223r, effective impedance between the outermost end 723m of the connection coil 1223 and the IC chip 22 can be adjusted. As viewed in the second direction D2, the connection pads 1223p, 1223q and 1223r can be disposed so as to overlap with the bypass portion 723b, thereby suppressing increase in size of the connection coil 1223 including the connection pads 1223p, 1223q and 1223r in the first direction D1. Therefore, the distance between the connection coil 1223 and the IC chip 22 can be easily increased.

### <Thirteenth Embodiment>

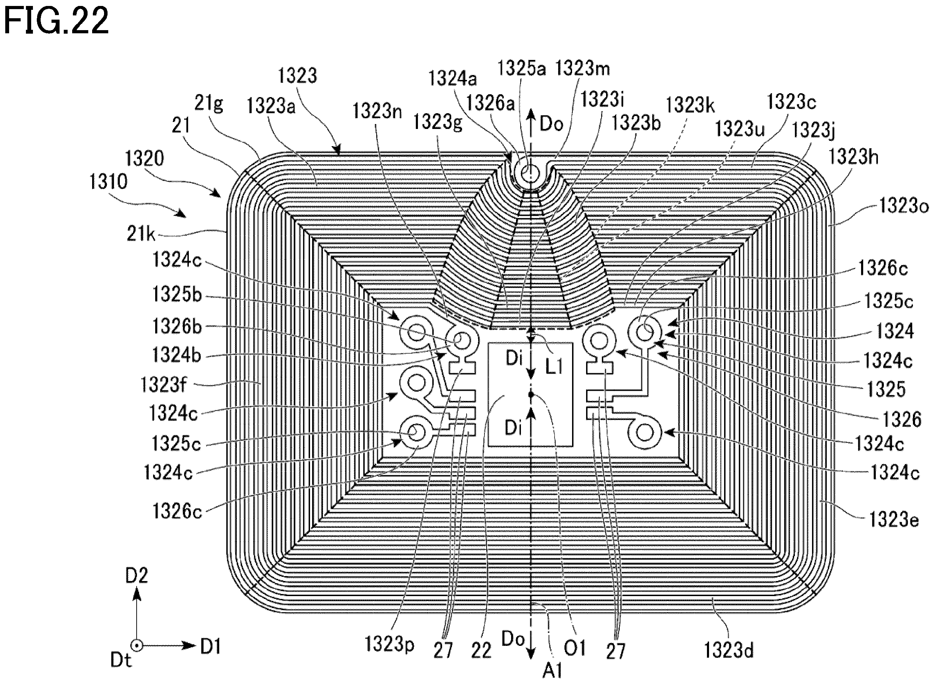

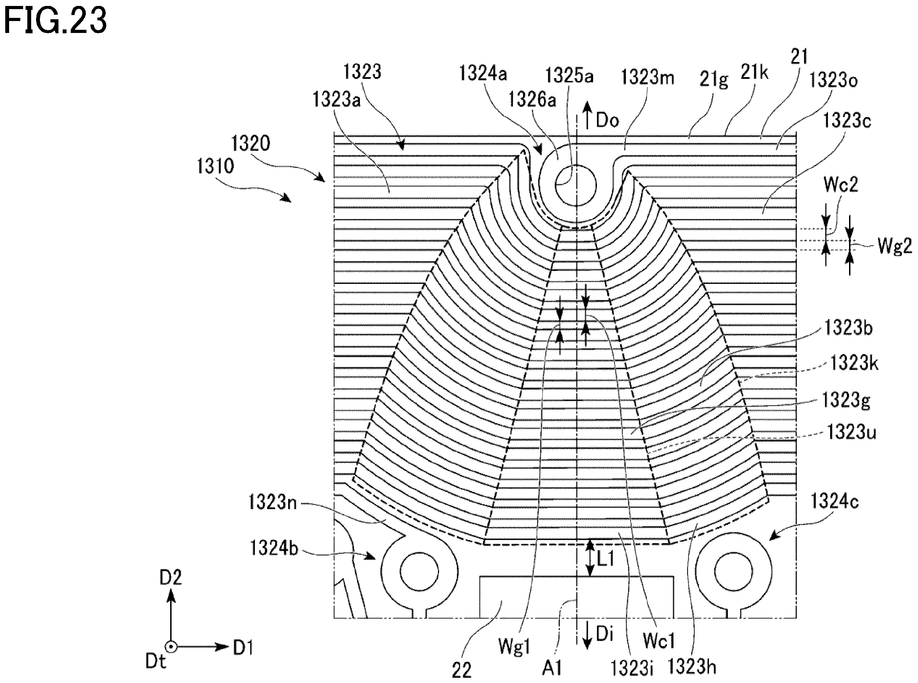

Next, referring to Figs. 22 and 23, a thirteenth embodiment of the present invention will be described. In the following description, the same components as those in the first embodiment described above are denoted by the same reference signs to omit repeated explanation. The following description will be focused on differences from the first embodiment.

In the present embodiment, the first direction D1 is the direction in which the long sides of the rectangular substrate extend and perpendicular to the thickness direction Dt. In the following description, the side toward which the arrow of the first direction D1 points (+D1 side) is referred to as first side in the first direction D1. The side opposite to the side toward which the arrow of the first direction D1 points (-D1 side) is referred to as second side in the first direction D1.

In the present embodiment, the second direction D2 is the direction in which the short sides of the rectangular substrate extend and perpendicular to the first direction D1 and the thickness direction Dt. In the following description, the side toward which the arrow of the second direction D2 points (+D2 side) is referred to as first side in the second direction D2. The side opposite to the side toward which the arrow of the second direction D2 points (-D2 side) is referred to as second side in the second direction D2.

Fig. 22 is a transparent view illustrating an IC module 1320 of an IC card 1310 as seen from above. Fig. 23 is an enlarged transparent view illustrating the IC module 1320 of the IC card 1310 as seen from above.

As shown in Fig. 22, the IC module 1320 includes the substrate 21 , the IC chip 22, a connection coil 1323, a connection terminal 1324, the relay pads 27, the contact terminal 29, and the resin seal portion 50 (see Fig. 4). The IC module 1320 has a rectangular shape with the long sides extending in the first direction D1. The long-side dimension of the IC module 1320 is about 10.6 mm, and the short-side dimension of the IC module 1320 is about 8.0 mm.

As shown in Fig. 22, in the present embodiment, as viewed in the thickness direction Dt, the outer edge of the contact terminal 29 overlaps with the edge surface 21k of the substrate 21. As viewed in the thickness direction Dt, the outer edge of the contact terminal 29 may be located on the inner peripheral side (Di side) relative to the edge surface 21k of the substrate 21. The edge surface 21k of the substrate 21 is a surface facing radially outward in the outer surface of the substrate 21. As viewed in the thickness direction Dt, the edge surface 21k of the substrate 21 has a substantially rectangular shape.

The connection coil 1323 is formed on the first surface 21g of the substrate 21. In the present embodiment, the connection coil 1323 is formed of a coil wire wound approximately 17 times in a substantially rectangular shape. That is, the number of turns of the connection coil 1323 is 17. The connection coil 1323 is constituted of 17 turn portions. The turn portions are disposed side by side in the radial direction. In the turn portions of the connection coil 1323, an outermost turn portion 1323o disposed on the most outer peripheral side (Do side) is formed into a substantially rectangular shape conforming to the edge surface 21k of the substrate 21. In the turn portions of the connection coil 1323, an innermost turn portion 1323h disposed on the most inner peripheral side (Di side) faces the IC chip 22, the connection terminal 1324, and the relay pads 27 in the radial direction. The connection coil 1323 includes a rectangular portion 1323a, a bypass portion 1323b, a first coil portion 1323c, a second coil portion 1323d, a third coil portion 1323e, a fourth coil portion 1323f, and a connection pad 1323p.

The rectangular portion 1323a is a portion of the connection coil 1323, which is formed into a substantially rectangular shape. A bypass area 1323k shown in Fig. 22, which is indicated by a virtual closed curve, is an area in which the bypass portion 1323b is formed. The rectangular portion 1323a is a portion of the connection coil 1323 located outside the bypass area 1323k. The bypass portion 1323b is a portion of the connection coil 1323 bypassing an outermost connection terminal portion 1324a, described later, on the second side (-D2 side) in the second direction D2 of the connection terminal 1324. The bypass portion 1323b is a portion of the connection coil 1323 located inside the bypass area 1323k. The lengths of the turn portions constituting the bypass portion 1323b become longer as the turn portions are located closer to the inner peripheral side (Di side).

The first coil portion 1323c is a portion of the connection coil 1323 disposed on the first side (+D2 side) in the second direction D2 relative to the IC chip 22 and extending in the first direction D1. A center portion of the first coil portion 1323c in the first direction D1 corresponds to the bypass portion 1323b. That is, in the present embodiment, the bypass portion 1323b is a part of the first coil portion 1323c. Portions of the first coil portion 1323c on both sides of the bypass portion 1323b in the first direction D1 are parts of the rectangular portion 1323a. The second coil portion 1323d is a portion of the connection coil 1323 disposed on the second side (-D2 side) in the second direction D2 relative to the IC chip 22 and extending in the first direction D1.

The third coil portion 1323e is a portion of the connection coil 1323 disposed on the first side (+D1 side) in the first direction D1 relative to the IC chip 22 and extending in the second direction D2. The ends of the turn portions on the first side (+D2 side) in the second direction D2 constituting the third coil portion 1323e are connected to the respective ends of the turn portions on the first side in the first direction D1 constituting the first coil portion 1323c. The ends of the turn portions on the second side (-D2 side) in the second direction D2 constituting the third coil portion 1323e are connected to the respective ends of the turn portions on the first side in the first direction D1 constituting the second coil portion 1323d.

The fourth coil portion 1323f is a portion of the connection coil 1323 disposed on the second side (-D1 side) in the first direction D1 relative to the IC chip 22 and extending in the second direction D2. The ends of the turn portions on the first side (+D2 side) in the second direction D2 constituting the fourth coil portion 1323f are connected to the respective ends of the turn portions on the second side in the first direction D1 constituting the first coil portion 1323c. The ends of the turn portions on the second side (-D2 side) in the second direction D2 constituting the fourth coil portion 1323f are connected to the respective ends of the turn portions on the second side in the first direction D1 constituting the second coil portion 1323d.

A small-width area 1323u shown in Fig. 22, which is indicated by a virtual closed curve, is an area in which a small-width portion 1323g is formed. The small-width portion 1323g is a portion of the connection coil 1323 located inside the small-width area 1323u. In the present embodiment, the small-width portion 1323g is a part of the bypass portion 1323b. That is, at least a part of the bypass portion 1323b is the small-width portion 1323g. Also, the small-width portion 1323g is a part of the first coil portion 1323c. That is, the first coil portion 1323c includes the small-width portion 1323g as a part thereof. In other words, at least either of the first and second coil portions 1323c and 1323d includes the small-width portion 1323g as a part thereof.

A first innermost turn portion 1323i shown in Fig. 22 is a portion of the innermost turn portion 1323h constituting the small-width portion 1323g. A second innermost turn portion 1323j is a portion of the innermost turn portion 1323h constituting the portion other than the small-width portion 1323g. As viewed in the thickness direction Dt, a first virtual line A1 shown in Fig. 22 is a straight line passing through both an outermost connection terminal portion 1324a, described later, and the IC chip 22. The first virtual line A1 passes through the small-width portion 1323g. As described above, the bypass portion 1323b including the small-width portion 1323g bypasses the outermost connection terminal portion 1324a on the second side (-D2 side) in the second direction D2, and therefore the first innermost turn portion 1323i is disposed on the inner peripheral side (Di side) relative to the second innermost turn portion 1323j. Furthermore, as described above, since the first virtual line A1 passes through the small-width portion 1323g, the first innermost turn portion 1323i faces the IC chip 22. Therefore, the first distance L1, which is the distance between the first innermost turn portion 1323i and the IC chip 22, is smaller than the distance between the second innermost turn portion 1323j and the IC chip 22. Accordingly, in order to increase the distance between the connection coil 1323 and the IC chip 22, the first distance L1 is required to be increased.

As shown in Fig. 23, the portion of the bypass portion 1323b other than the small-width portion 1323g is formed into a substantially arc shape centered on the outermost connection terminal portion 1324a and protrudes toward the inner peripheral side (Di side). In the present embodiment, a first coil width Wc1 that is the width of the coil wire in the small-width portion 1323g is smaller than a second coil width Wc2 that is the width of the coil wire in the portion other than the small-width portion 1323g of the connection coil 1323. In the present embodiment, a first coil interval Wg1 that is the interval between portions of the coil wire in the small-width portion 1323g is smaller than a second coil interval Wg2 that is the interval between portions of the coil wire in the portion other than the small-width portion 1323g of the connection coil 1323. That is, at least either of the width of the coil wire in the small-width portion 1323g and the interval between portions of the coil wire in the small-width portion 1323g is smaller than that in the portion of the connection coil 1323 other than the small-width portion 1323g. Therefore, in the present embodiment, the turn portions of the small-width portion 1323g can each be formed into a linear shape extending in the first direction D1. Although not shown, if the dimensions of the first and second coil widths Wc1 and Wc2 are the same and the dimensions of the first and second coil intervals Wg1 and Wg2 are the same, the small-width portion 1323g will have a substantially arc shape centered on the outermost connection terminal portion 1324a and protrude toward the inner peripheral side. The first innermost turn portion 1323i in this case will be formed closer to the inner peripheral side than the first innermost turn portion 1323i of the present embodiment. That is, compared to such a case, the innermost turn portion 1323i of the present embodiment can be formed closer to the outer peripheral side (Do side), and therefore the first distance L1 can be increased.

In the present embodiment, the first coil width Wc1 is about 75 µm and the first coil interval Wg1 is about 70 µm. Therefore, in the small-width portion 1323g, the width of the coil wire is greater than the interval between adjacent portions of the coil wire in the radial direction. Also, in the present embodiment, the second coil width Wc2 is about 80 µm and the second coil interval Wg2 is about 75 µm. Therefore, the width of the coil wire is greater than the interval between adjacent portions of the coil wire in the radial direction in the portion other than the small-width portion 1323g. Consequently, the width of the coil wire of the connection coil 1323 is greater than the interval between adjacent portions of the connection coil 1323 in the radial direction. The dimensions of the width of the coil wire of the connection coil 1323 and the interval between adjacent portions of the coil wire in the radial direction are not limited to the dimensions of the present embodiment, but can be determined appropriately depending on the impedance, etc. required for the connection coil 1323.

As shown in Fig. 22, connection pad 1323p is connected to an innermost end 1323n of the connection coil 1323. The connection pad 1323p is formed into a substantially rectangular shape with a width greater than that of the coil wire. The connection pad 1323p is electrically connected to some of the multiple terminals of the IC chip 22 by wire bonding or the like. Consequently, the connection coil 1323 is electrically connected to the IC chip 22. Therefore, the IC chip 22 can perform contactless communication with a contactless external device via the connection coil 1323 and the booster antenna 32. Other configurations and the like of the connection coil 1323 of the present embodiment are similar to those of the connection coil 23 of the first embodiment described above.

The connection terminal 1324 shown in Fig. 22 electrically connects the contact terminal 29 to the connection coil 1323 and the relay pads 27. The connection terminal 1324 has a through-hole 1325 and a land 1326. The connection terminal 1324 includes the outermost connection terminal portion 1324a, an innermost connection terminal portion 1324b, and multiple relay connection terminal portions 1324c. The through-hole 1325 penetrates the substrate 21 in the thickness direction Dt and has an inner peripheral surface provided with an unshown conductor formed of a copper foil layer. In the present embodiment, the through-hole 1325 includes an outermost through-hole portion 1325a, an innermost through-hole portion 1325b, and multiple relay through-hole portions 1325c. The land 1326 electrically connects the through-hole 1325 to the contact terminal 29, the connection coil 1323, and the relay pads 27. The land 1326 surrounds the through-hole 1325. The land 1326 is connected to the through-hole 1325. The land 1326 includes an outermost land portion 1326a, an innermost land 1326b, and multiple relay land portions 1326c.

The outermost connection terminal portion 1324a is formed at an outermost end 1323m of the connection coil 1323. The outermost connection terminal portion 1324a is disposed at an edge portion of the substrate 21 on the first side (+D2 side) in the second direction D2. In the present embodiment, as viewed in the second direction D2, the outermost connection terminal portion 1324a overlaps with the IC chip 22. Although not shown, as viewed in the thickness direction Dt, the outermost connection terminal portion 1324a overlaps with the second contact terminal portion 29b. The outermost connection terminal portion 1324a electrically connects the connection coil 1323 to the second contact terminal portion 29b. The outermost connection terminal portion 1324a includes the outermost through-hole portion 1325a and the outermost land portion 1326a.

The outermost through-hole portion 1325a penetrates the substrate 21 in the thickness direction Dt. The outermost land portion 1326a has an annular shape surrounding the outermost through-hole portion 1325a. Although not shown, the outermost connection terminal portion 1324a is provided with first and second halves of the outermost land portion 1326a. The first half of the outermost land portion 1326a is provided on the first surface 21g of the substrate 21. The first half of the outermost land portion 1326a is connected to the outermost end 1323m of the connection coil 1323. The first half of the outermost land portion 1326a is connected to the outermost through-hole portion 1325a. Thus, the outermost land portion 1326a connects between the outermost through-hole portion 1325a and the connection coil 1323. Although not shown, the second half of the outermost land portion 1326a is provided on the second surface 21f of the substrate 21. The second half of the outermost land portion 1326a is connected to the outermost through-hole portion 1325a. The second half of the outermost land portion 1326a is connected to the second contact terminal portion 29b. Consequently, the connection coil 1323 is electrically connected to the second contact terminal portion 29b via the outermost connection terminal portion 1324a.

The innermost connection terminal portion 1324b is formed at the innermost end 1323n of the connection coil 1323. The innermost connection terminal portion 1324b is disposed on the second side (-D1 side) in the first direction D1 of the IC chip 22. Although not shown, as viewed in the thickness direction Dt, the innermost connection terminal portion 1324b overlaps with the eighth contact terminal portion 29h. The innermost connection terminal portion 1324b includes the innermost through-hole portion 1325b and the innermost land portion 1326b.

The innermost through-hole portion 1325b penetrates the substrate 21 in the thickness direction Dt. The innermost connection terminal portion 1324b includes first and second halves of the innermost land portion 1326b. The first half of the innermost land portion 1326b is provided to the first surface 21g of the substrate 21 and electrically connects the innermost end 1323n of the connection coil 1323 to the innermost through-hole portion 1325b. Although not shown, the second half of the innermost land portion 1326b is provided on the second surface 21f of the substrate 21. The second half of the innermost land portion 1326b electrically connects the innermost through-hole portion 1325b to the eighth contact terminal portion 29h. Consequently, the connection coil 1323 is electrically connected to the eighth contact terminal portion 29h via the innermost connection terminal portion 1324b.

The multiple relay connection terminal portions 1324c are connected to the contact terminal 29. In the present embodiment, the connection terminal 1324 includes six relay connection terminal portions 1324c. The relay connection terminal portions 1324c are disposed on the inner peripheral side (Di side) relative to the connection coil 1323. The relay connection terminal portions 1324c include respective relay through-hole portions 1325c and relay land portions 1326c. The relay connection terminal portions 1324c are electrically connected to the first contact terminal portion 29a, the third contact terminal portion 29c, the fourth contact terminal portion 29d, the fifth contact terminal portion 29e, the sixth contact terminal portion 29f, and the seventh contact terminal portion 29g, respectively. Other configurations and the like of the connection terminal 1324 of the present embodiment are similar to those of the connection terminal 24 of the first embodiment described above. Other configurations and the like of the IC module 1320 of the present embodiment are similar to those of the IC module 20 of the first embodiment described above. Other configurations and the like of the IC card 1310 of the present embodiment are similar to those of the IC card 10 of the first embodiment described above.

According to the present embodiment, in the IC module 1320, the connection coil 1323 is disposed on the first side (+D2 side) in the second direction D2 relative to the IC chip 22, and includes the first coil portion 1323c extending in the first direction D1 and the second coil portion 1323d disposed on the second side (-D2 side) in the second direction D2 relative to the IC chip 22 and extending in the first direction D1, with the first coil portion 1323c including the small-width portion 1323g in a part thereof, the first virtual line A1 that passes through both the outermost connection terminal portion 1324a and the IC chip 22 as viewed in the thickness direction Dt passing through the small-width portion 1323g, and at least either of the width of the coil wire in the small-width portion 1323g and the interval between portions of the coil wire in the small-width portion 1323g being smaller than that in the portion of the connection coil 1323 other than the small-width portion 1323g. As described above, the first virtual line A1 passing through both the outermost connection terminal portion 1324a and the IC chip 22 passes through the small-width portion 1323g, and therefore the first innermost turn portion 1323i that is a portion of the innermost turn portion 1323h constituting the small-width portion 1323g faces the IC chip 22. Therefore, the first distance L1, which is the distance between the first innermost turn portion 1323i and the IC chip 22, tends to become smaller than the distance between the IC chip 22 and the second innermost turn portion 1323j that is a portion of the innermost turn portion 1323h constituting the portion other than the small-width portion 1323g. In this regard, in the connection coil 1323 according to the present embodiment, as described above, the first coil width Wc1 and the first coil interval Wg1 are smaller than the second coil width Wc2 and the second coil interval Wg2, respectively, and therefore the first innermost turn portion 1323i can be formed closer to the outer peripheral side (Do side). Thus, since the first distance L1 can be increased, the distance between the connection coil 1323 and the IC chip 22 can be increased. Thus, the number of turns of the connection coil 1323 can be increased, thereby increasing the impedance of the connection coil 1323, while increasing the distance between the connection coil 1323 and the IC chip 22. Accordingly, in the IC module 1320 which uses the downsized substrate 21 with the introduction of the contact terminal 29 having six terminal portions and the small-capacitance IC chip 22, a connection coil 1323 having an impedance matching the impedance of the IC chip 22 can be formed.

According to the present embodiment, the outermost connection terminal portion 1324a is disposed at an edge portion of the substrate 21 on the first side (+D2 side) in the second direction D2, the first coil portion 1323c includes the bypass portion 1323b bypassing the outermost connection terminal portion 1324a on the second side (-D2 side) in the second direction D2, and at least a part of the bypass portion 1323b corresponds to the small-width portion 1323g. Thus, the first innermost turn portion 1323i is disposed on the inner peripheral side (Di side) relative to the second innermost turn portion 1323j, and therefore the first distance L1 tends to be reduced. In this regard, in the present embodiment, as described above, the first coil width Wc1 and the first coil interval Wg1 are smaller than the second coil width Wc2 and the second coil interval Wg2, respectively, and therefore the first innermost turn portion 1323i can be formed closer to the outer peripheral side (Do side). Thus, since the first distance L1 can be increased, the number of turns of the connection coil 1323 can be increased, thereby increasing the impedance of the connection coil 1323, while increasing the distance between the connection coil 1323 and the IC chip 22. Accordingly, in the IC module 1320 which uses the downsized substrate 21 with the introduction of the contact terminal 29 having six terminal portions and the small-capacitance IC chip 22, a connection coil 1323 having an impedance matching the impedance of the IC chip 22 can be formed.

In the present embodiment, since the small-width portion 1323g is a part of the bypass portion 1323b, increase in electrical resistance of the connection coil 1323 can be suppressed compared to the case of reducing the width of the entire coil wire of the entire connection coil 1323. Thus, since resistance loss of the current passing through the connection coil 1323 can be suppressed, a larger current can be passed through the connection coil 1323. Accordingly, electromagnetic coupling can be enhanced between the connection coil 1323 and the booster antenna 32 of the antenna substrate 30, thereby improving the communication performance of the IC card 1310 as a contactless communication medium.

According to the present embodiment, the width of the coil wire of the connection coil 1323 is greater than the interval between adjacent portions of the coil wire of the connection coil 1323 in the radial direction. Therefore, electrical resistance of the connection coil 1323 can be reduced compared to the case where the width of the coil wire of the connection coil 1323 is smaller than the interval between adjacent portions of the coil wire of the connection coil 1323 in the radial direction. Thus, a larger current can be passed through the connection coil 1323. Accordingly, electromagnetic coupling can be enhanced more suitably between the connection coil 1323 and the booster antenna 32 of the antenna substrate 30, thereby improving more suitably the communication performance of the IC card 1310 as a contactless communication medium. In addition, since the width of the coil wire of the connection coil 1323 can be prevented from becoming excessively small, breaking of the coil wire can be easily suppressed. Accordingly, reliability of the IC card 1310 having the IC module 1320 as a contactless communication medium can be enhanced.

According to the present embodiment, the IC module 1320 includes the contact terminal 29 provided on the second surface 21f of the substrate 21, the contact terminal 29 is constituted of multiple terminal portions, the number of terminal portions constituting the contact terminal 29 or the number of terminal portions therein is six or less, and the input capacitance between the RF terminals of the IC chip 22 is less than 60 pF. Therefore, in IC modules 1320 which have become increasingly popular in recent years, provided with both the IC chip 22 having an input capacitance of less than 60 pF between the RF terminals and the contact terminal 29 having six terminal portions, the impedance of the connection coil 1323 can be increased by increasing the number of turns of the connection coil 1323. Accordingly, electromagnetic coupling can be enhanced between the connection coil 1323 and the booster antenna 32, and thus communication performance of the IC card 1310 as a contactless communication medium can be improved.

If the first distance L1, which is the distance between the first innermost turn portion 1323i and the IC chip 22, can be increased, at least either of the first coil width Wc1 and the first coil interval Wg1 may be smaller than the second coil width Wc2 and the second coil interval Wg2. That is, if the first coil width Wc1 is smaller than the second coil width Wc2, the dimension of first coil interval Wg1 may be the same as or greater than that of the second coil interval Wg2. Also, if the first coil interval Wg1 is smaller than the second coil interval Wg2, the dimension of first coil width Wc1 may be the same as or greater than that of the second coil width Wc2.

### <Fourteenth Embodiment>

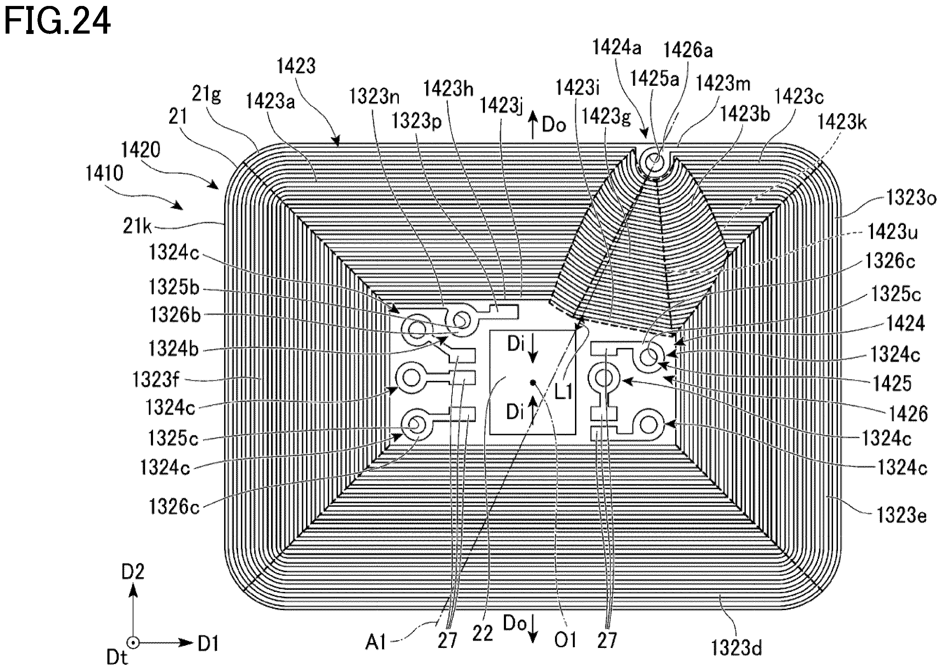

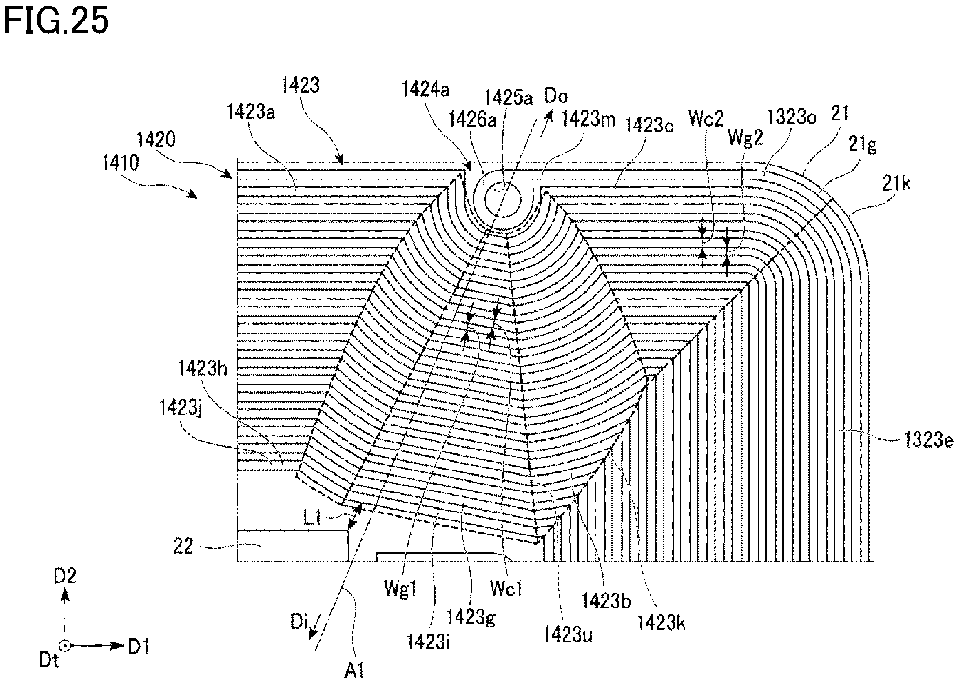

Next, referring to Figs. 24 and 25, a fourteenth embodiment of the present invention will be described. In the following description, the components common to those in the thirteenth embodiment described above are denoted by the same reference signs to omit repeated explanation. The following description will be focused on differences from the thirteenth embodiment.

Fig. 24 is a transparent view illustrating an IC module 1420 of an IC card 1410 according to the fourteenth embodiment as seen from above (+Dt side). Fig. 25 is an enlarged transparent view illustrating the IC module 1420 of the present embodiment as seen from above.

As shown in Fig. 24, as viewed in the second direction D2, an outermost connection terminal portion 1424a of a connection terminal 1424 of the present embodiment is disposed on the first side (+D1 side) in the first direction D1 relative to the IC chip 22. The outermost connection terminal portion 1424a includes an outermost through-hole portion 1425a of a through-hole 1425, and an outermost land portion 1426a of a land 1426.

The outermost through-hole portion 1425a penetrates the substrate 21 in the thickness direction Dt. The outermost land portion 1426a has an annular shape surrounding the outermost through-hole portion 1425a. Although not shown, the outermost connection terminal portion 1424a is provided with first and second halves of the outermost land portion 1426a. The first half of the outermost land portion 1426a is provided to the first surface 21g of the substrate 21 and connects the outermost through-hole portion 1425a to an outermost end 1423m of a connection coil 1423. Although not shown, the second half of the outermost land portion 1426a is provided to the second surface 21f of the substrate 21 and connects the outermost through-hole portion 1425a to the second contact terminal portion 29b. Consequently, the connection coil 1423 is electrically connected to the second contact terminal portion 29b via the outermost connection terminal portion 1424a. Other configurations and the like of the connection terminal 1424 of the present embodiment are similar to those of the connection terminal 1324 of the thirteenth embodiment described above.

The connection coil 1423 of the present embodiment includes a rectangular portion 1423a, a bypass portion 1423b, a first coil portion 1423c, the second coil portion 1323d, the third coil portion 1323e, the fourth coil portion 1323f, and the connection pad 1323p.

The rectangular portion 1423a is a portion of the connection coil 1423 which is formed into a rectangular shape. The rectangular portion 1423a is a portion of the connection coil 1423 located outside a bypass area 1423k. The bypass portion 1423b is a portion of the connection coil 1423 bypassing the outermost connection terminal portion 1424a on the second side (-D2 side) in the second direction D2. The bypass portion 1423b is a portion of the connection coil 1423 located inside the bypass area 1423k. The lengths of the turn portions constituting the bypass portion 1423b become longer as the turn portions are located closer to the inner peripheral side (Di side).

The first coil portion 1423c is a portion of the connection coil 1423 disposed on the first side (+D2 side) in the second direction D2 relative to the IC chip 22 and extending in the first direction D1. The bypass portion 1423b is provided to a portion of the first coil portion 1423c on the first side (+D1 side) in the first direction D1. That is, in the present embodiment, the first coil portion 1423c includes the bypass portion 1423b. Other configurations and the like of the first coil portion 1423c are similar to those of the first coil portion 1323c of the thirteenth embodiment described above.

A small-width area 1423u shown in Fig. 24, which is indicated by a virtual closed curve, is an area in which a small-width portion 1423g is formed. The small-width portion 1423g is a portion of the connection coil 1423 located inside the small-width area 1423u. In the present embodiment, the small-width portion 1423g is a part of the bypass portion 1423b. That is, at least a part of the bypass portion 1423b corresponds to the small-width portion 1423g. The first coil portion 1423c includes the small-width portion 1423g as a part thereof. In other words, at least either of the first and second coil portions 1423c and 1323d includes the small-width portion 1423g as a part thereof.

A first innermost turn portion 1423i shown in Fig. 24 is a portion of an innermost turn portion 1423h constituting the small-width portion 1423g. A second innermost turn portion 1423j is a portion of the innermost turn portion 1423h constituting the portion other than the small-width portion 1423g. As viewed in the thickness direction Dt, the first virtual line A1 shown in Fig. 24 is a straight line passing through both the outermost connection terminal portion 1424a and the IC chip 22. The first virtual line A1 passes through the small-width portion 1423g. As described above, the bypass portion 1423b including the small-width portion 1423g bypasses the outermost connection terminal portion 1424a on the second side (-D2 side) in the second direction D2, and therefore the first innermost turn portion 1423i is disposed on the inner peripheral side (Di side) relative to the second innermost turn portion 1423j. Furthermore, as described above, since the first virtual line A1 passes through the small-width portion 1423g, the first innermost turn portion 1423i faces the IC chip 22. Therefore, similarly to the thirteenth embodiment described above, in order to increase the distance between the connection coil 1423 and the IC chip 22, the first distance L1, which is the distance between the first innermost turn portion 1423i and the IC chip 22, is required to be increased.

As shown in Fig. 25, in the present embodiment, the first coil width Wc1 that is the width of the coil wire in the small-width portion 1423g is smaller than the second coil width Wc2 that is the width of the coil wire in the portion other than the small-width portion 1423g. In the present embodiment, the first coil interval Wg1 that is the interval between portions of the coil wire in the small-width portion 1423g is smaller than the second coil interval Wg2 that is the interval between portions of the coil wire in the portion other than the small-width portion 1423g. Therefore, in the present embodiment, the turn portions of the small-width portion 1423g can each be formed into a linear shape. Therefore, similarly to the thirteenth embodiment described above, the innermost turn portion 1423i of the present embodiment can be formed closer to the outer peripheral side (Do side), and therefore the first distance L1 can be increased. Other configurations and the like of the connection coil 1423 of the present embodiment are similar to those of the connection coil 1323 of the thirteenth embodiment described above.

In the present embodiment, the first coil portion 1423c includes the small-width portion 1423g as a part thereof, the first virtual line A1 that is a straight line passing through both the outermost connection terminal portion 1424a and the IC chip 22 as viewed in the thickness direction Dt passes through the small-width portion 1423g, and the first coil width Wc1 and the first coil interval Wg1 are smaller than the second coil width Wc2 and the second coil interval Wg2, respectively. Therefore, similarly to the thirteenth embodiment described above, the first innermost turn portion 1423i can be disposed closer to the outer peripheral side (Do side). Thus, since the first distance L1 can be increased, the distance between the connection coil 1423 and the IC chip 22 can be increased. Therefore, the number of turns of the connection coil 1423 can be increased to increase the impedance of the connection coil 1423, while also increasing the distance between the connection coil 1423 and the IC chip 22.

In the present embodiment, the outermost connection terminal portion 1424a is disposed at an edge portion of the substrate 21 on the first side (+D2 side) in the second direction D2, the first coil portion 1423c includes the bypass portion 1423b bypassing the outermost connection terminal portion 1424a on the second side (-D2 side) in the second direction D2, and at least a part of the bypass portion 1423b corresponds to the small-width portion 1423g. Thus, similarly to the thirteenth embodiment described above, the first innermost turn portion 1423i is disposed on the inner peripheral side (Di side) relative to the second innermost turn portion 1423j, and therefore the first distance L1 tends to be reduced. Therefore, in the present embodiment, the first innermost turn portion 1423i can be formed closer to the outer peripheral side (Do side) as described above. Thus, since the first distance L1 can be increased, the number of turns of the connection coil 1423 can be increased, thereby increasing the impedance of the connection coil 1423, while increasing the distance between the connection coil 1423 and the IC chip 22.

In the present embodiment, as viewed in the second direction D2, the outermost connection terminal portion 1424a is disposed on the first side (+D1 side) in the first direction D1 relative to the IC chip 22. Therefore, compared to the case where the outermost connection terminal portion 1424a is disposed overlapping with the IC chip 22 as viewed in the second direction D2, the distance between the IC chip 22 and the outermost connection terminal portion 1424a can be increased. Thus, since the first distance L1 can be increased, the number of turns of the connection coil 1423 can be increased, thereby increasing the impedance of the connection coil 1423, while increasing even more the distance between the connection coil 1423 and the IC chip 22.

In the present embodiment, the small-width portion 1423g is a part of the bypass portion 1423b. Therefore, compared to the case where the width of the coil wire of the entire connection coil 1423 is reduced, increase in electrical resistance of the connection coil 1423 can be suppressed. Thus, a larger current can be passed through the connection coil 1423. Accordingly, electromagnetic coupling can be enhanced between the connection coil 1423 and the booster antenna 32 of the antenna substrate 30, thereby improving the communication performance of the IC card 1410 as a contactless communication medium.

### <Fifteenth Embodiment>

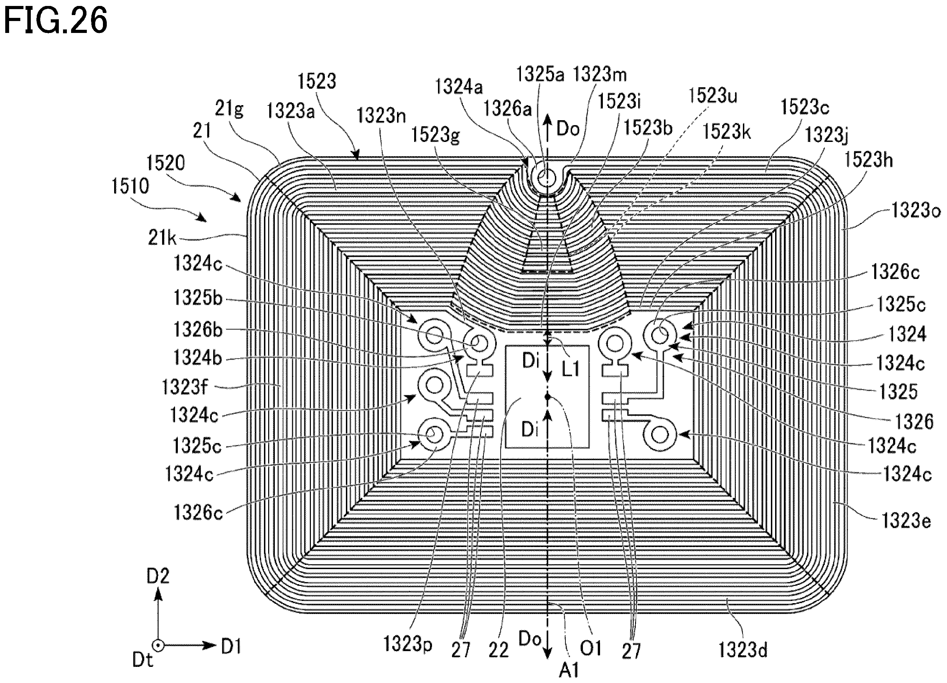

Next, referring to Fig. 26, a fifteenth embodiment of the present invention will be described. In the following description, the components common to those in the thirteenth embodiment described above are denoted by the same reference signs to omit repeated explanation. The following description will be focused on differences from the thirteenth embodiment.

Fig. 26 is a transparent view illustrating an IC module 1520 of an IC card 1510 according to the fifteenth embodiment as seen from above (+Dt side).

As shown in Fig. 26, a connection coil 1523 of the present embodiment is formed of a coil wire wound approximately 17 times in a substantially rectangular shape. That is, the number of turns of the connection coil 1523 is 17. The connection coil 1523 includes the rectangular portion 1323a, a bypass portion 1523b, a first coil portion 1523c, the second coil portion 1323d, the third coil portion 1323e, the fourth coil portion 1323f, and the connection pad 1323p.

The bypass portion 1523b is a portion of the connection coil 1523 bypassing the outermost connection terminal portion 1324a on the second side (-D2 side) in the second direction D2. The bypass portion 1523b is a portion of the connection coil 1523 located inside a bypass area 1523k. The lengths of the turn portions constituting the bypass portion 1523b become longer as the turn portions are located closer to the inner peripheral side (Di side).

The first coil portion 1523c is a portion of the connection coil 1523 disposed on the first side (+D2 side) in the second direction D2 relative to the IC chip 22 and extending in the first direction D1. A center portion of the first coil portion 1523c in the first direction D1 corresponds to the bypass portion 1523b. That is, in the present embodiment, the first coil portion 1523c includes the bypass portion 1523b.

A small-width area 1523u shown in Fig. 26, which is indicated by a virtual closed curve, is an area in which a small-width portion 1523g is formed. The small-width portion 1523g is a portion of the connection coil 1523 located inside the small-width area 1523u. In the present embodiment, the small-width portion 1523g corresponds to a center portion of the bypass portion 1523b in the first direction D1 and a portion on the outer peripheral side (Do side) of the bypass portion 1523b. More specifically, the small-width portion 1523g corresponds to nine turn portions on the outer peripheral side of the bypass portion 1523b. The small-width portion 1523g may be constituted of eight or less turn portions on the outer peripheral side of the bypass portion 1523b, or may be constituted of ten or more turn portions on the outer peripheral side of the bypass portion 1523b. The lengths of the turn portions constituting the small-width portion 1523g become longer as the turn portions are located closer to the inner peripheral side. In the present embodiment, at least a part of the bypass portion 1523b corresponds to the small-width portion 1523g. Therefore, the first coil portion 1523c includes the small-width portion 1523g as a part thereof.

In the present embodiment, the first coil width that is the width of the coil wire in the small-width portion 1523g is smaller than the second coil width that is the width of the coil wire in the portion other than the small-width portion 1523g. In the present embodiment, the coil wire in the portion other than the small-width portion 1523g includes the coil wire in the bypass portion 1523b formed between the small-width portion 1523g and the IC chip 22. In the present embodiment, the first coil interval that is the interval between portions of the coil wire in the small-width portion 1523g is smaller than the second coil interval that is the interval between portions of the coil wire in the portion other than the small-width portion 1523g. Therefore, in the present embodiment, the turn portions of the small-width portion 1523g can each be formed into a linear shape extending in the first direction D1. Thus, the portion of the bypass portion 1523b formed on the inner peripheral side (Di side) relative to the small-width portion 1523g can also be formed into a linear shape extending tin the first direction D1.

A first innermost turn portion 1523i shown in Fig. 26 is a portion of the innermost turn portion 1523h constituting the bypass portion 1523b. The second innermost turn portion 1323j is a portion of the innermost turn portion 1523h constituting the rectangular portion 1323a. As viewed in the thickness direction Dt, the first virtual line A1 shown in Fig. 26 is a straight line passing through both the outermost connection terminal portion 1324a and the IC chip 22. The first virtual line A1 passes through the small-width portion 1523g. As described above, the bypass portion 1523b bypasses the outermost connection terminal portion 1324a on the second side (-D2 side) in the second direction D2, and therefore the first innermost turn portion 1523i is disposed on the inner peripheral side (Di side) relative to the second innermost turn portion 1323j. Furthermore, as described above, since the first virtual line A1 passes through the small-width portion 1523g, the first innermost turn portion 1523i faces the IC chip 22. Therefore, similarly to the thirteenth embodiment described above, in order to increase the distance between the connection coil 1523 and the IC chip 22, the first distance L1 is required to be increased.

In the present embodiment, as described above, the turn portions constituting the small-width portion 1523g and the portion located between the small-width portion 1523g of the bypass portion 1523b and the IC chip 22 can be formed into a linear shape extending in the first direction D1. Therefore, the portion of the first innermost turn portion 1523i, which faces the IC chip 22 in the second direction D2, can be formed closer to the outer peripheral side (Do side), and therefore the first distance L1 can be increased.

According to the present embodiment, the portion of the bypass portion 1523b on the outer peripheral side (Do side) corresponds to the small-width portion 1523g. Therefore, the electrical resistance per unit length of the coil wire of the turn portions in the bypass portion 1523b located on the inner peripheral side (Di side) relative to the small-width portion 1523g can be reduced compared to the electrical resistance per unit length of the coil wire of the turn portions constituting the small-width portion 1523g. As described above, the lengths of the turn portions constituting the bypass portion 1523b become longer as the turn portions are located closer to the inner peripheral side. Therefore, compared to the case where the inner peripheral portion of the bypass portion 1523b corresponds to the small-width portion 1523g, increase in electrical resistance of the connection coil 1523 can be suppressed. Thus, a larger current can be passed through the connection coil 1523. Accordingly, electromagnetic coupling can be enhanced between the connection coil 1523 and the booster antenna 32 of the antenna substrate 30, thereby improving the communication performance of the IC card 1510 as a contactless communication medium.

In the present embodiment, the first coil portion 1523c includes the small-width portion 1523g as a part thereof, and the first virtual line A1, which is a straight line passing through both the outermost connection terminal portion 1324a and the IC chip 22 as viewed in the thickness direction Dt, passes through the small-width portion 1523g. Therefore, as described above, the portion of the first innermost turn portion 1523i facing the IC chip 22 in the second direction D2 can be formed closer to the outer peripheral side (Do side), and therefore the first distance L1 can be increased. Accordingly, the number of turns of the connection coil 1523 can be increased to increase the impedance of the connection coil 1523, while also increasing the distance between the connection coil 1523 and the IC chip 22.

### <Sixteenth Embodiment>

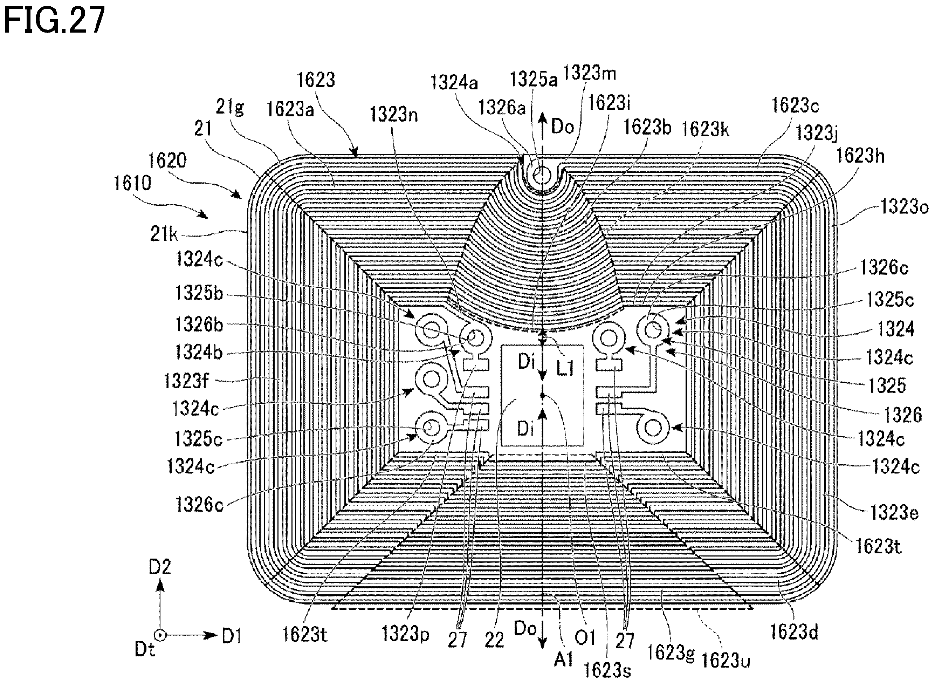

Next, referring to Fig. 27, a sixteenth embodiment of the present invention will be described. In the following description, the components common to those in the thirteenth embodiment described above are denoted by the same reference signs to omit repeated explanation. The following description will be focused on differences from the thirteenth embodiment.

Fig. 27 is a transparent view illustrating an IC module 1620 of an IC card 1610 according to the sixteenth embodiment as seen from above (+Dt side). The IC chip 22 of the present embodiment is disposed on the second side (-D2 side) in the second direction D2 relative to the IC chip 22 of the thirteenth embodiment described above.

As shown in Fig. 27, a connection coil 1623 of the present embodiment includes a rectangular portion 1623a, a bypass portion 1623b, a first coil portion 1623c, a second coil portion 1623d, the third coil portion 1323e, the fourth coil portion 1323f, and the connection pad 1323p.

The rectangular portion 1623a is a portion of the connection coil 1623 formed into a substantially rectangular shape. The rectangular portion 1623a is a portion of the connection coil 1623 located outside a bypass area 1623k. The bypass portion 1623b is a portion of the connection coil 1623 located inside the bypass area 1623k. The bypass portion 1623b bypasses the outermost connection terminal portion 1324a on the second side (-D2 side) in the second direction D2. As viewed in the thickness direction Dt, the turn portions constituting the bypass portion 1623b are formed into a substantially arc shape centered on the outermost connection terminal portion 1324a and protrude toward the inner peripheral side (Di side).

A first innermost turn portion 1623i shown in Fig. 27 is a portion of an innermost turn portion 1623h constituting the bypass portion 1623b. The second innermost turn portion 1323j is a portion of the innermost turn portion 1623h constituting the rectangular portion 1623a. The first innermost turn portion 1623i is located on the inner peripheral side (Di side) relative to the second innermost turn portion 1323j. Therefore, the first distance L1, which is the distance between the first innermost turn portion 1623i and the IC chip 22, is smaller than the distance between the second innermost turn portion 1323j and the IC chip 22. Accordingly, in order to increase the distance between the connection coil 1623 and the IC chip 22, the first distance L1 is required to be increased.

The first coil portion 1623c is a portion of the connection coil 1623 disposed on the first side (+D2 side) in the second direction D2 relative to the IC chip 22 and extending in the first direction D1. A center portion of the first coil portion 1623c in the first direction D1 corresponds to the bypass portion 1623b. The second coil portion 1623d is a portion of the connection coil 1623 disposed on the second side (-D2 side) in the second direction D2 relative to the IC chip 22 and extending in the first direction D1.

A small-width area 1623u shown in Fig. 27, which is indicated by a virtual closed curve, is an area in which a small-width portion 1623g is formed. The small-width portion 1623g is a portion of the connection coil 1623 located inside the small-width area 1623u. In the present embodiment, the small-width portion 1623g is a part of the second coil portion 1623d. That is, at least a part of the second coil portion 1623d corresponds to the small-width portion 1623g. More specifically, the small-width portion 1623g corresponds to a center portion of the second coil portion 1623d in the first direction D1. The first virtual line A1 shown in Fig. 27 is a straight line passing through both the outermost connection terminal portion 1324a and the IC chip 22 as viewed in the thickness direction Dt. In the present embodiment, the first virtual line A1 passes through the small-width portion 1623g. As viewed in the second direction D2, the IC chip 22 overlaps with the small-width portion 1623g. Consequently, the small-width portion 1623g faces the IC chip 22 in the second direction D2.

In the present embodiment, the first coil width that is the width of the coil wire in the small-width portion 1623g is smaller than the second coil width that is the width of the coil wire in the portion other than the small-width portion 1623g. In the present embodiment, the first coil interval that is the interval between portions of the coil wire in the small-width portion 1623g is smaller than the second coil interval that is the interval between portions of the coil wire in the portion other than the small-width portion 1623g. Thus, the turn portions constituting the small-width portion 1623g in the second coil portion 1623d can be formed on the second side (-D2 side) in the second direction D2 relative to the portion other than the small-width portion 1623g. More specifically, the turn portions in the small-width portion 1623g located closer to the inner peripheral side (Di side) can be accordingly formed closer to the second side in the second direction D2 than in the portion other than the small-width portion 1623g. Therefore, a third innermost turn portion 1623s that is a portion of the innermost turn portion 1623h constituting the small-width portion 1623g can be formed on the second side in the second direction D2 relative to a fourth innermost turn portion 1623t that is a portion of the innermost turn portion 1623h constituting the portion other than the small-width portion 1623g of the second coil portion 1623d. In the present embodiment, the turn portions constituting the small-width portion 1623g have larger lengths in the first direction D1 as they are located closer to the outer peripheral side (Do side).

In the present embodiment, the dimension of the third innermost turn portion 1623s in the first direction D1 is greater than the dimension of the IC chip 22 in the first direction D1. As described above, since the small-width portion 1623g faces the IC chip 22 in the second direction D2, the third innermost turn portion 1623s faces the IC chip 22 in the second direction D2. Therefore, in the present embodiment, distance reduction between the second coil portion 1623d and the IC chip 22 can be suppressed, while disposing the IC chip 22 closer to the second side (-D2 side) in the second direction D2 than in the thirteen embodiment described above. Thus, the first distance L1, which is the distance between the first innermost turn portion 1623i and the IC chip 22, can be increased.

According to the present embodiment, the outermost connection terminal portion 1324a is disposed at an edge portion of the substrate 21 on the first side (+D2 side) in the second direction D2, and at least a part of the second coil portion 1623d corresponds to the small-width portion 1623g. Therefore, as described above, the third innermost turn portion 1623s, which is a portion of the innermost turn portion 1623h constituting the small-width portion 1623g, can be formed on the second side (-D2 side) in the second direction D2, and thus the IC chip 22 can be easily disposed on the second side in the second direction D2. This can increase the first distance L1 which is the distance between the IC chip 22 and the first innermost turn portion 1623i of the bypass portion 1623b bypassing the outermost connection terminal portion 1324a on the second side in the second direction D2 which is disposed at an edge portion of the substrate 21 on the first side in the second direction D2. Accordingly, the number of turns of the connection coil 1623 can be increased to increase the impedance of the connection coil 1623, while also increasing the distance between the connection coil 1623 and the IC chip 22.

In the present embodiment, the small-width portion 1623g is a part of the second coil portion 1623d. Therefore, compared to the case where the width of the coil wire of the entire connection coil 1623 is reduced, increase in electrical resistance of the connection coil 1623 can be suppressed. Thus, a larger current can be passed through the connection coil 1623. Accordingly, electromagnetic coupling can be enhanced between the connection coil 1623 and the booster antenna 32 of the antenna substrate 30, thereby improving the communication performance of the IC card 1610 as a contactless communication medium.

In the present embodiment, both of the first and second coil portions 1623c and 1623d may be provided with respective small-width portions 1623g. In other words, both of the first and second coil portions 1623c and 1623d may include respective small-width portions 1623g as parts thereof. In this case, the distances from the IC chip 22 to the first innermost turn portion 1623i and to the third innermost turn portion 1623s can be increased even more, and therefore the distance between the connection coil 1623 and the IC chip 22 can be more suitably increased with ease. The small-width portion 1623g may be an inner peripheral portion of the bypass portion 1623b or may be an outer peripheral portion of the second coil portion 1623d.

### <Seventeenth Embodiment>

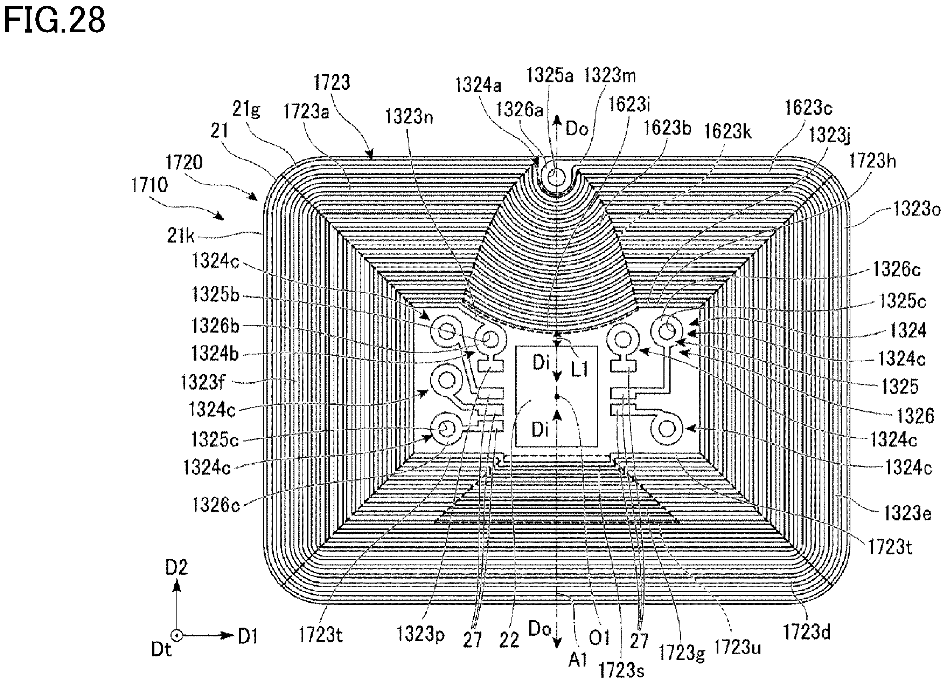

Next, referring to Fig. 28, a seventeenth embodiment of the present invention will be described. In the following description, the components common to those in the sixteenth embodiment described above are denoted by the same reference signs to omit repeated explanation. The following description will be focused on differences from the sixteenth embodiment.

Fig. 28 is a transparent view illustrating an IC module 1720 of an IC card 1710 according to the seventeenth embodiment as seen from above (+Dt side).

As shown in Fig. 28, a connection coil 1723 of the present embodiment includes a rectangular portion 1723a, the bypass portion 1623b, the first coil portion 1623c, a second coil portion 1723d, the third coil portion 1323e, the fourth coil portion 1323f, and the connection pad 1323p.

The rectangular portion 1723a is a portion of the connection coil 1723 formed into a substantially rectangular shape. The rectangular portion 1723a is a portion of the connection coil 1723 located outside the bypass area 1623k.

The second coil portion 1723d is a portion of the connection coil 1723 disposed on the second side (-D2 side) in the second direction D2 relative to the IC chip 22 and extending in the first direction D1. A small-width portion 1723g is a portion of the connection coil 1723 located inside a small-width area 1723u. In the present embodiment, the small-width portion 1723g is a part of the second coil portion 1723d. In other words, the second coil portion 1723d includes the small-width portion 1723g as a part thereof. In the present embodiment, the small-width portion 1723g corresponds to a center portion of the second coil portion 1723d in the first direction D1 and a portion on the inner peripheral side (Di side) of the second coil portion 1723d. More specifically, the small-width portion 1723g corresponds to eight turn portions on the inner peripheral side of the second coil portion 1723d. The small-width portion 1723g may be constituted of seven or less turn portions on the inner peripheral side of the second coil portion 1723d, or may be constituted of nine or more turn portions on the inner peripheral side of the second coil portion 1723d. The first virtual line A1 shown in Fig. 28 is a straight line passing through both the outermost connection terminal portion 1324a and the IC chip 22 as viewed in the thickness direction Dt. The first virtual line A1 passes through the small-width portion 1723g. As viewed in the second direction D2, the IC chip 22 overlaps with the small-width portion 1723g. Consequently, the small-width portion 1723g faces the IC chip 22 in the second direction D2.

In the present embodiment, the first coil width that is the width of the coil wire in the small-width portion 1723g is smaller than the second coil width that is the width of the coil wire in the portion other than the small-width portion 1723g. In the present embodiment, the first coil interval that is the interval between portions of the coil wire in the small-width portion 1723g is smaller than the second coil interval that is the interval between portions of the coil wire in the portion other than the small-width portion 1723g. Thus, in eight turn portions of the second coil portion 1723d on the inner peripheral side (Di side), the portion constituting the small-width portion 1723g can be formed on the second side (-D2 side) in the second direction D2 relative to the portion other than the small-width portion 1723g. Therefore, a third innermost turn portion 1723s that is a portion of an innermost turn portion 1723h constituting the small-width portion 1723g can be formed on the second side in the second direction D2 relative to a fourth innermost turn portion 1723t that is a portion of the innermost turn portion 1723h constituting the portion other than the small-width portion 1723g of the second coil portion 1723d.

In the present embodiment, the dimension of the third innermost turn portion 1723s in the first direction D1 is greater than the dimension of the IC chip 22 in the first direction D1, and the third innermost turn portion 1723s faces the IC chip 22 in the second direction D2. Therefore, in the present embodiment, similarly to the sixteenth embodiment described above, distance reduction between the second coil portion 1723d and the IC chip 22 can be suppressed, while disposing the IC chip 22 closer to the second side (-D2 side) in the second direction D2 than in the thirteen embodiment described above. Thus, the first distance L1, which is the distance between the first innermost turn portion 1623i and the IC chip 22, can be increased. In the present embodiment, the turn portions constituting the small-width portion 1723g have larger lengths in the first direction D1 as they are located closer to the outer peripheral side (Do side).

According to the present embodiment, the small-width portion 1723g corresponds to a portion of the second coil portion 1723d on the inner peripheral side (Di side). As described above, the turn portions constituting the small-width portion 1723g have larger lengths in the first direction D1 as they are located closer to the outer peripheral side (Do side). Furthermore, since the first coil width is smaller than the second coil width, the electrical resistance per unit length of the coil wire in the small-width portion 1723g is larger than the electrical resistance per unit length of the coil wire in the portion other than the small-width portion 1723g. Therefore, compared to the case where the small-width portion 1723g corresponds to the outer peripheral portion of the second coil portion 1723d, increase in electrical resistance of the connection coil 1723 can be easily suppressed. Thus, a larger current can be passed through the connection coil 1723. Accordingly, electromagnetic coupling can be enhanced between the connection coil 1723 and the booster antenna 32 of the antenna substrate 30, thereby improving the communication performance of the IC card 1710 as a contactless communication medium.

In the present embodiment, as described above, the third innermost turn portion 1723s can be formed on the second side (-D2 side) in the second direction D2, and thus the IC chip 22 can be easily disposed on the second side in the second direction D2. Thus, the first distance L1, which is the distance between the first innermost turn portion 1623i of the bypass portion 1623b and the IC chip 22, can be increased. Accordingly, the number of turns of the connection coil 1723 can be increased to increase the impedance of the connection coil 1723, while also increasing the distance between the connection coil 1723 and the IC chip 22.

### <Eighteenth Embodiment>

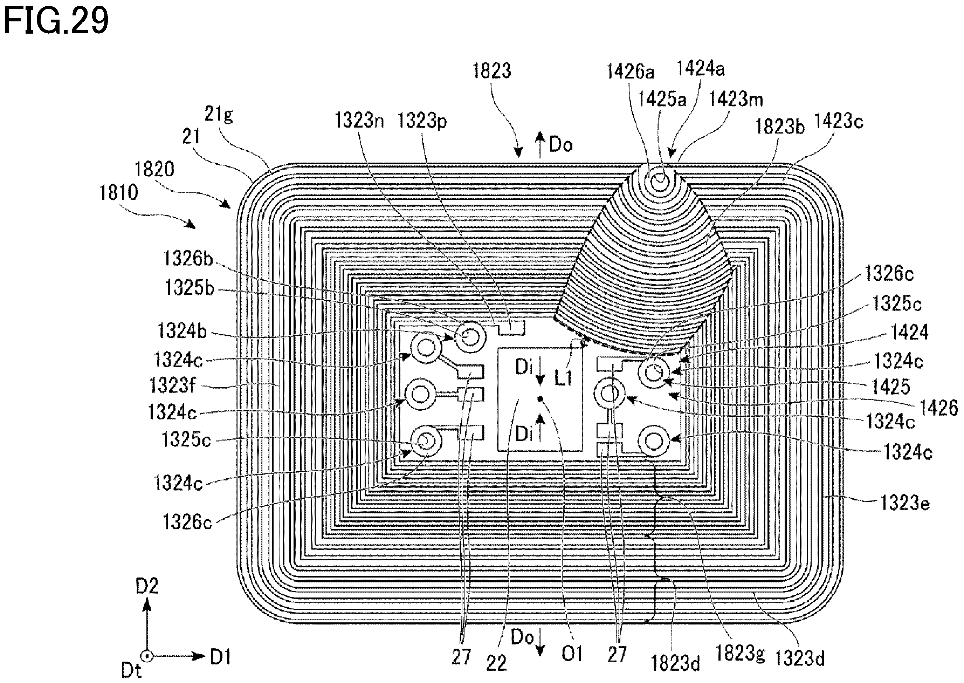

Next, referring to Fig. 29, an eighteenth embodiment of the present invention will be described. In the following description, the components common to those in the fourteenth embodiment described above are denoted by the same reference signs to omit repeated explanation. The following description will be focused on differences from the fourteenth embodiment.

Fig. 29 is a transparent view illustrating an IC module 1820 of an IC card 1810 according to the eighteenth embodiment as seen from above (+Dt side).

A connection coil 1823 of the present embodiment includes a bypass portion 1823b, an outer coil portion 1823d, and a small-width portion 1823g. The bypass portion 1823b is a portion of the connection coil 1823 bypassing the outermost connection terminal portion 1424a on the second side (-D2 side) in the second direction D2. As viewed in the thickness direction Dt, the turn portions constituting the bypass portion 1823b are formed into a substantially arc shape centered on the outermost connection terminal portion 1424a and protrude toward the inner peripheral side (Di side).

The outer coil portion 1823d is a portion of the connection coil 1823 on the outer peripheral side (Do side). The outermost end 1423m of the outer coil portion 1823d corresponds to the outermost end 1423m of the connection coil 1823. The outermost end 1423m of the outer coil portion 1823d is provided with the outermost connection terminal portion 1424a. The small-width portion 1823g is a portion of the connection coil 1823 on the inner peripheral side (Di side) relative to the outer coil portion 1823d. The small-width portion 1823g is connected to the outer coil portion 1823d. The innermost end 1323n of the small-width portion 1823g corresponds to the innermost end of the connection coil 1823. In the present embodiment, the number of turns of each of the outer coil portion 1823d and the small-width portion 1823g is 9. The number of turns of each of the outer coil portion 1823d and the small-width portion 1823g may be 8 or less or may be 10 or more.

In the present embodiment, the second coil width that is the width of the coil wire forming the outer coil portion 1823d is greater than the first coil width that is the width of the coil wire constituting the small-width portion 1823g. In other words, the coil width in the outer coil portion 1823d is greater than the coil width in the small-width portion 1823g.

According to the present embodiment, the connection coil 1823 includes the outer coil portion 1823d having the outermost end 1423m at which the outermost connection terminal portion 1424a is formed, and the small-width portion 1823g is a portion of the connection coil 1823, which is on the inner peripheral side (Di side) relative to the outer coil portion 1823d. Therefore, the electrical resistance per unit length of the coil wire constituting the outer coil portion 1823d is smaller than the electrical resistance per unit length of the coil wire constituting the small-width portion 1823g. Furthermore, since the outer coil portion 1823d is a portion of the connection coil 1823 located on the outer peripheral side (Do side) relative to the small-width portion 1823g, the length of the coil wire constituting the turn portions of the outer coil portion 1823d is larger than the length of the coil wire constituting the turn portions of the small-width portion 1823g. Therefore, compared to the configuration in which the coil width in the outer coil portion 1823d is smaller than the coil width in the small-width portion 1823g, increase in electrical resistance of the connection coil 1823 can be suppressed in the present embodiment. Thus, a larger current can be passed through the connection coil 1823. Accordingly, electromagnetic coupling can be enhanced between the connection coil 1823 and the booster antenna 32 of the antenna substrate 30, thereby improving the communication performance of the IC card 1810 as a contactless communication medium.

The width of the connection coil 1823 is not limited to the width according to the present embodiment described above. For example, the width of the connection coil 1823 may be increased from the inner peripheral side (Di side) toward the outer peripheral side (Do side). With this configuration also, increase in electrical resistance of the connection coil 1823 can be suppressed as in the present embodiment. Accordingly, since resistance loss of the current passing through the connection coil 1823 can be suppressed, a larger current can be passed through the connection coil 1823.

### <Nineteenth Embodiment>

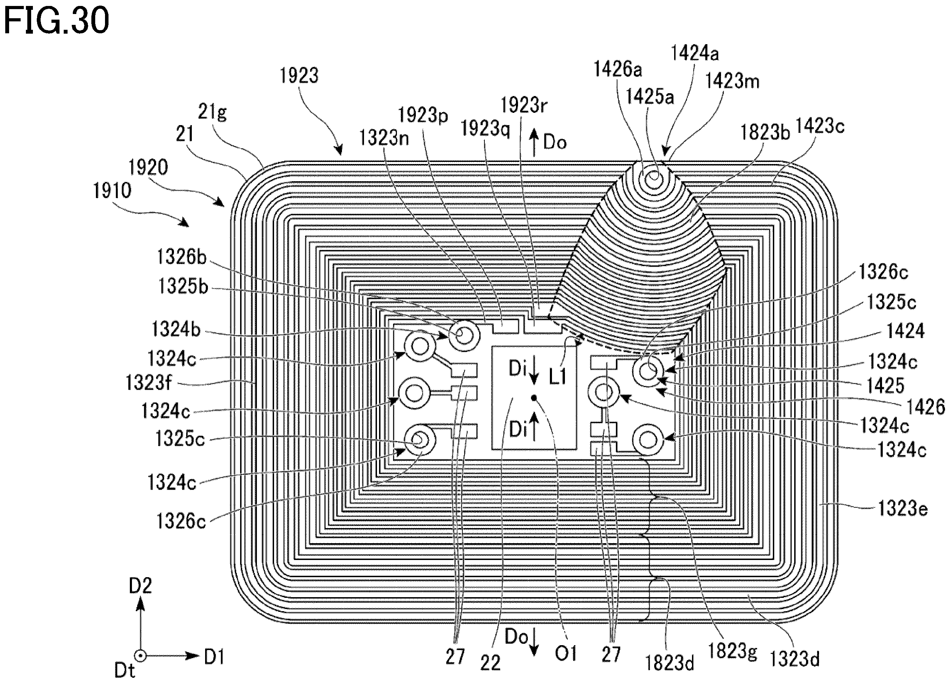

Next, referring to Fig. 30, a nineteenth embodiment of the present invention will be described. In the following description, the components common to those in the eighteenth embodiment described above are denoted by the same reference signs to omit repeated explanation. The following description will be focused on differences from the eighteenth embodiment.

Fig. 30 is a transparent view illustrating an IC module 1920 of an IC card 1910 according to the nineteenth embodiment as seen from above (+Dt side).

A connection coil 1923 of the present embodiment includes the bypass portion 1823b, and multiple connection pads 1923p, 1923q and 1923r. Similarly to the bypass portion 1823b of the eighteenth embodiment described above, the bypass portion 1823b of the present embodiment bypasses the outermost connection terminal portion 1424a on the second side (-D2 side) in the second direction D2 which is disposed on an edge portion of the substrate 21 on the first side (+D2 side) in the second direction D2. As viewed in the thickness direction Dt, the turn portions constituting the bypass portion 1823b are formed into a substantially arc shape centered on the outermost connection terminal portion 1424a and protrude toward the inner peripheral side (Di side).

The multiple connection pads 1923p, 1923q and 1923r are respectively formed on different turn portions of the connection coil 1923. More specifically, the connection pad 1923p is formed at the innermost end 1323n of the connection coil 1923. In other words, the connection pad 1923p is formed on a turn portion on the most inner peripheral side (Di side) of the connection coil 1923. The connection pad 1923p is disposed on the second side (-D1 side) in the first direction D1 relative to the bypass portion 1823b. The connection pad 1923q is formed on a second turn portion from the inner peripheral side of the connection coil 1923. In the first direction D1, the connection pad 1923q is disposed between the connection pad 1923p and the bypass portion 1823b. The connection pad 1923r is formed on the third turn portion from the inner peripheral side of the connection coil 1923. The connection pad 1923r is disposed on the first side (+D2 side) in the second direction D2 relative to the connection pad 1923q. The connection pads 1923p, 1923q and 1923r are formed on the first side in the second direction D2 relative to the IC chip 22. As viewed in the first direction D1, at least a part of the multiple connection pads 1923p, 1923q and 1923r overlaps with the bypass portion 1823b. Any one of the multiple connection pads 1923p, 1923q and 1923r is electrically connected to some of the multiple terminals of the IC chip 22 by wire bonding. Consequently, the connection coil 1923 is electrically connected to the IC chip 22.

According to the present embodiment, the connection coil 1923 includes the bypass portion 1823b bypassing the outermost connection terminal portion 1424a on the second side (-D2 side) in the second direction D2, and the multiple connection pads 1923p, 1923q and 1923r formed on different turn portions of the connection coil 1923, and as viewed in the first direction D1, at least a part of the multiple connection pads 1923p, 1923q and 1923r overlaps with the bypass portion 1823b. Therefore, by appropriately selecting a connection pad to be connected to the IC chip 22 from the connection pads 1923p, 1923q and 1923r, effective impedance between the outermost end 1323m of the connection coil 1923 and the IC chip 22 can be adjusted. As viewed in the first direction D1, the connection pads 1923p, 1923q and 1923r can be disposed so as to overlap with the bypass portion 1823b, thereby preventing the connection coil 1923 including the connection pads 1923p, 1923q and 1923r from becoming larger in the second direction D2. Therefore, the distance between the connection coil 1923 and the IC chip 22 can be easily increased.

Some embodiments of the present invention have so far been described. However, specific configurations are not limited to these embodiments. The present invention should encompass modifications, combinations, or the like in the range not departing from the spirit of the present invention.

For example, the inner diameter of the outermost through-hole portion may be greater than the inner diameters of other through-hole portions. The inner diameter of the innermost through-hole portion may be smaller or greater than the inner diameters of the relay through-hole portions. The width of the connection coil may be smaller than or equal to the interval between adjacent portions of the connection coil in the radial direction.

The position at which the outermost connection terminal portion is provided on the substrate is not limited to the positions in the above embodiments. The outermost connection terminal portion may be provided on the second side in the first direction relative to the IC chip, or may be provided on the second side in the second direction relative to the IC chip.

In the embodiments described above, examples of a so-called hybrid IC card functioning as both a contact and contactless IC card have been described as examples of an IC card; however, the IC card is not limited to these examples, but may be an IC card functioning only as a contact IC card, or may be an IC card functioning only as a contactless IC card.

### [Industrial Applicability]

The IC module related to the present invention can be applied to a dual interface electromagnetic coupling card module installed in an IC card capable of both contact and contactless communication.

### [Reference Signs List]

10, 110, 210, 310, 410, 510, 610, 710, 810, 910, 1010, 1110, 1210, 1310, 1410, 1510, 1610, 1710, 1810, 1910: IC card
15: Card substrate
20, 120, 220, 320, 420, 520, 620, 720, 820, 920, 1020, 1120, 1220, 1320, 1420, 1520, 1620, 1720, 1820, 1920: IC module
21, 1021: Substrate
21f: Second surface
21g: First surface
22: IC chip
23, 323, 423, 623, 723, 823, 923, 1123, 1223, 1323, 1423, 1523, 1623, 1723, 1823, 192: Connection coil
23b, 23b, 323b, 723b, 823b, 923b, 1323b, 1423b, 1523b, 1623b, 1823b: Bypass portion
23m, 323m, 723m, 1123m, 1323m, 1423m: Outermost end of connection coil
24a, 124a, 224a, 324a, 424a, 724a, 824a, 924a, 1324a, 1424a: Outermost connection terminal portion
25, 125, 325, 425, 725: Through-hole
25a, 125a, 225a, 325a, 425a, 725a, 825a, 925b: Outermost through-hole portion
26a, 126a, 226a, 326a, 426a, 726a, 826a, 926a: Outermost land portion
29,129,229,329: Contact terminal
29a, 129a, 329a: First contact terminal portion
29b, 129b, 229b, 329b: Second contact terminal portion
30: Antenna substrate
33: Coupling coil
36: Antenna coil
129m, 229m: Protrusion
523d, 1123d, 1323c, 1423c, 1523c, 1623c: First coil portion
523e, 1123e, 1323d, 1623d, 1723d: Second coil portion
623p, 623q, 623r, 1223p, 1223q, 1223r, 1923p, 1923q, 1923r: Connection pad
861, 961: Filler
1323g, 1423g, 1523g, 1623g, 1723g, 1823g: Small-width portion
1823d: Outer coil portion
A1: First virtual line
D1: First direction
D2: Second direction
Di: Inner peripheral side
Do: Outer peripheral side
Dt: Thickness direction
θ1, θ2: Center angle

## Claims

1. An IC module comprising
a rectangular substrate having long sides extending in a first direction;
a connection coil formed in a spiral shape on a first surface of the substrate;
an outermost connection terminal portion formed at an outermost end of the connection coil; and
an IC chip provided on a portion of the first surface on an inner peripheral side relative to the connection coil, wherein
the outermost connection terminal portion comprises
an outermost through-hole portion penetrating the substrate in a thickness direction of the substrate, and
an outermost land portion surrounding the outermost through-hole portion and connecting between the outermost through-hole portion and the connection coil; and
as viewed in a second direction perpendicular to both the first direction and the thickness direction, the outermost connection terminal portion is disposed on a first side in the first direction relative to the IC chip.

2. The IC module according to claim 1, wherein
the substrate is provided with a plurality of through-hole portions including the outermost through-hole portion, the plurality of through-hole portions penetrating the substrate in the thickness direction; and
the outermost through-hole portion has an inner diameter smaller than inner diameters of other through-hole portions.

3. The IC module according to claim 1, wherein
the connection coil includes a first coil portion in which the outermost connection terminal portion is formed at an outermost end, and a second coil portion disposed on an inner peripheral side relative to the first coil portion; and
a coil width in the first coil portion is greater than a coil width in the second coil portion.

4. The IC module according to claim 1, wherein the connection coil has a width increasing from an inner peripheral side toward an outer peripheral side.

5. The IC module according to claim 1, wherein the connection coil has a width greater than an interval between adjacent portions of the connection coil in a radial direction.

6. The IC module according to claim 1, wherein
the outermost connection terminal portion is disposed at an edge portion of the substrate on a first side in the second direction;
the connection coil includes
a bypass portion bypassing the outermost connection terminal portion on a second side in the second direction, and
a plurality of connection pads respectively formed on different turn portions of the connection coil; and
as viewed in the first direction, at least a part of the plurality of connection pads overlaps with the bypass portion.

7. The IC module according to any one of claims 1 to 6, comprising
a contact terminal provided on a second surface of the substrate facing away from the first surface, wherein
the contact terminal includes a first contact terminal portion disposed on a first side in the first direction and on a first side in the second direction relative to the IC chip, and a second contact terminal portion disposed on a second side in the first direction of the first contact terminal portion so as to be adjacent to the first contact terminal portion in the first direction;
the second contact terminal portion includes a protrusion protruding toward the first side in the first direction; and
as viewed in the thickness direction, at least a part of the outermost connection terminal portion overlaps with the protrusion.

8. The IC module according to any one of claims 1 to 6, comprising
a contact terminal provided on a second surface of the substrate facing away from the first surface, wherein
the contact terminal includes a second contact terminal portion disposed on a first side in the first direction relative to the IC chip; and
as viewed in the thickness direction, the outermost connection terminal portion is disposed on an edge portion of the second contact terminal portion on a first side in the first direction.

9. The IC module according to claim 7, wherein
the IC chip has an input capacitance of less than 60 pF between RF terminals;
the contact terminal is constituted of a plurality of terminal portions; and
the number of terminal portions constituting the contact terminal or the number of terminal portions therein is six or less.

10. An IC card comprising
the IC module according to claim 7;
a card substrate in which the IC module is fitted; and
an antenna substrate including an antenna coil and a coupling coil that can be electromagnetically coupled to the connection coil.

11. An IC module comprising
a rectangular substrate;
a connection coil formed in a spiral shape on a first surface of the substrate;
an outermost connection terminal portion formed at an outermost end of the connection coil;
an IC chip provided on a portion of the first surface on an inner peripheral side relative to the connection coil; and
a contact terminal provided on a second surface of the substrate facing away from the first surface, wherein
the outermost connection terminal portion comprises
an outermost through-hole portion penetrating the substrate in a thickness direction of the substrate, and
an outermost land portion surrounding the outermost through-hole portion and connecting between the outermost through-hole portion and the connection coil; and
a part of the outermost land portion is located on an outer peripheral side relative to the connection coil.

12. The IC module according to claim 11, wherein
as viewed in the thickness direction, the connection coil is disposed on an inner peripheral side relative to an outer edge of the contact terminal; and
as viewed in the thickness direction, an outer edge of the outermost land portion overlaps with an outer edge of the contact terminal, or is disposed on an inner peripheral side relative to an outer edge of the contact terminal.

13. The IC module according to claim 11, wherein the outermost through-hole portion is an edge surface through-hole provided on an edge surface of the substrate.

14. The IC module according to claim 11, wherein
the outermost connection terminal portion includes a plurality of outermost through-hole portions connected in parallel with each other via the outermost land portion; and
the plurality of outermost through-hole portions are edge surface through-holes provided to an edge surface of the substrate.

15. The IC module according to claim 13, wherein a portion of the edge surface of the substrate on which the outermost connection terminal portion is formed is recessed toward the inner peripheral side.

16. The IC module according to claim 13, wherein the outermost through-hole portion has an arc shape with a center angle of 120° or more as viewed in the thickness direction.

17. The IC module according to claim 13, wherein the outermost through-hole portion is filled with a filler made of a resin or a conductive material.

18. An IC module, comprising
a rectangular substrate having long sides extending in a first direction;
a connection coil formed in a spiral shape on a first surface of the substrate;
an outermost connection terminal portion formed at an outermost end of the connection coil; and
an IC chip provided on a portion of the first surface on an inner peripheral side relative to the connection coil, wherein
the connection coil comprises
a first coil portion disposed on a first side in a second direction perpendicular to the first direction relative to the IC chip, and extending in the first direction, and
a second coil portion disposed on a second side in the second direction relative to the IC chip, and extending in the first direction;
at least either of the first coil portion and the second coil portion has a part provided with a small-width portion;
as viewed in a thickness direction of the substrate, a first virtual line that is a straight line passing through both the outermost connection terminal portion and the IC chip passes through the small-width portion; and
at least either of a width of a coil wire in the small-width portion and an interval between portions of the coil wire in the small-width portion is smaller than that in a portion of the connection coil other than the small-width portion.

19. The IC module according to claim 18, wherein
the outermost connection terminal portion is disposed on an edge portion of the substrate on a first side in the second direction;
the first coil portion includes a bypass portion bypassing the outermost connection terminal portion on a second side in the second direction; and
at least a part of the bypass portion corresponds to the small-width portion.

20. The IC module according to claim 19, wherein an outer peripheral portion of the bypass portion corresponds to the small-width portion.

21. The IC module according to claim 18, wherein
the outermost connection terminal portion is disposed on an edge portion of the substrate on a first side in the second direction; and
at least a part of the second coil portion corresponds to the small-width portion.

22. The IC module according to claim 21, wherein the small-width portion corresponds to an inner peripheral portion of the second coil portion.

23. The IC module according to claim 18, wherein
the connection coil includes an outer coil portion having an outermost end at which the outermost connection terminal portion is formed; and
the small-width portion corresponds to a portion of the connection coil on an inner peripheral side relative to the outer coil portion.
